(19) Europäisches Patentamt
European Patent Office
Office européen des brevets

(11) Publication number: **0 420 668 A2**

(12) # EUROPEAN PATENT APPLICATION

(21) Application number: **90310641.7**

(51) Int. Cl.[5]: **H01L 23/427**

(22) Date of filing: **28.09.90**

(30) Priority: **29.09.89 JP 252075/89**
**16.02.90 JP 36676/90**
**06.08.90 JP 206826/90**

(43) Date of publication of application:
**03.04.91 Bulletin 91/14**

(84) Designated Contracting States:
**DE ES FR GB IT**

(71) Applicant: **MITSUBISHI DENKI KABUSHIKI KAISHA**
**2-3, Marunouchi 2-chome Chiyoda-ku**
**Tokyo(JP)**

(72) Inventor: **Takahashi, Nobuyoshi, C/o Itami Seisakusho**
**Mitsubishi Denki K. K., 1-1 Tsukaguchi Hon-machi**
**8-chome, Amagasaki City, Hyogo Pref.(JP)**
Inventor: **Kameda, Takashi, C/o Itami Seisakusho**
**Mitsubishi Denki K. K., 1-1 Tsukaguchi Hon-machi**
**8-chome, Amagasaki City, Hyogo Pref.(JP)**
Inventor: **Ashiya, Masahiro, C/o Itami Seisakusho**
**Mitsubishi Denki K. K., 1-1 Tsukaguchi Hon-machi**
**8-chome, Amagasaki City, Hyogo Pref.(JP)**
Inventor: **Murase, Seiichi, C/o Itami Seisakusho**
**Mitsubishi Denki K. K., 1-1 Tsukaguchi Hon-machi**
**8-chome, Amagasaki City, Hyogo Pref.(JP)**
Inventor: **Yoshioka, Takeo, C/o Itami Seisakusho**
**Mitsubishi Denki K. K., 1-1 Tsukaguchi Hon-machi**
**8-chome, Amagasaki City, Hyogo Pref.(JP)**
Inventor: **Fujii, Masao, C/o Chuo Kenkyusho**
**Mitsubishi Denki K. K., 1-1 Tsukaguchi Hon-machi**
**8-chome, Amagasaki City, Hyogo Pref.(JP)**

(74) Representative: **Lawson, David Glynne et al**
**MARKS & CLERK 57-60 Lincoln's Inn Fields**
**London WC2A 3LS(GB)**

(54) **Boiling type cooler device for power semiconductor switching elements.**

(57) A boiling cooler device for cooling thyristers, etc., is made of copper and utilizes water or an aqueous solution of ethylene glycol as the cooling medium. The cooler fins 31 constituting the evaporators of the device are disposed to a side of a common liquid reservoir 33 directly coupled to the condensor 24, to be coummunicated thereto via substantially horizontally extending ducts 32 (Figs. 8 and 9). Each cooler fin 31 may be coupled to the common reservoir 33 via two parallel ducts 34 and 35 (Fig. 10). The cooler fins 31 may each comprise vertically extending interior conduits 42 at the interior side of the heat absorbing surfaces 31a (Figs. 13 through 15). The evaporator 51 amy comprise a first cooling medium conduit 53 and second cooling medium conduits 54 having a smaller overall cross sectional area than the first conduit 53 (Figs. 32 and 33). Metal particles 61, preferably having a particle size of from about 400 to 1000 micormeters, may be attached to the heat transfer surfaces of the cooler fins 31 (Figs. 41 and 42). Further, optimal ranges of a dimensionless number F for stabilizing the cooling efficiency is disclosed for respective cooling media.

EP 0 420 668 A2

## BOILING TYPE COOLER DEVICE FOR POWER SEMICONDUCTOR SWITCHING ELEMENTS

### BACKGROUND OF THE INVENTION

This invention relates to boiling type cooler devices for cooling power semiconductor switching elements, such as thyrister elements of chopper devices mounted on underground railroad vehicles, or power transistors utilized in electronic devices.

Fig. 1 shows a conventional immersed type boiling cooler device for accomodating thyristers, which is disclosed, for example, in Mitsubishi Denki Giho (Mitsubish Electric Corporation's Techinical Journal), Vol. 48, No. 2.

In Fig. 1, an evaporator 1 contains a liquid fluorocarbon 2 such as R113 (1,1,2-trichloro-1,1,2-trifuoroethane or trifluorotrichloroethane), in which the thyrister elements 3 are immersed to be cooled therein. Fins 4 are attached integrally to the thyrister elements 3, the terminals 5 of the thyrister elements 3 extending through the side walls of the evaporator 1. To the top of the evaporator 1 is coupled a condenser 8 via a vapor conduit pipe 6 and a liquid return conduit pipe 7.

The operation of the device of Fig. 1 is as follows. When the thyristers 3 are in operation, the electrical power loss taking place therein results in the generation of an amount of heat as large as several hundred watts. On the other hand, the cooling areas of the thyrister elements 3 are so small as to have only sevral tens of millimeters across. Thus, the flux of heat flowing through the cooling surfaces thereof reaches as high a value as $10^5$ W/m$^2$. The heat generated in the thyrister elements 3 is discharged into the liquid fluorcarbon 2 via the fins 4 that are in pressured contact with the cooling surfaces of the thyrister elements 3. As a result, the liquid fluorcarbon 2 boils, thereby generating fluorcarbon vapor 2a within the evaporator 1. The fluorocarbon vapor 2a thus generated in the evaporator proceeds via the vapor pipe 6 into the condenser 8, to be condensed therein into the liquid phase fluorocarbon 2 again. The condensed liquid fluorocarbon 2 returns via the liquid return pipe 7 to the evaporator 1. The above operations are repeated and the thyristers 3 are thus cooled continuously.

Next, Fig. 2 shows a separate cooler fin type (non-immersion type) boiling cooler device for cooling thyristers, which is disclosed, for example, in "Heat Radiation Designs and Simulations for Electronics Devices", Ohyoh-gijutsu Shuppan (Applied Technology Publisher), 1989, p. 148.

In Fig. 2, the thyrister elements 3 are exposed to the atmosphere. The cooler fins 9 attached to the respective thyristers 3 are coupled via heat transport pipes 10 to a common liquid reservoir 11. The cooler fins 9, the heat transport pipes 10, and the common liquid reservoir 11 contain a liquid fluorocarbon 2 therein. The common liquid reservoir 11 is coupled via the vapor pipe 6 and the liquid return pipe 7 to the condenser 8.

The operation of the device of Fig. 2 is as follows. The heat generated in thyrister elements 3 are conducted via the cooler fins 9 to the liquid fluorocarbon 2 therein. As a result, the liquid fluorocarbon 2 evaporates to generate fluorocarbon vapor 2a therein, which proceeds through the heat transport pipes 10, the common reservoir 11, and the vapor pipe 6, into the condenser 8, in which the vapor 2a is condensed again into the liquid phase fluorocarbon 2. The condensed fluorocarbon 2 returns, due to the effect of the gravity, to the common liquid reservoir 11 via the liquid return pipe 7. The above operations are repeated such that the thyrister elements 3 are cooled continuously.

By the way, Fig. 3 shows the relationship between the superheating degree and the heat flux, wherein the curve represents the boing curve of a representative cooling medium. In Fig. 3, the curve between the points A and 0 corresponds to the region of natural convection. The portion of the curve extending from B via C to D corressponds to the region of nucleate boiling. The flux of heat at point D is called the burn-out heat flux. The curve between the points D and E corresponds to the transition boiling region, and the curve E-F-G corresponds to the film boiling region.

Generally, in the case where the heat flux increases from a low to a high flux region, it exhibits the the following characteristics: First, the heat flux moves from point A via point a to point H$'$. When the heat flux further increases, it moves abruptly from point H$'$ to H. When the heat flux further increases, it moves from H via C to D. On the other hand, when the heat flux decreases, it exhibits the following characteristics: First, it moves from point D via C to H. When the heat flux further decreases, it does not move to the point H$'$; instead, it returns from H via B to A. This phenomenon is generally called hysterisis.

In the case of the above conventional boiling type coolers, the flux of heat in the region shown at the double-headed arrow X in Fig. 3 within the nucleate boiling region between the points B and D is utilized. However, the heat transfer areas of the evaporator 1 have heretofore been determined without a qualitative understanding of the above described characteristics of the hysterisis. Even when the heat transfer areas of the evaporator 1 are determined on an estimate of these characteristics, it would be necessary, when the cooling medium is changed, to evaluate anew the boiling characteristics of the new medium.

In summary, the conventional boiling type coolers as described above have the following disadvantages:

(1) The devices utilize liquid fluorcarbon 2 as the cooling medium. When the fluorocarbon is discharged into the atmosphere, it tends to destruct the ozonosphere. Thus, it is an urgent demand from the point of view of environmental protection that the fluorocarbon be replaced by a substitute. On the other hand, when a cooling medium other than fluorcarbons are utilized, sufficient cooling performance cannot be obtained by means of the devices structurally similar to the conventional ones, since the physical properties of the new medium is different from those of the fluorocarbons.

(2) In the case of the devices of the separate cooler fin type, the common liquid rewervoir 11 is disposed above the cooler fins 9, so that the overall size of the cooler device is increased. Thus, a large installment space is necessary in the machines (such as railroad vehicles) within which the thyrister devices are mounted. This is against the demand for the compactification of such vehicles. In particular, in the case of linear motor cars, the requirement for the compactification of the vehicles, i.e., the reducing the height of the floors, is severe. Thus, the reduction of the overall size of the thyrister devices is urgent in such applications.

(3) The cooled bodies such as the thyristers or power transistors are being operated at an increasingly large rated current. The conventional devices do not offer sufficient cooling performance for such large current thyrister devices over the whole operating condition of the thyristers. In particular, the cooling performance under small heat load becomes insufficient.

(4) The designs of the evaporator 1 or the cooler fins 9 does not pay enough ettention to the problem of the variation of the heat flux at the boiling or ebullition starting point. Namely, near the point H in Fig. 3, the degree of superheating, i.e., the difference between the temperature on the cooling areas of the fins of the evaporator 1 and the temperature of the cooling medium, vies even when the flux of heat remains constant. Thus, the cooling performance becomes unstable.

## SUMMARY OF THE INVENTION

It is therefore an object of this invention to provide a boiling cooler device which does not utilize fluorocarbons as the cooling medium and which all the same is enhanced in the cooling efficiency.

A further object of this invention is to provide a boiling cooler device which is small-sized and especially low in height, but which is enhanced in the cooling efficiency over a wide range of the heat load. More particularly, this invention aims at providing such a boiling cooler device which utilizes water or an aqueous solution of ethylene glycol as the cooling medium.

A still further object of this invention is to provide a boiling cooler device wherein the fluctuations of the superheating degree of the evaporator is effectively prevented such that the cooling performance of the boiling cooler device is stabilized.

The first object is accomplished in accordance with the principle of this invention by a boiling cooler device which comprises: an evaporator containing a liquid cooling medium consisting of an aqueous solution of ethylene glycol, wherein a body to be cooled by the boiling cooler device is in thermal contact with the cooling medium to generate vapor of the aqueous solution of ethylene glycol; and a condensor made of copper, coupled via a vapor conduit and a liquid return conduit to the evaporator, such that the vapor generated in the evaporator proceeds via the vapor conduit to the condensor to be condensed therein into liquid cooling medium, and the condensed liquid cooling medium returns therefrom via the liquid return conduit to the evaporator.

The second object is accomplished in accordance with the principle of this invention by a boiling cooler device which comprises: a common liquid reservoir containing a liquid cooling medium; a plurality of evaporators containing the liquid cooling medium and disposed to a side of the common liquid reservoir, each one of the evaporators being in thermal contact with at least one cooled body at an exterior side surface thereof, such that vapor of the cooling medium is generated in the evaporators; a plurality of ducts each extending substantially horizontally from a side of the common liquid reservoir to connect the common liquid reservoir to one of the evaporators, whereby the interior of each one of the evaporators is communicated via one of the ducts to the common liquid reservoir; and a condensor coupled directly to the common liquid reservoir, the condensor condensing into the liquid cooling medium the vapor generated in the evaporators. Preferably, the condensor comprises: a first header coupled directly to the common liquid reservoir; a plurality of finned tubes each coupled at an end thereof to the first header to extend horizontally therefrom, the finned tubes being tilted by a predetermined angle from the horizontal direction; and a second header coupled to the ends of finned tubes opposite to said ends coupled to the first header.

Preferably, the evaporators each comprise interior conduits extending vertically therewithin to an interior side of the heat transfer surface of the evaporators.

The cooling efficiency is enhanced over a wide range of heat load by a boiling cooler device which comprises: an evaporator containing a liquid cooling medium and having an exterior side wall in thermal contact with a cooled body, the evaporator comprising a first cooling medium conduit and second cooling medium conduits extending vertically therewithin, wherein the second cooling medium conduits are situated nearer to the cooled body than the first cooling medium conduits, and have an overall cross sectional area smaller than the cross sectional area of the first cooling medium conduit; and a condensor coupled to the evaporator, such that the vapor generated in the evaporator is condensed into liquid cooliing medium within the condensnor. It is preferred that heat transfer promoting particles are attached to an interior side surface of the first cooling medium conduit situated to the side in thermal contact with the cooled body.

Further, an enhanced cooling efficincy is provided according to the principle of this invention by a boiling cooler device which comprises: an evaporator containing a liquid cooling medium selected from the group consisting or water or an aqueous solution of ethylene glycol, a cooled body being in thermal contact with an exterior side of the evaporator to generate vapor of the cooling medium therein, wherein an interior heat transfer surface of the evaporator has attached thereon heat transfer promoting particles having a particle diameter ranging from about 300 $\mu$m to about 2000 $\mu$m; and a condensor coupled to the evaporator to condense the vapor generated in the evaporator. Preferably, said heat promoting particles have a particle diameter ranging from about 400 $\mu$m to about 1000 $\mu$m. Further, the heat promoting particles attached to the heat transfer surface are preferred to be double layered.

The deterioration of the cooling efficiency resulting from the leakage can be effectively prevented by a boiling cooler device which comprises: pressure monitoring means for detecting a pressure within an interior space of the condensor coupled to the evaporator, the monitoring means outputting a signal when the pressure of the interior space rises above a predtermined value; and an exhaust means, coupled to the monitoring means, for exhausting the interior space of the condensor in response to the signal of the monitoring means, thereby reducing the pressure within the interior space to a normal level.

The last mentioned object is accomplished according to the principle of this invention by a boiling cooler device wherein the area A of a heat transfer surface of the evaporator is selected such that a dimensionless number F satisfies:

$F \geqq 2.7 \times 10^4$

or

$F \geqq 2.1 \times 10^4 \cdot m^{-0.027}$

or

$F \geqq 1.1 \times 10^4$

accoording as the cooling medium is: pure water or an aqueous solution; or an aqueous solution of ethylene glycol; or a fluorocarbon; wherein

$F = Pr^{-0.35} \cdot [\{0.86(Q/A)/L \cdot \rho v \cdot al)\} \cdot \sqrt{\sigma/(\rho l - \rho v)}\ ]^{0.7} \cdot [Ps/\sqrt{\sigma(\rho l - \rho v)}\ ]^{0.7}$

and

Q/A is a heat flux (W/m$^2$) through the heat transfer surface of the evaporator;

Q is a quantity of heat (W) flowing through the heat transfer surface of the evaporator;

A is the area (m$^2$) of the heat transfer surface of the evaporator;

L is the latent heat of evaporation (kcal/kg) of the cooling medium;

$\rho v$ is the specific weight (kg/m$^3$) of the vapor of the cooling medium;

$\rho l$ is the specific weight (kg/m$^3$) of the liquid cooling medium;

al is the thermal conductivity of the liquid cooling medium (m$^2$/hr);

$\sigma$ is the surface tension (kg/m) of the cooling medium;

Ps is the vapor pressure (kg/m$^2$) of the cooling medium; and

Pr is the Prandtl number of the liquid cooling medium.

## BRIEF DESCRIPTION OF THE DRAWINGS

The novel features which are believed to be characteristic of this invention are set forth with particularity in the appended claims. This invention itself, however, both as to its structure and method operation, together with further objects and advantages thereof, may best be understood from the detailed description of the preferred embodiments, taken in connection with the accompanying drawings, in which:

Figs. 1 and 2 show typical conventional boiling cooler devices in elevational views;

Fig. 3 shows a typical boiling curve of a cooling medium;

Fig. 4 is a side view of a boiling cooler device according to a first aspect of this invention;

Figs. 5 through 7 are the graphs which show the relationships exemplifiying the cooling effficiency of the device of Fig. 4;

Figs. 8 and 9 show a side and a front view, respectively, of a boiling cooler device according to a second aspect of this invention;

Figs. 10 through 12 show other embodiments of the same aspect;

Figs. 13 through 15 show the evaporator (cooler fins) of a boiling cooler device according to a third aspect of this invention;

Figs. 16 and 17 are the graphs of the experimental results which give evidence with respect to the enhanced cooling efficiency of the boiling cooler device according to the third aspect;

Fig. 18 shows another evaporator according to the third aspect;

Figs. 19 and 20 shows still another evaporator according to the third asepct;

Figs. 21 through 23 show a further evaporator according to the third aspect;

Fig. 24 shows another boiling cooler device according to the third aspect;

Fig. 25 shows a duct structure of another boiling cooler device;

Fig. 26 is a side view of a boiling cooler device provided with the evaporator of Figs. 21 through 23;

Figs. 27 through 30 are the graphs showing the experimetal results obtained by utilizing the boiling cooler device of Fig. 26;

Fig. 31 is a side view of a boiling cooler device according to a fourth asepct of this invention;

Figs. 32 and 33 show an evaporator according to a fifth aspect of this invention;

Fig. 34 shows the boiling curves which are indicative of the enhancement of the cooling efficiency according to the fifth aspect;

Figs. 35 through 37 show another evaporator according to the fifth aspect;

Figs. 38 through 40 show still another evaporator according to the fifth aspect;

Figs. 41 and 42 show a boiling cooler device according to a sixth aspect of this invention;

Figs. 43 and 44 show modified evaporators according to the sixth aspect;

Figs. 45 through 50 are the graphs which show the experimental results relative to the enhancement of the cooling efficiency according to the sixth asepct;

Fig. 51 shows a shematic view of a boiling cooler device according to the seventh aspect of this invention;

Fig. 52 through 56 are the graphs of the experimental results relative to the eighth aspect of this invetion; and

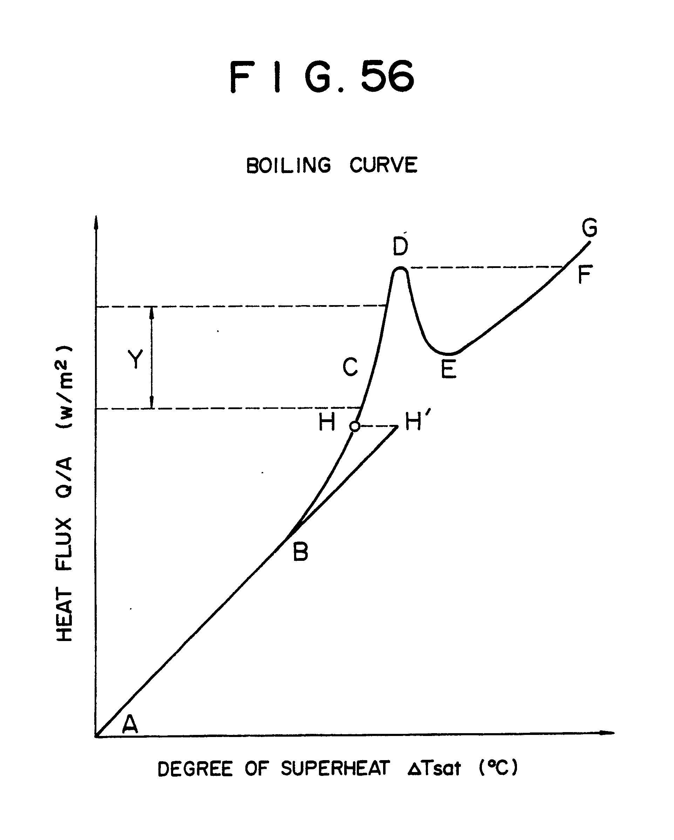

Fig. 56 is a boiling curve which shows the stabilization of the cooling performance according to the eighth aspect.

In the drawings, like reference numerals represent like or corresponding parts.

## DETAIELD DESCRIPTION OF THE PREFERRED EMBODIMENTS

Referring first to Figs. 4 through 7 of the drawings, embodiments according to the first aspect of this invention is described.

Fig. 4 shows a boiling cooler device of the separate cooler fin type for accomodating a thyrister device according to the first asepct of this invention. In Fig. 4, an evaporator 21 is coupled to a condensor 24, via a vapor pipe 22 and a liquid return pipe 23 constituting the return conduit for the condensed liquid. The condensor 24 comprises finned tubes 24a and a first and a second header 24b and 24c coupled to the ends of the finned tubes 24a. The finned tubes 24a extend horizontally, tilted upward toward the second header 24c. The evaporator 21 contains a cooling medium 25 consisting of an aqueous solution of ethylene glycol. In view of the anti-corrosive property with respect to the aqueous solution of ethylene glycol, the evaporator 21, the condensor 24, the vapor pipe 22, and the return pipe 23 are made of copper. Thyrister elements 3 are in pressured contact with the outer sides of the evaporator 21.

The thyrister elements 3 are cooled via the cooling liquid medium 25 as in the case of the conventional devices. Thus, the heat generated in the thyrister elements 3 are transmitted via the walls of the evaporator 21 to the cooling liquid 25 therewithin. The vapor 27 resulting from the boiling of the medium 25 in the evaporator 21 travels into the condensor 24 via the vapor pipe 22, to be condensed in the condensor 24. The thus condensed medium 25 returns to the evaporator 21. Since the cooling liquid 25 consists of an aqueous solution of ethylene glycol in the case of this boiling cooler device, there does not occur the problem of enviroment destruction resulting from the leakage or discharge of the fluorocarbons. Further, since the cooler device is made of copper, the corrosion occasioned by the aqueous solution of ethylene glycol is prevented. The corrosive speed of 38 percent by weight aqueous solution of ethylene glycol mixed with an anti-corrosive agent, for example, is 0.041 mm per year in the case of soft steel, 0.059 mm per year in the case of zinc, and 0.0017 mm per year in the case of copper. Thus, the corrosion of the cooler device according to this embodiment is substantially prevented, and hence the generation of non-condensing gases (such as hydrogen) resultling from the corrosion can also be prevented.

Fig. 5 shows the relationships between the superheating degree of the heat transfer surface and the flux of heat flowing therethrough, wherein the curves represent the respective boiling curves of fluorocarbon R113 (solid line), water (dot-and-dash line), and 35 % by weight aqueous solution of ethylene glycol (dotted line). The relations are those at the saturated liquid temperature of 70 degrees Celsius. (With respect to the precise definition of the heat flux and that of the superheating degree, reference is to be made to equations (1) and (2) described hereinbelow.)

The boiling or ebullition cooling performance of the respective media as shown in Fig. 5 is as follows: the performance of water is the best, that of 35 % by weight aqueous solution of ethylene glycol comes next, and that of fluorocarbon R113 follows thereafter. It is to be noted that the values shown with regard to the water and 35 % by weight aqueous solution of ethylene glycol is the experimental measurement values, while those with respect to fluorocarbon R113 are determined by means of the Labountzov' s equations which give estimates of the nucleate boiling heat transfers. The Labountzov's equations are as follows:

$$\alpha \cdot \ell_2/\lambda_1 = 0.0625[\{Q/(L \cdot \gamma_v)\} \cdot \ell_2/\nu_1]^{0.5} \times P_{r1}^{1/3}$$

in the case where

$$\{Q/(L \cdot \gamma_v)\} \cdot \ell_2/\nu_1 < 10^{-2};$$

and

$$\alpha \cdot \ell_2/\lambda_1 = 0.125[\{Q/(L \cdot \gamma_v)\} \cdot \ell_2/\nu_1]^{0.65} \times P_{r1}^{1/3}$$

in the case where

$$\{Q/(L \cdot \gamma_v)\} \cdot \ell_2/\nu_1 > 10^{-2};$$

wherein:

$$\ell_2 = \{C_{P1} (T_S + 273)/L\} (\gamma_1/\gamma_v) \times \{\sigma / J \cdot \gamma_v \cdot L)\}$$

and

Q is the heat flux ($kcal/m^2 \cdot hr$);

L is the latent heat of evaporation (kcal/kg);

$\gamma_1$ is the specific weight of the liquid ($kg/m^3$);

$\gamma_v$is the specific wieght of the vapor ($kg/m^3$);

$\nu_1$ is the coefficient of dynamic viscosity of the liquid ($m^2/hr$);

$\alpha$ is the heat transfer coefficient (heat transfer rate) ($kcal/m^2 \cdot hr \cdot {}^\circ C$);

$\lambda_1$ is the heat transfer coefficient of the liquid ($kcal/m^2 \cdot hr \cdot {}^\circ C$);

$C_{p1}$ is the specific heat of the liquid (kcal/kg °C);

$\sigma$ is the surface tension (kg/m);

J is the conversion constant of heat (= 426.8 kg•m/kcal);

$T_S$ is the temperature of the wall surface (°C); and

$P_{r1}$ is the Prandtl number (dimensionless).

As is evident from Fig. 5, in the case where the saturated liquid temperature is 70 dgrees Celcsus, the boiling or ebullition cooling characteristics of the 35 percent by weight aqueous solution of ethylene glycol are substantially equal or superior to those of the fluorocarbon R113, although inferior to those of water.

The data shown in Fig. 5 suggests that water is a good cooling medium for a coler device. However, water turns into ice at 0 °C. Thus, where the device utilizing water is to be mounted on vehicles, etc., designs for the prevention of the freezing of water which pay due attention to the starting characteristics of the cooler device at lower temperatures are required. This limits the applicable temperature range of such a cooler device. On the other hand, the freezing temperature of aqueous solution of ethylene glycol is lowered, as shown in Fig. 6, as the concentration thereof increases. For example, the 35 % by weight aqueous solution shown in Fig. 5 has the freezing point at - 20 °C, such that the aqueous solution of ethylene glycol at this concentration is appliable to the operation temperature range of thyrister elements 3, which is usually about from - 20 °C to 80 °C.

However, the aqueous solutions of ethylene glycol has, as shown in Fig. 7, the saturation pressure lower than the atmospheric pressure, within the operational temperature range of the thyrister elements 3. Thus, it is necessay that the device be produced such that the cooling performance is not deteriorated by the intrusion of non-condensing gases (such as air) into the device due to the leakage thereof.

Incidentally, the whole device is made of copper in the case of the above embodiment. However, the parts other than the condensor 24 may be made of other materials. In view of the anti-corrosive property, however, the parts with which the vapor 27 of aqueous solution of ethylene glycol come into contact - e.g., the vapor pipe 22 - are preferred to be made of copper.

It is noted that anti-corrosive agent may be added to the cooling medium 25 which consists of aqueous solution of ethylene glycol, thereby ensuring the prevention of corrosion. Further, it is to be noted that although the vapor pipe 22 and the liquid return pipe 24 having tubular forms are utilized in the case of the above embodiment as the vapor conduit and the liquid return conduit, respectively, it goes without saying that they are not limited to the tubular forms. Furthermore, it is to be noted that although the above embodiment shows a boiling cooler device of the separate cooler fin type for cooling a thyrister device, the idea of the first aspect of this invention is applicable to other boiling cooler devices as well.

Referring next to Figs. 8 through 12 of the drawings, the embodiments according to the second aspect of this invention are described. The second aspect of this invention is characterized in the geometry of the cooler fins and the horizontally extending ducts which communicate the interiors of the cooler fins to the common liquid reservoir.

Figs. 8 and 9 show a first embodiment according to the second aspect of this invention. Fig. 8 is a partially broken-away side view of a boiling cooler device of the separate cooler fin type for accomodating a tyrister device according to the embodiment, and Fig. 9 shows the front end view thereof (as seen from the right in Fig. 8). As shown in Figs. 8 and 9, to the rectangular cooler fins 32 constituting the evaporators of the device are attached the thyrister elements 3 to alternate therewith. The back sides (left sides in Fig. 8) of the respective cooler fins 31 are extended horizontally to form the ducts 32, which are coupled to the front side of the common liquid reservoir 33 so as to communicate the interiors of the cooler fins to the common liquid reservoir 33. A condensor 24 is connected to the top of the common reservoir 33. The cooling liquid 25 contained in the fins 31, ducts 32, and the common reservoir 33 comprises pure water or an aqueous solution of ethylene glycol.

The operation of the device of Figs. 8 and 9 is as follows. The heat generated in the thyrister elements 3 exposed to the atmosphere is transmitted via the walls of the cooler fins 31 to the cooling liquid 25 therewithin. Due to this heat, the cooling liquid 25 within the cooler fins 31 boils, so that bubbles 26 are generated at the heat absorbing surfaces 31a of the fins 31. Accompanying the upward movement of the bubbles 26, the cooling liquid 25 within the cooler fins 31 are convected as shown by the arrows in Fig. 8. The bubbles 26 moving upward within the cooler fins 31 proceed via the ducts 32 to the common liquid reservoir 33, and enter into the first header 24b of the condensor 24 via the surface of the cooling medium 25 within the common liquid reservoir 33. Thus, the first header 24b is filled with vapor 27. The vapor 27 is cooled in the condensor 24 to be condensed into the liquid phase medium 25. The liquid cooling medium 25 returns to the common liquid reservoir 33 due to the action of gravity, and thence is carried back by the convection to the cooler fins 31 so as to cool the thyrister elements 3.

In the case of the boiling cooler device as described above, the ducts 32 for communicating the interiors of the cooler fins 31 to the common liquid reservoir 33 extend substantially horizontally and the cooler fins 31 are thus disposed to a lateral side of the common liquid reservoir 33. Thus, the overall height of the device is reduced compared with the conventional devices as shown in Fig. 2.

In the case of the above embodiment, water or aqueous solution of ethylene glycol is utilized as the cooling liquid 25. Thus, the cooling modes of the thyrister elements 3 are not limited to the cooling by means of ebullition (boiling); it may comprise the cooling mode by means of convection or the mixed cooling mode by means of convection and ebullition. With respect to these modes of cooling effected partly or wholely by means of convection, it is noted that in the case of the above embodiment, the ducts 32 extend substantially horizontally, and the cooler fins 31 are disposed to a side of the common liquid reservoir 33. Thus, the convection produces the circular movement of the cooling liquid 25 as shown in Fig. 8, which enhance the cooling efficiency of the convection mode. Further, the bubbles 26 move smoothly within the ducts 32 near the top surface of the cooling liquid 25 therein, and the resulting movements of the bubbles enhance the convection of the cooling liquid 25. Thus, the cooling efficiency is improved compared with the conventional device of Fig. 2.

By the way, when pure water or an aqueous solution of ethylene glycol is utilized as the cooling liquid 25, the operational temperature is at about from - 20 to 60 °C, so that the pressure of the vapor 27 is as low as 150 mm Hg or less. Thus, the prevention of leakage of air into the cooler device is essential. This is the same as in the case of the embodiment according to the first aspect of this invention.

Next, Fig. 10 shows a sectional view of boiling cooler device according to a second embodiment of the second aspect of this invention.

As shown in Fig. 10, each one of the cooler fins 31 is coupled to the common liquid reservoir 33 via the upper and lower ducts 34 and 35, which extend substantially horizontally to communicate the interiors of the cooler fins 31 to the common liquid reservoir 33. The upper and lower ducts 34 and 35 run parallel to each other, being vertically spaced from each other. Otherwise, the structure is similar to that of the device shown in Fig. 8.

In the case of this boiling cooler device, the vapor bubbles 26 generated within the cooler fins 31 proceed through the upper ducts 34 into the common liquid reservoir 33. Conversely, the cooling liquid within the common liquid reservoir 33 returns to the cooler fins 31 via the lower ducts 35. Thus, as shown by the arrows in the figure, the convection of the cooling liquid 25 is further promoted, and hence the cooling characteristics are further enhanced.

Next, Fig. 11 shows a side cross sectional view of a boiling cooler device according to a third embodiment of the second aspect of this invention.

As shown in this figure, the top side of the cooler fins 31 are extended further upward compared with the case of Fig. 10, such that the surface level of the cooling liquid 25 is situated well above the heat absorbing surfaces 31a of the cooling fins 31. Further, the space above the liquid surface within the cooler fins 31 and the space above the liquid surface within the common liquid reservoir 33 (or the space within the first header 24b) are coupled to each other via the vapor ducts 36 which couple the top portion of the cooler fins 31 to a side of the first header 24b of the condensor 24. Thus, each one of the cooler fins 31 are coupled to the common liquid reservoir 33 via three horizontal ducts 36, 34, 35 (from top to bottom).

In the case of this boiling cooler device, the vapor ducts 36 are provided exlusively for the purpose of transporting the vapor 27 from the cooler fins 27 to the first header 24b; thus, most of the vapor 27 is transported to the condensor 24 without being hindered by the resistance of the cooling liquid 25. Thus, the cooling characteristics are further enhanced.

Next, Fig. 12 shows a side cross sectional view of a boiling cooler device according to a fourth embodiment of the second aspect of this invention.

As shown in this figure, the condensor 24 is tilted in a direction opposite to that which is the case in Figs. 10 and 11. Namely, the second header 24c is situated at a lower level than the first header 24b above the common liquid reservoir 33, so that the finned tubes 24a are tilted downward toward the second header 24c. Further, a liquid return pipe 37 is provided between the bottom end of the second header 24c and the common liquid reservoir 33. The bottom portion of the first header 24b serves as the common liquid reservoir 33.

According to this embodiment, the cooling liquid 25 leaves top space unfilled within the cooler fins 31 and the ducts 32, so that a wide conduit is provided for the vapor 27. Thus, the pressure loss of the vapor 27 is small, and thus the vapor 27 is soon rendered uniform. Further, thanks to the geometry of the condensor 24 and the provision of the liquid return pipe, the condensed cooling liquid 25 returns from the second header 24c to the common liquid reservoir 33 via the liquid return pipe 37, such that the condensed cooling liquid 25 and the vapor 27 does not come into contact with each other immediately after the condensation. Thus, the cooling efficiency is enhanced.

By the way, although the above embodiments of the second aspect of this invention relate to cases where pure water or aqueous solution of ethylene glycol is utilized as the cooling liquid 25, this aspect of the invention is applicable to cases where aqueous solultions of other materials or liquid fluorocarbons are utilized instead. Furthermore, although the above embodiment relate to cases where the number of ducts connecting each one of the fins to the common liquid reservoir ranges from one to three, four or more ducts may also be utilized. Further, the cross-sectional form of the ducts may be circular, rectangular, or polygonal, as the case may be, and, as described in detail hereinafter by reference to Fig. 24, etc., the ducts may consist, partially or wholely, of bellows. Furthermore, although the above embodiments relate to cases where the cooled bodies consist of thyrister elements 3, it goes without saying that this invention is not limited to such cases.

Next, embodiments according to the third aspect of this invention are described by reference to the accompanying drawings. The third aspect is a modification of the second aspect of this invention.

Fig. 13 is a vertical sectional view of the essential portions of a boiling cooler device according to the first embodiment of the third aspect of this invention; Figs. 14 and 15 are a sectional view along the line A-A and line B-B of Fig. 13, respectively, as viewed in the direction of the arrows.

As shown in these figures, a block-shaped element 41 is disposed within each one of the cooler fins 31 to span across the two opposing heat absorbing surfaces 31a thereof. The device according to this embodiment is made of copper, and hence the element 41 is also made of copper. The element 41 comprises a multitude of interior ducts 42 of circular cross-section extending vertically therethrough to form interior conduits therethrough. Otherwise the structure of the device is similar to that of the device of Fig. 8.

In the case of this boiling cooler device, the cooler fins 31 are disposed to a side of the common liquid reservoir 33; thus, as in the case of the embodiments of the second aspect of this invention, the overall height is reduced. Further, since circular interior ducts 42 extending vertically within the cooler fins 31 between the heat absorbing surfaces 31a are provided, the bubbles 26 generated within the cooler fins 31 are guided therethrough to rise smoothly upward. As a result, the ebullition (i.e., boiling) cooling and the convection of the cooling liquid 25 are promoted. Thus, the cooling characteristics of the cooler fins 31, especially those under small heat load, are improved.

Next, this enhancement of the cooling efficiency brought about by the interior ducts of the element 41 is explained by reference to the drawings. Fig. 16 is a graph showing the relations between the degree of superheating and the heat flux. The data dots shown in Fig. 16 represent the experimental results concerning the ebullition cooling characteristics of vertically extending circular tubes when pure water is utilized as the cooling medium. The results were obtained at the liquid temperature of 60 °C, under the condition of uniform heat flux through the heat transfer surfaces. The vertical circular tubes were utilized which range from 3 mm to 9 mm in inner diameter, and from 40 mm to 80 mm in length. Further, to compare with the results obtained with respect to these tubes, the ebullition cooling characteristics of a horizontally disposed disk of 10 mm in diameter are shown in a broken line.

As seen from these experimental results shown in Fig. 16, even in the region below the boiling or ebullition starting point where the heat flux through the heat transfer surface is small, the ebullition cooling characteristics of the vertical circular tubes represented by the respective dots are enhanced compared with those of the horizontal disk represented by the dotted line.

Further, Fig. 17 shows the relationship between the degree of superheating and the heat flux. The data dots represent the experimental results obtained with regard to the ebullition cooling characteristics of vertical circular tubes when aqueous solutions (20 % by weigth and 35 % by weight, respectively) of ethylene glycol are utilized as the cooling medium. The results were obtianed at the liquid temperature of 60 °C, under the condition of uniform heat flux through the heat transfer surfaces. The vertical circular tubes were utilized which range from 6 mm to 12 mm in inner diameter, but are fixed at 80 mm in length. Further, to compare with the results obtained with respect to the vertical tubes, the ebullition cooling characteristics of a horizontally disposed disk of 10 mm in diameter are shown in a solid line.

As shown by the experimental results shown in Fig. 17, the ebullition cooling characteristics of the vertical circular tubes in the region of small heat flux are also enhanced in the case where aqueous solution of ethylene glycol is utilized.

Thus, from the experimental results shown in Figs. 16 and 17, it can be concluded that the cooling characteristics of the cooler fins 31, especially those under small heat load, can be enhance by means of the circular interior ducts 42 according to this embodiment.

Next, referring to Fig. 18, a cooling fin of a boiling cooler device according a second embodiment of the third aspect of this invention is described. Fig. 18 shows a horizontal cross section of one of the cooler fins 31 corresonding to that of Fig. 15. In the case of this embodiment, rectangular ducts 43 of rectangular cross section are utilized as the interior conduits or ducts, whereby meritorious effects similar to that of the embodiments of Figs. 13 through 15 are obtained.

Fig. 19 shows a cross section of one of the cooler fins 31 of boiling cooler device according to a third embodiment of the third aspect of this invention. Fig. 20 shows the cross section along line C-C in Fig. 19 as viewed in the direction of the arrows at C. As shown in these figures, a plurality of vertically extending fins 44 project toward the opposte side from the innner side of the heat absorbing surface 31a of a cooler fin 31. The fins 44 form interior conduits 45 through the central portion of the cooler fin 31. In the case of this embodiment, the vapor bubbles generated in the cooling liquid 25 by the heat transmitted from the heat absorbing surface 31a are separated from the fins 44 to move upward through the central portion of the cooler fin 31; thus, the upper limit of the heat flux that can flow through the heat absorbing surface 31a increases, thereby suppressing the drying-out phenomenon accurring at the heat absorbing surface 31a.

Next, a fourth embodiment of the third aspect of this invention is decribed by reference to Figs. 21 through 23. Fig. 21 shows a cross section of one of the cooler fins 31 of boiling cooler device according to the fourth embodiment of the third aspect of this invention. Fig. 22 shows the cross section along line D-D in Fig. 22 as viewed in the direction of the arrows. Fig. 23 shows a portion of the element 41 in a perspective view. In these figures, an element 41 disposed within each one of the cooler fins 31 has a multitude of two-layered rectangular ducts 46 extending vertically therethrough to form interior conduits or ducts. The wall thickness of each one of the two-layer rectangular ducts 46 is not greater than 2 mm. Fig. 23 shows the ducts 46 in an enlarged perspective view. A multitude of fine particles 47 for enhancing heat transfer are attached to the surface of the ducts 46. The fine particles 47 may consist, for example, of small pieces made of aluminum or copper.

The meritorious effects similar to those of the above embodiments are also obtained by means of the two-layer rectangular ducts 46 formed through the element 41. Further, even when, as shown in Fig. 21, the upper surface of the cooling liquid 25 is below the top end of the heat absorbing surface 31a, the generated vapor bubbles 26 moving upward within the two layer rectanular ducts 46 push up the cooling liquid 25 within the duct 46 such that the cooling liquid 25 boils over the top ends of the ducts 46. Thanks to this pumping effect caused by the upward movement of the bubbles within the interior ducts 46, the whole heat absorbing surface 31a is cooled and efficient ebullition cooling is ensured. Further, the elements 41 having the two-layer rectangular ducts 46 provide structural strength. Furthermore, it is to be noted that when the elements 41 having the two-layer rectangular ducts 46 are utilized, the heat transfer efficiency of the cooler fins 31 is relatively deteriorated, so that the heat flux through the heat absorbing surface 31a increases, thereby realizing the utilization of sufficiently developed nucleate boiling heat transfer characteristics.

Fig. 24 shows a side cross section of a boiling cooler device according to a fifth embodiment of the third aspect of this invention. As in the case of Fig. 21, cooler fins 31 provided with an element 41 having two-layer rectangular ducts 46 are utilized. The bottom portion of the first header 24b serves also as common liquid reservoir 33; the first header 24b is coupled to the cooler fins 31 via the bellows 48 serving as the duct for communicating the interior of the cooler fins 31 to the first header 24b. Generally, the cooler fins 31 are supported on the stack 12 of thyrister elements 3, the condensor 24 being supported on other mounting portions to which the cooler device is mounted. Thus, there may result large stresses in the duct connecting the cooler fins 31 to the condensor 24. Further, due to thermal deformations, undue stereses may be developed in the ducts. However, the bellows 48 used as the duct for coupling the cooler fins 31 to the condensor 24 liberate the stresses and thus prevents the failure thereof.

It is noted that in the case of the above embodiment, water or aqueous solution of ethylene glycol is utilized as the cooling liquid 25; however, aqueous solutions of other materials or liquid fluorocarbons may also be utilized. Furthermore, the cooled bodies may comprise elements other than thyrister elements 3. In addition, the above embodiments show the case where the number of ducts is one or two; however, as in the case of the second embodiment, the number of ducts may be three or more, the cross-sectional form of the ducts being not limited to those shown above. Furthermore, in the case where two or more ducts are utilized, bellows 48 may be utilized for each one of the ducts as shown in Fig. 25.

Fig. 26 shows a side cross sectional view of a boiling cooler device provided with the cooler fins 31 of Fig. 21. In this figure, the dotted lines A, B, and C represent the position of the upper surface of the cooling liquid 25, respectively. The experimental results obtained by a cooling test utilizing this boiling cooler device are shown in Figs. 27 to Fig. 30.

Fig. 27 shows the relations between the superheating degree and the heat flux in the case where pure water is utilized as the cooling liquid which fills the device of Fig. 26 to the upper liquid surface level at C. These results are represented by the respective data dots. For comparison's sake, the results obtained by means of a horizontally disposed copper disk of 10 mm in diameter and a vertically disposed circuilar tube of stainless steel (SUS according to the Japanese Industrial Standard), 6 mm in diameter and 80 mm in length, are also shown in the figure by a dotted line and a two-dots and dash line, respectively. The data obtained where fluorocarbon R113 is utilized as cooling liquid 25 are also shown by data dots (small circles with a cross within).

As shown in Fig. 27, the results which are obtained where pure water is utilized at the liquid surface elvel of C in the device of Fig. 26 exhibit superior ebullition cooling characteristics compared with the results obtained with respect to the fluorocarbon R113, the horizontal disk, and the vertical circular tube.

By the way, the calculations of the heat flux and the superheating degree are effected according to the following equations (1) and (2):

(heat flux) = Q/A (1)

wherein

Q = (power loss of the thyrister elements)

A = (area of the heat absorbing surface)

and

(superheating degree) = $\Delta$Tsat = T - t (2)

wherein:

T = (temperatrue at the heat absorbing surface)

t = (temperature of the cooling liquid).

Fig. 28 shows the relation between the superheating degree and the heat flux in the case where 35 % by weight aqueous solution of ethylene glycol is utilized as the cooling liquid to fill the device of Fig. 26 to the upper liquid surface level at C. The results are represented by the respective data dots. Further, as in the case of Fig. 27, the data obtained with respect to flurocarbon R113 are also shown by data dots represented by small circles with a cross within. The results obtaiend with respect to a horizontal copper disk of 10 mm in diameter and a vertically disposed stainless steel circular tube (6 mm inner diameter, 80 mm long) are also shown in the figure by a dotted line and a dot-and-dash line (the results with respect to the copper disk) and by a two-dots-and-dash line and a three-dots-and-dash line (the results with respect to the stainless tube). As is apparent from this figure, good ebullition cooling characteristics are also obtained where aqueous solution of ethylene glycol at the upper liquid level height C is utilized.

It is apparent from the results shown in Fig. 28 that the device of Fig. 26 utililng aqueous solution of ethylene glycol exhibits a superior cooling efficiency.

Fig. 29 shows the relations between the boiling heat transfer coefficient (heat transfer rate) and the heat flux, which are obtained from the results of the cooling experiments utilizing the device of Fig. 26. The results shown therein comprise the data obtained in the cases where pure water, aqueous solutions of ethylene glycol (20 % by weight and 35 % by weight), and fourocarbon R113 are utilized as the cooling liquid at the upper liquid surface level C. These results are shown by the respective data dots. Further, for comparison's sake, the data for a horizontal copper disk of 10 mm in diameter is also shown by a dotted line, a dot-and-dash line, and a two-dots-and-dash line.

From the results shown in this figure, it can be concluded that when pure water or aqueous solution of ethylene glycol are utilized in the device of Fig. 26, enhanced boiling heat transfer coefficient is obtained in a wide range of the heat flux.

Fig. 30 is a graph which shows the relation between the upper liquid surface level and the parallel thermal resistance in the case where 35 % by weight aqueous solution of ethylene glycol is utilized in the device of Fig. 26. The data shown by the curve was obtained at a heat load of 1000 W. The parallel thermal resistance, which represents the cooling characteristics of the cooler fins 31, is good in the range between A′ and C. This is due to the fact, first, that if the liquid surface level is lower than the level A′, the part of the heat absorbing surface 31a exposed above the liquid becomes large; and, second, that if the liquid surface level is higher than the level C, the cooling liquid 25 presents a resistance to the movements of the vapor bubbles 26. As a result of the experiment, it can be concluded that the liquid surface level is appropriately set at a level higher than the level 10 mm below the top end of the heat absorbing surface 31a. The efficiency of the ebullition cooling can thereby be enhanced.

Next, an embodiment according to the fourth aspect of this invention, which is also a modification of the second aspect, is described by reference to the drawings.

Fig. 31 shows a side cross sectional view of a boiling cooler device according to an embodiment of the fourth aspect of this invention; the parts identical or corresponding to those shown in Fig. 10 or 11 are designated by the same reference enumerals and the description thereof is omitted below.

In Fig. 31, the cooler fins 31, constituting the evaporator of the cooler device, and the condensor 24 are coupled to each other directly via a vapor pipe 49. On the other hand, to a side wall of the common liquid reservoir 33 is connected a liquid cooler 50 having a plurality of fin tubes 50a. The liquid cooler 50 is connected to the common liquid reservoir 33, and thence, via the respective ducts 34, to the cooler fins 31. Otherwise the structure is similar to that shown in Fig. 11.

In the case of the boiling cooler device of Fig. 31 as described above, a convection is generated in the cooling liquid 25 as shown by the arrows in the figure, especially when the heat load is small. The convecting cooling liquid 25 flows into the liquid cooler 50 to be cooled therein. Thus, even when the cooling is effected primarily by means of convection rather than boiling, i.e., even when the heat load is small, sufficient cooling efficiency is obtained.

By the way, in the case of the above embodiment, the liquid cooler 50 is of the air cooling type having fin tubes 50a; however, the liquid cooler 50 may be of replaced by any type capable of cooling the cooling liquid 25. Further, although in the case of the above embodiment the liquid cooler 50 is connected to the common liquid reservoir 33, it is to be noted that the liquid cooler may be connected directly to the cooler fins 31. Furthermore, although the above embodiment relates to non-immersed type boiling cooler device, this aspect of the invention is applicable to the boiling cooler device of the immersion type as well.

Next, an embodiment according to the fifth asepct of this invention is described by reference to the drawings. Fig. 32 shows a horizontal cross section of the evaporator of a boiling cooler device according to a first embodiment of the fifth aspect of this invention; and Fig. 33 shows a vertical cross section along the line E-E in Fig. 32 as viewed in the direction of the arrows.

As shown in these figures, to an outer side surface of the evaporator 51 is attached a cooled body 52, i.e., the heat generating body comprising thyrister elements or power transistors, etc. The evaporator 51 is coupled to a condensor (not shown) as described below. Through the evaporator 51 there extend a first cooling medium conduit 53 of a rectangular cross section and three second cooling conduits 54 of square cross sections. The second cooling medium conduits 54 are situated nearer to the side of the cooled body 52 than the first cooling medium conduit 53, running parallel to the first cooling medium conduit 53. The overall cross sectional area of the second cooling medium conduits 54 is smaller than that of the first cooling medium conduit 53. Within the first and the second cooling medium conduits 53 and 54 there flows a cooling liquid 25 such as water. Further, metal particles 55, constituting heat transfer promoting particles, are attached all over the interior wall surface of the first cooling medium conduit 53 situated at the side of the cooled body 52. To the bottom end of the evaporator 51 is attached a cooling medium entrance port 56; to the top end thereof is attached a cooling medium exit port 57. These ports 56 and 57 are connected to the condensor (not shown).

The operation of the device of Figs. 32 and 33 is as follows. When the cooled body 52 generates heat, the thus generated heat is conducted to the evaporator 51, to be cooled by means of the cooling liquid 25 within the second cooling medium conduits 54. If the heat load is small, this cooling via the second cooling medium conduits 54 is effected by means of the convection heat transfer; if the heat load is large, it is effected by means of the boiling (ebullition) heat transfer.

When, however, the heat load further increases, the second cooling medium conduits 54 having a small overall cross sectional area reach the burn-out point thereof; as a result, the heat transfer surfaces thereof undergo the dry-out phenomenon, the cooling characteristics thereof thereby being abruptly deteriorated. If this happens, the heat is transmitted to the first cooling medium conduit 53 having a larger cross sectional area than the second cooling medium conduits 54, such that the ebullition cooling is effected by means of the cooling liquid 25 within the fist cooling medium conduit 53.

Usually, the heat transfers to the cooling liquid 25 within the first and the second conduits 53 and 54 do not occurr independently of each other; on the contrary, the heat trasfer modes, such as the convection heat transfer, the ebullition heat transfer, and the heat transfer effected both by means of the convection and the boiling, are determined with respect to each other in accordance with the amounts of heat flowing into the heat transfer surfaces and the magnitudes of the heat flux as determined by the areas of the heat transfer surfaces. In particular, when the second cooling medium conduits 54 undergo the dry-out, all the heat load flow into the first cooling medium conduuit 53, such that the heat flux through the heat transfer surfaces of the first cooling medium conduit 53 increases abruptly.

As described above, in the case of this embodiment, the cooling is effect first by means of the second cooling medium conduits 54 having a smaller cross sectional area than the first cooling medium conduit 53, before it is effected by means of the first cooling medium conduit 53. Thus, the cooling characteristics under a relatively small heat load, i.e., when the electrical power loss of the cooled body 51 is small, are enhanced. On the other hand, when the heat load increases, the cooling is effected via the first cooling medium conduit 53, thereby enhancing the cooling efficiency under a larger heat load. Thus, the cooling characteristics taken as a whole are improved over a wide range of the heat load. Further, since the metal particles 55 are attached to the heat transfer surface, i.e., the interior wall surface, of the first cooliing medium conduit 53 in the case of the above embodiment, the area of the heat transfer surface thereof is increased, and the development of a temperature boundary layer is prevented. Thus, heat transfer is promoted, and, as a result, the cooling efficiency, in particular that under relatively large heat load, is further improved.

Next, the cooling characteristics of the boiling cooler device having the above evaporator 51 are described by reference to Fig. 34, which shows the boiling curves or the relations between the superheating degree and the heat flux of the device of the above embodiment.

In Fig. 34, the solid line passing through the points E, F, and A represents the boiling curve obtained in the case where only the first cooling medium conduit 53 is utilized without the metal particles 55 and without the second conduits 54. The point A thereon represents the burn-out point. When the metal particles 55 are attached, the boiling curve shifts to the curve E, F, C, and B as represented partly by a solid line and partly by a dotted line. When the second cooling medium conduits 54 are utlilized in addition, the points E and F on the boiling curve translates to points D and C, such that the boiling curve as a whole is now represented by the curve D, C, and B, as represented partly by a dot and dash line and partly by a dotted line.

The following advatnages of the boiling cooler device of Figs. 32 and 33 is clear from the results shown in Fig. 34. Namely, the attachment of the metal particles 55 to the first cooliing medium conduit 53 enhances the heat transfer, particularly under a large heat load, thereby improving the cooling efficiency. Further, when the heat load is small, sicne cooling medium conduits of a smaller cross sectinal area provide better cooling characteristics, the provision of the second conduits 54 improves the cooling characteristics particularly under small heat load (as shown by the translation of the solid line E,F to the dot and dash line D, E).

It is to be noted in this connection that in a majority of cases, the electrical power loss of the the cooled body consisting of power transistors, etc., varies with time in accordance with the operating conditions thereof. Thus, it is necessary that the cooler device exhibit a high cooling efficiency over the whole region of the operating condition ranging from a small to a large electrical power loss. With regard to this, the boiling cooler device having the above evaporator 51 is improved in the cooling efficiency and hence has an enhanced cooling characteristics over a wide range of the heat load, since it comprises the second cooling medium conduits 54 and, further, the metal particles 55.

Next, Fig. 35 shows a horizontal cross section of an evaporator 51 of an boiling cooler device according a second embodiment of the fifth aspect of this invention. Fig. 36 shows the vertical cross section along the line F-F in Fig. 35, and Fig. 37 shows the vertical cross section along the line G-G in Fig. 35.

As shown in these figures, a reinforcement plate 58 is disposed at the widthwise central portion of the first cooling medium conduit 53; the plate 58 span across the two interior side surfaces of the first conduit 53 to extend in the longitudinal direction thereof, such that the interior of the first cooling medium conduit 53 is divided into two rectangular parts. The cooled bodies 52 are attached to both sides of the evaporator 51. Thus, the second cooling medium conduits 54, each having a circular cross section, are disposed on both sides of the first cooling medium conduit 53, and the metal particles 55 are attached on both the interior side walls of the first cooling medium conduit 53.

This device has meritorious effects similar to those obtained by the above first embodiment of the fifth aspect of this invention. Further, the reinforcement plate 58 provides the structural strength against the pressure resulting from the thyrister elements which are in pressed contact with the evaporator 51 at the pressure level as great as about 3 tons.

By the way, the cross sectional form of the second cooling medium conduits 54 of the fifth aspect of this invention is not limited to the square as shown in Fig. 32 or the circle as shown in Fig. 35; it may take the form of a polygon or an ellipse. Further, the cross sectional form of the first cooling medium conduit 53 is not limited to that of a rectangle. Furthermore, the cooled bodies 52 are not limited to thyrister elements or power transistors; the number thereof is also not limited. In addition, the arrangement and the number of the first and the second cooling medium conduits 53 and 54 are not limited to those shown in the above embodiments. Thus, they may be modified as shown in Figs. 38 through 40, wherein a large number of the first conduits 53 are provided and the second conduits 54 of circular cross sections are disposed therebetween near the heat absorbing sides of the evaporator 51.

Further, in the case of the above embodiments, metal particles 55 are utilized as the heat transfer promotinng particles; these may comprise, for example, small pieces of aluminun or copper. The heat transfer promoting particles may comprise non-metalic particles as well, provided that they exhibit high heat conductivity. It is noted in particular that the heat transfer promoting particles made of the same material as the evaporator 51 can be easily attached thereto. Further, although the evaporator 51 of the above embodiments is made of copper, it may also be made of other materials such as aluminum, for example. Furthermore, the metal particles 55 are attached to the first cooling medium conduit in the case of the above embodiments. They may, however, attached to the second cooling medium conduits 54 as well. Further, in the case of the above embodiments, the metal particles 55 are attached over the whole side wall surfaces of the first conduits 53 situated at the side of the cooled bodies 52. They may be attached only on a portion of such wall surfaces, or on other wall surfaces as well. Furthermore, in the case of the above embodiments, water is utilized as the cooling liquid. The cooling liquid, however, may comprise aqueous solutions such as an aqueous solution of ethylene glycol, or liquid fluorocarbons such as R113. Further, although, in the above embodiments, the metal particles 55 are attached on the side walls of the first cooling medium conduit 53, the heat transfer promoting particles may be omitted; even with such omission, the meritorious effects of this invention are good enough.

Next, an embodiment according to the sixth aspect of this invention, which is a modification of the second aspect, is described by reference to the drawings. Fig. 41 shows a side cross sectional view of a boiling cooler device of the separate cooler fin type (non-immersion type) according to a first embodiment of the sixth aspect of this invention; and Fig. 42 shows a horizontal cross section of a cooler fin of Fig. 41. The parts which are idential or corresponding to those of Fig. 8 are represented by the same reference numerals, the description thereof being omitted below.

As shown in Figs. 41 and 42, on each one of the two heat absorbing surfaces 31a constituting the heat transfer surfaces of the cooler fins 31 constituting the evaporator of the cooler device, there is attached a single layer of heat transfer promoting particles 61. The cooling liquid 25 comprises pure water or an aqueous solution of ethylene glycol.

In the case of this boiling cooler device, when the heat transmitted to the cooler fins 31 exceeds a predetermined value, vapor bubbles 26 are generated from the gaps formed between the heat transfer promoting particles 61 or from the heat absorbing surfaces 31a. The thus generated vapor bubbles 26 move upward, pushing up the cooling liquid 25. When the vapor bubbles 26 reach the top space within the cooler fins 31, they move via the duct 32 to the common liquid reservoir 33, to enter into the first header 24b passing through the surface of the cooling liquid 25. Thus, the space within the first header 24b is filled with vapor 27. The vapor 27 is air-cooled within the condensor 24, to be condensed and liquefied therein. The resulting condensed liquid returns to the common liquid reservoir 33 due to the effect of gravity, to be used again in the cooling process therein.

By the way, in the case of the cooler device utilizing fluorocarbon R113, the interior wall surfaces of the cooler fins 31 are roughened by means of the shot blast process, etc., so that the heat transfer therethrough would be promoted. When, however, pure water or aqueous solution of ethylene glycol having physical properties different from those of fluorocarbons are utilized, sufficient heat transfer can not be obtained by means of the conventional devices. With regard to this problem, this embodiment has heat transfer promoting particles 61 attached on the heat absorbing surfaces 31a, so that the heat transfer from the heat absorbing surfaces 31a to the cooling liquid 25 is promoted and vapor bubbles 26 are easily generated over the whole surfaces during the boiling periods, thereby enhancing the cooling efficiency of the cooler device.

Fig. 43 shows a horizontal cross section of a cooler fin 31 according to a second embodiment of the sixth aspect of this invention, wherein heat transfer promoting particles 61 are attached in two layers on the interior side walls of the cooler fins 31 opposite to the heat absorbing surfaces 31a.

Fig. 44 shows a cross section of the cooler fin 31 according to a third embodiment of the sixth aspect of this invention, wherein a reinforcement plate 62 spans across the side walls of the cooler fin 31 so as to increase the structural strength of the cooler fin 31. Namely, when pure water or aqueous solution of ethylene glycol is utilized as the cooling liquid 25, a sufficiently developed nucleate boiling phenomenon is realised at a heat flux level above $10^5$ W/m$^2$, in contrast to the case where fluorocarbon R113 is utilized. Thus, provided that the heat load is at one and the same level, the smaller the area of the heat absorbing surfaces 31a is, the greater is the heat flux. On account of this reason, there are cases where it is better not to provide fins, etc., on the surface of the heat absorbing surfaces 31a for the purpose of increasing the heat transfer area. In such case, the structural strength of the cooler fins 31 may become insufficient. Then, the reinforcement plate 62 is necessary.

It is noted that the second and third embodiment of the sixth aspect of this invention provides similar meritorious effects as those of the first embodiment.

However, even when heat transfer promoting particles 61 are utilized, there may arise situations where a sufficient heat transfer promoting effect can not be obtained due to an inappropriate size of the particles. Thus, the optimal particle size of the heat transfer promoting particles 61 is described below in the case where pure water or aqueous solution of ethylene glycol is utilized as the cooling liquid 25.

First, the optimal particle size is estimated on the basis of an equation shown in "Nucleate Boiling Heat Transfer Characteristics of Porous Heat Transfer Surfaces", Collected Papers of Japan Society of Mechanical Engneers, No. 451, part B. The values of the physical properties of the materials which are required for the estimation are those of the latent heat of evaporation, surface tension, and density of the vapor of the cooling medium; for these values, those corresponding to the saturation temperature under consideration are utilized.

It is assumed that the heat transfer surface temperature difference or temperature gap ΔT (K) which is necessary for generating vapor bubbles from a heat transfer surface having cavities of an opening radius rc (cm), in a non-homogenous temperature field, is given by the following equation (3):

$$\Delta T = Kc \cdot 2\sigma\,(Ts + 273.15)/(L \cdot \rho v \cdot rc \cdot gc) \quad (3)$$

wherein:

$\sigma$ is the surface tension (kg/m);

L is the latent heat of evaporation (kcal/kg);

$\rho v$ is the density (kg/m$^3$) of the vapor of the cooling medium;

Ts is the saturation temperature (°C) of the cooling medium;

Kc is a constant; and

gc is the coefficient of conversion which is given by:

$$gc = 10^7 \text{ dyne}\cdot\text{cm/J} = 427 \text{ kgf}\cdot\text{m/kcal}$$

Further, it is inferred that in the case of porous material surfaces formed by the attached particles 61, the cavities formed between the particles form the effective nuclei of the bubbles. Thus, assuming that the dimension, i.e., the opening radius rc, of the cavities is proportional to the particle size, the following equation (4) holds:

$$rc = Kp \cdot rp \quad (4)$$

wherein:
Kp is a constant; and
rp is the radius (m) of the particles.

From the above equations (3) and (4), following equation (5) can be obtained:

$2\sigma$ (Ts + 273.15)/(L•$\rho$v•rp•gc) = (Kp/Kc) • $\Delta$T (5)

On the other hand, the temperature difference range of the porous surface having a high boiling heat transfer characteristics from the low heat flux level:

Q/A = 3 × $10^4$ W/$m^2$

to the high heat flux level:

Q/A = 1 × $10^5$ W/$m^2$

is expressed by the following equation (6):

0.094 ≦ Kp•$\Delta$T/Kc ≦ 0.23 (6)

Substituting equation (5) in equation (6), and arranging the terms with respect to the particle size rp, the following equation (7) is obtained:

$2\sigma$(Ts + 273.15)/(L•$\rho$v•gc × 0.23)
≦ rp ≦
$2\sigma$ (Ts + 273.15)/(L•$\rho$v•gc × 0.094) (7)

The optimal particle size has been estimated on the basis of the equation (7). The result is shown in the following table:

TABLE

| Ts | 40 °C | 60 °C | 70 °C | 80 °C |
|---|---|---|---|---|
| pure water | 1.54 ~ 3.8 mm | 0.63 ~ 1.54 mm | 0.41 ~ 1.0 mm | 0.28 ~ 0.68 mm |
| A | 1.3 ~ 3.1 mm | 0.52 ~ 1.27 mm | 0.34 ~ 0.83 mm | 0.23 ~ 0.55 mm |
| B | 1.1 ~ 2.7 mm | 0.44 ~ 1.1 mm | 0.29 ~ 0.71 mm | 0.20 ~ 0.48 mm |
| C | 0.98 ~ 2.4 mm | 0.40 ~ 0.98 mm | 0.26 ~ 0.63 mm | 0.17 ~ 0.43 mm |
| D | 67.7 ~ 166 mm | 15.4 ~ 37.6 mm | 7.9 ~ 19.2 mm | 4.3 ~ 10.5 mm |
| R113 | 54.5 ~ 133 µm | 28 ~ 68.8 µm | 20.7 ~ 50.6 µm | 13.6 ~ 33.0 µm |

In the above table:
A is 25 wt.% aqueous solution of ethylene glycol;
B is 35 wt.% aqueous solution of ethylene glycol;
C is 45 wt.% aqueous solution of ethylene glycol;
D is ethylene glycol liquid; and
R113 is fluorocarbon R113.

From the results shown in the above table, etc., the range of the radius of the heat transfer promoting particles 61 in the case where pure water or an aqueous solution of ethylene glycol is utilized as the cooling liquid 25 is concluded to be from about 0.17 to 3.8 mm. Taking the practical range within this range, the optimal particle size of the heat transfer promoting particles 61 is from about 0.17 to 1.0 mm in radius, namely, from about 300 to 2000 µm in diameter. This range of the optimal particle size is distinctly different from the case where fluorocarbon R113 is utilized.

Figs. 45 thgough 48 are the graphs of the relations between the superheating degree and the heat flux, which graphs show the boiling heat transfer characteristics of the heat absorbing surface 31a at a low pressure where pure water or aqueous solution of ethylene glycol is utlized as the cooling liquid 25. Fig. 45 shows the results where the particle size (i.e., diameter) of the heat transfer promoting particles 61 are 1000 µm and the heat transfer promoting particles 61 are single layered; Fig. 46 shows the case where particle size is 1000 µm and the heat transfer promoting particles 61 are double layered; Fig. 47 shows the case where particle size is 400 µm and the heat transfer promoting particles 61 are single layered; and Fig. 48 shows the case where the particle size is 400 µm and the heat transfer promoting particles 61 are double layered. The data dots shown in these figures are based on experimentally measured values. Further, for comparison's sake, the measurement values that are obtained utilizing a horizontal disk having a smooth surface of 10 mm diameter at a liquid temperature of 60 °C of respective media are also shown by the respective curves in the figures.

From these figures it can be concluded that with regard to any choise of the particle sizes and cooling media, the boiling heat transfer characteristics are markedly improved by the utilization of the heat transfer promoting particles 61, compared with the case of the horizontal disk.

Fig. 49 shows the relations, for respective particle sizes, between the heat flux and the heat transfer promoting rate (the ratio as expressed by the equation (8) below) in the case of pure water, obtained on the basis of the data shown in Figs. 45 through 48. Similarly, Fig. 50 shows the relations, for respective particle sizes, between the heat flux and the heat transfer promoting rate in the case of 35 % by weight aqueous solution of ethylene glycol.

From these figures, it can be affirmed that the heat transfer promoting rate is enhanced where the heat transfer promoting particles 61 are in the particle size range of from 400 to 1000 μm diameter (which gives a further preferred range within the above estimation of the optimal range of the particle size based on equation (7)), and are single or double layered. In particular, the case where the heat transfer promoting particles 61 are 1000 μm diameter and double layered exhibits a superior heat transfer promoting rate. By the way, the heat transfer promoting rate has been calculated by means of the following equation (8):

(heat transfer promoting rate) = $\Delta T1/\Delta T2$ (8)

wherein:

$\Delta T1$ = (superheating degree of the heat transfer surface having heat transfer promoting particles)

$\Delta T2$ = (superheating degree of smooth surface)

and

(superheating degree)

= (temperature on the heat absorbing surface)

- (temperature of the cooling medium)

Summarizing the above results, it can be concluded that the preferred particle size of the heat transfer promoting particles 61 where pure water or an aqueous solution of ethylene glycol is utilized as the cooling liquid 25 is from 300 to 2000 μm, and most preferably in the range of from 400 to 1000 μm. In addition, the meritorious effects can further be enhanced when the heat transfer promoting particles 61 is double layered.

By the way, although the above embodiment relates to a boiling cooler device of the separate fin type, the sixth aspect of this invention is applicalbe to the boiling cooler devices of the immersed type as well. In such case, the heat transfer promoting particles 61 may be attached to the heat dissipating block, etc., thereof attached to the heat generating body. Further, the heat transfer promoting particles 61 may comprise particles made of a metal such as copper and aluminum or those made of a non-metallic material; they may comprise particles made of any material, provided that the material exhibits a high heat conductance.

Next, an embodiment according to the seventh aspect of this invention is described by reference to drawings.

Fig. 51 shows the structure of a boiling cooler device according to an embodiment of the seventh aspect of this invention, wherein the parts identical or corresponding to those of Fig. 26 are represented by the same reference numerals and the description thereof is omitted below.

The embodiment of Fig. 51 is characterized by the monitoring means 70 for monitoring the pressure within the condensor. Thus, as shown in Fig. 51, a contractible and flexible member, or bellows, 71, is coupled to the top end of the first header 24b of the condensor 24. The space within this bellows 71 communicates with the space within the first header 24b, namely, the space 72 above the surface of the cooling liquid 25. Thus, the bellows 71 is contracted and extended in accordance with the pressure variations in the space 72 within the first header 24b. The bellows 71 is constantly urged by the spring 73 in the direction of contraction thereof.

At the top end of the bellows 71 is attached a movable contact 74a opposing the fixed contact 74b. the movable contact 74a moves accompanying the contraction and expansion of the bellows 71, to come into contact with and to be separated from the fixed contact 74b. The respective contacts 74a and 74b are coupled across the input terminals of the detector 75, which detects the abnormal pressure rise in the space 72 within the first header 24b. An alarm device 76 is coupled to an output of the detector 75.

The bellows 71, spring 73, the contacts 74a and 74b, the detector 75 and the alarm device 76 constitute the monitoring means 70.

To the side of the first header 24b is coupled via an electromagnetic valve 77 a vacuum contianer 78 which constitutes an exhaust means. The electromagnetic valve 77 is couled to the other output the detector 75, so that the valve 77 is opened when an abnormality is detected by the detector 75.

The operation of the boiling cooler device of Fig. 51 is the same as that of the device of Fig. 26, with regard to the ebullition cooling operations thereof.

As has been explained above with regard to the embodiments of the first aspect of this invention, when pure water or aqueous solution of ethylene glycol is utilized as the cooling liquid 25, the saturation pressure thereof at the operational temperature of the thyrister elements 3 (i.e., around 60 degrees Celsius) is lower than the atmospheric pressure (see Fig. 7). Thus, due to the pressure difference, non-condensing gases such as air may intrude into the space 72.

When air intrudes into the device, the cooling efficiency of the condensor 24 deteriorates, thereby raising the operational temperature of the cooliing liquid 25. As a result, the temperature of the cooler fins 31 also rises. Further, when the junction temperature of the thyrister elements 3 rises above the allowable temperature limit thereof, the thyrister elements 3 ceases to function. This entails grave consequences in the case of thyrister elements 3 mounted on railroad vehicles, since the vehicles must be stopped if the function of the thyrister elements 3 stops. This causes hinderance to the commercial operations of the railroad.

With regard to this problem, the device of the above embodiment operates as follows. When the pressure within the space 72 rises due to the intrusion of air, the bellows 71 elongates against the spring 73. When the pressure rise reaches a predetermined value, the movable contact 74a comes into contact with the fixed contact 74b, such that the abnormal pressure rise is detected by the detector 75. Thus, in response to the outputs of the detector device 75, the alarm device 76 sends out an alarm signal and the electromagnetic valve 77 is opened. As a result of the opening of the electromagnetic valve 77, the gas within the space 72 is exhaused into the vacuum container 78, such that the pressure within the space 72 is decreased. When the pressure within the device decreases, the bellows 71 contracts, to open the contacts 74a and 74b again. When the contacts 74a and 74b open, the normal output signal is outputted from the detector 75, so as to close the electromagnetic valve 77.

Thanks to these operations of the monitoring means 70 and the vacuum container 78, the deterioration of the cooling performance due to the leakage of the device is prevented, and the device can hence be used continually. Thus, the cooling performance of the device can be maintained stably for a long period of time.

By the way, the operational temperature of the cooling liquid 25 is determined by the heat load from the thyrister elements 3 and by the cooling efficiency of the condensor 24. Assuming the operational temperatuer of the cooling liquid 25 is at 60 °C, the vapor pressure P at the temperature is: P = 150 mm Hg (= 0.2 kg/cm$^2$abs), in the case where pure water is utilized as the cooling liquid 25; and P = 129 mm Hg (= 0.17 kg/cm$^2$abs), in the case where 35 % by weight aqueous solution of ethylene glycol is utilized as the cooling liquid 25.

On the other hand, let the area of the pressure receiving surface of the bellows 71 be S cm$^2$; let the spring constant of the spring 73 be k kg/cm; let the atmospheric pressure be $P_0$ kg/cm$^2$; and let the displacement of the movable end of the spring 73 when the cooling liquid 25 is at 60 °C be represented by $\Delta X$ cm; thenhen the following equation (9) holds:

$P_0 \cdot S = P \cdot S + k \Delta X$ (9)

wherein P is the vapor pressure of the cooling liquid 25.

Let us assume here that the inner pressure of the device, i.e., the vapor pressure P, increases by $\Delta P$ kg/cm$^2$ due to the leakage of the atmospheric air into the device, thereby increasing the length of the bellows 71 by $\Delta x_1$ cm. Then, the following equation (10) holds:

$P_0 \cdot S = (P + \Delta P) S + k(\Delta X - \Delta x_1)$ (10)

Substituting equation (9) in the equation (10) and re-arranging the terms, the following equation is obtained:

$\Delta P \cdot S - k \Delta x_1 = 0$

Namely, the displacement of the top end of the bellows 71 equal to:

$\Delta x_1 = \Delta P \cdot S/k$ (cm)

is observed in response to the pressure rise $\Delta P$.

Thus, if the allowable limit of the pressure rise within the device is predetermined, and, further, if the separation between the contacts 74a and 74b is set to a dimension corresponding thereto as determined by the above equation, then an alarm signal is correctly sent out at the abnormal pressure rise periods and the electromagnetic valve 77 is correctly opened at such abnormal periods to reduce the pressure within the space 72.

Further, although the above embodiment relates to a boiling cooler device of the separate fin type (non-immersion type), this aspect of the invention is applicalbe to the immersion type as well. Furthermore, the vacuum container 78 is utilized as the exhaust means in the case of the above embodiment; however, the exhaust means may consist of other devices such as a vacuum pump. In addition, the organization of the monitoring means 70 is not limited to that of the above embodiment.

Referring next to Figs. 52 to 56, the embodiments of the eighth aspect of this invention are described.

Fig. 52 is a graph of the relations between the superheating degree and the heat flux, which shows the boiling curves of respective cooling media at the saturation liquid temperature of 60 °C, the results shown being experimentally obtained by the inventors. The cooling media utilized in the experiments are: pure water (represented by the circular dots along the two-dots and dash line); 20 wt.% aqueous solution of ethylene glycol (trianglar dots along the solid); 35 wt.% aqueous solution of ethylene glycol (solid circular dots along the dotted) ; and 45 wt.% aqueous solution of ethylene glycol (rectangular dots along the dot and dash line). It can be seen from this figure that the boiling curves turns at heat flux of $10^5$ W/m$^2$.

The results obtained in the experiments were rearranged by substituting into the following equations (11) through (13) (which relate to the Nusselt number Nu and a dimensionless number F as described below) the measured values - superheating degree Δ Tsat, heat flux Q/A, the vapor pressure Ps, and the heat transfer coefficient α -and the values of physical properties of the respective media - the thermal conductivity K1, the surface tension σ, the specific gravity of the liquid ρl, the specific gravity of the vapor ρv, the Prandtl number Pr, the latent heat of the cooling medium L, and the thermal conductivity a1:

$Nu = (\alpha/K1)\cdot\sqrt{\sigma/(\rho l - \rho v)}$ (11)

$\alpha = Q/(A\cdot\Delta Tsat)$ (W/m$^2$ °C) (12)

$F = Pr^{-0.35}\cdot[\{0.86(Q/A)/(L\cdot\rho v\cdot al)\}\cdot\sqrt{\sigma/(\rho l-\rho v)}\,]^{0.7}\cdot[Ps/\sqrt{s(\rho l-\rho v)}\,]^{0.7}$ (13)

Fig. 53 shows the relation thus obtained between the Nusselt number Nu, which represents the rate of the nucleate boiling heat treanser, and the dimensionless number F, in the case of 35 wt.% aqueous solution of ethylene glycol.

In Fig. 53, the dot and dash line represents the the relation according to Kutateladze's equation:

$Nu = 7.0 \times 10^{-4}\cdot F$;

the dotted line represents the relation according to the equation:

$Nu = 9.0 \times 10^{-4}\cdot F$

obtained experimentally by the inventors. The majority of the data dots obtained with regard to the dimensionless numbers Nu and F fall within the range of from - 25 % to + 40 % with respect to the relation according to the experimental equation obtained by the inventors. However, when the dimensionless number F is below $2 \times 10^4$, the experimental measurement values have the characeristic that they deviate from the relation according to the experimental equation of the inventors. This shows the fact that the heat transfer characteristics of the 35 wt.% aqueous solution of ethylene glycol as the cooling medium may be divided into two regions: a region of strong nucleate boiling heat transfer characteristics and a region of relatively weak nucleate boiling heat transfer characteristics (i.e., the region where the nucleate boiling and the natural convection co-exist).

Fig. 54 shows the relation between the contents (mixture ratio) of the aqueous solution of ethylene glycol and the heat flux at the stable nucleate boiling starting point, wherein the experimental measurement values are shown with respect to saturaton temperatures: 40 °C, 60 °C, 70 °C, and 80 °C, respectively. It can be seen from this figure that the heat flux at the starting point of the nucleate boiling depends on the mixture ratio and the saturation temperature of the liquid.

Fig. 55 shows the relation between the molar fraction m of ethylene glycol and the value of the dimensionless number F at the beginning point of boiling. From the relations between the molar fraction m and the value of the number F, the following equation (14) can be obtained:

$F = 2.1 \times 10^4\cdot m^{0.027}$ (14)

By means of this equation (14), the value of F at the boiling or ebullition beginning point corresponding to a molar fraction m can be calculated when such molar fraction m is given.

On the other hand, the heat flux Q/A can be determined on the basis of the following equaition (15):

$Q/A = (L\cdot\rho v\cdot al/0.86)\cdot\sqrt{(\rho l-\rho v)/\sigma}\cdot[F/Pr^{-0.35}\cdot\{Ps/\sqrt{\sigma(\rho l-\rho v)}\,\}^{0.7}]^{1/0.7}$ (15)

Thus, if the heat transfer area A of the evaporator is determined such that the value of F in the equation (15) is not less than the value of F at the ebullition beginning point obtained by means of equation (14), then, with respect to the evaporator of a boiling cooler device utlizing aqueous solution of ethylene glycol as the cooling liquid, the device can be operated in the region Y shown in Fig. 56, where the heat flux is above the ebullition beginning point.

Further, where fluorocarbon cooling liquid is utilzed, the following value of F:

$F = 1.1 \times 10^4$

has been obtained as the value of F for determining the heat flux at the ebullition beginning point, from the experimental results with regard to the dimensionless numbers.

Similarly, the value of F:

$F = 2.7 \times 10^4$

has been obtained in the case where pure water or aqueous solution is utilied as the cooling liquid.

It is noted in the above equations that:

Q/A is the heat flux ($W/m^2$);

Q is the quantity of heat (W);

A is the area ($m^2$) of the heat transfer surfaces of the evaporator;

L is the latent heat of evaporation (kcal/kg);

$\rho v$ is the specific weight of the vapor ($kg/m^3$);

$\rho l$ is the specific weight of the liquid ($kg/m^3$);

al is the thermal conductivity of the liquid ($m^2/hr$);

$\sigma$ is the surface tension (kg/m);

Ps is the vapor pressure ($kg/m^2$); and

Pr is the Prandtl number of the liquid (dimensionless).

The above results can be sumarized as follows: Let the heat transfer area of the evaporator be determined such the following relation or inequality with respect to the dimensionless number F is satisfied:

$F \geqq 2.7 \times 10^4$

with respect to pure water or aqueous solutions;

$F \geqq 1.1 \times 10^4$

with respect to fluorocarbon cooling media; and

$F \geqq 2.1 \times 10^4 \cdot m^{-0.027}$

with respect to aqueous solution of ethylene glycol. Then, the heat flux above the level of the ebullition beginning point (i.e., in the range Y in Fig. 56) can be accomplished, so that practically stable boiling state ensues. Namely, an evaporator can be obtained whose superheating degree does not vary and whose cooling performance is stable.

While description has been made of the particular embodiments of this invention, it will be understood that many modifications may be made without departing from the spirit thereof; the appended claims are contemplated to cover any such modifications as fall within the true spirit and scope of this invention.

## Claims

1. A boiling cooler device comprising:
an evaporator containing a liquid cooling medium consisting of an aqueous solution of ethylene glycol, wherein a body to be cooled by the boiling cooler device is in thermal contact with the cooling medium to generate vapor of the aqueous solution of ethylene glycol; and
a condensor made of copper, coupled via a vapor conduit and a liquid return conduit to the evaporator, such that the vapor generated in the evaporator proceeds via the vapor conduit to the condensor to be condensed therein into liquid cooling medium, and the condensed liquid cooling medium returns therefrom via the liquid return conduit to the evaporator.

2. A boiling cooler device as claimed in claim 1, wherein the cooled body is in a pressured contact with an external side wall of the evaporator.

3. A boiling cooler device as claimed in claim 1, wherein the condensor comprises:
a first header coupled via the vapor conduit and the liquid return conduit to the evaporator;
a plurality of finned tubes each coupled at an end thereof to the first header to extend horizontally therefrom, the finned tubes being tilted by a predetermined angle from the horizontal direction; and
a second header coupled to the ends of finned tubes opposite to said ends coupled to the first header.

4. A boiling cooler device as claimed in claim 1, wherein said cooled body comprises a semicondutor switching element selected from the group consisting of a thyrister and a transistor.

5. A boiling cooler device comprising:
a common liquid reservoir containing a liquid cooling medium;
a plurality of evaporators containing the liquid cooling medium and disposed to a side of the common liquid reservoir, each one of the evaporators being in thermal contact with at least one cooled body at an exterior side surface thereof, such that vapor of the cooling medium is generated in the evaporators;
a plurality of ducts each extending substantially horizontally from a side of the common liquid reservoir to connect the common liquid reservoir to one of the evaporators, whereby the interior of each one of the evaporators is communicated via one of the ducts to the common liquid reservoir; and
a condensor coupled directly to the common liquid reservoir, the condensor condensing into the liquid cooling medium the vapor generated in the evaporators.

6. A boiling cooler device as claimed in claim 5, wherein the condensor comprises:

a first header coupled directly to the common liquid reservoir;
a plurality of finned tubes each coupled at an end thereof to the first header to extend horizontally therefrom, the finned tubes being tilted by a predetermined angle from the horizontal direction; and
a second header coupled to the ends of finned tubes opposite to said ends coupled to the first header.
7. A boiling cooler device as claimed in claim 5, wherein said cooled body comprises a semicondutor switching element selected from the group consisting of a thyrister and a transistor.
8. A boiling cooler device as claimed in claim 5, wherein said cooling medium comprises an aqueous solution of ethylene glycol.
9. A boiling cooler device as claimed in claim 5, wherein each one of the evaporators are coupled to the common liquid reservoir via a pair of vertically spaced substantally horizontally extending ducts.
10. A boiling cooler device as claimed in claim 5, wherein each one of the evaporators are coupled to the common liquid reservoir via three vertically spaced substantally horizontally extending ducts wherein a top surface level the liquid cooling medium contained in the common liquid reservoir and the evaporators is below a horizontal level of the uppermost duct of said three vertically spaced ducts.
11. A boiling cooler device as claimed in claim 6, wherein said plurality of finned tubes are tilted downward toward the second header, and a bottom portion of the second header is coupled to the common liquid reservoir via a liquid return pipe to be communicated therewith.
12. A boiling cooler device as claimed in claim 5, wherein the evaporators each comprise interior conduits extending vertically therewithin to a side of a heat transfer surface opposite to said exterior side surface of the evaporator which is in thermal contact with the cooled body.
13. A boiling cooler device as claimed in claim 12, wherein the evaporators each comprise a block-shaped element disposed therewithin to span across two opposing interior side walls thereof, each element having said interior conduits extending vertically therethrough.
14. A boiling cooler device as claimed in claim 12, wherein the condensor comprises:
a first header coupled directly to the the common liquid reservoir;
a plurality of finned tubes each coupled at an end thereof to the first header to extend horizontally therefrom, the finned tubes being tilted by a predetermined angle from the horizontal direction; and
a second header coupled to the ends of finned tubes opposite to said ends coupled to the first header.
15. A boiling cooler device as claimed in claim 12, wherein said cooled body comprises a semicondutor switching element selected from the group consisting of a thyrister and a transistor.
16. A boiling cooler device as claimed in claim 12, wherein said cooling medium comprises an aqueous solution of ethylene glycol.
17. A boiling cooler device as claimed in claim 12, wherein each one of the evaporators are coupled to the common liquid reservoir via a pair of vertically spaced substantally horizontally extending ducts.
18. A boiling cooler device as claimed in claim 5, wherein said ducts each comprise a bellows.
19. A boiling cooler device as claimed in claim 5, further comprising a liquid cooler coupled to the common liquid reservoir to cool the liquid cooling medium therein.
20. A boiling cooler device as claimed in claim 19, wherein said liquid cooler is coupled to a side of the common liquid reservoir opposite to the side thereof coupled to the evaporators via the ducts.
21. A boiling cooler device as claimed in claim 9. wherein a top portion of each one of the evaporators are coupled directly to the condensor via a vapor pipe.
22. A boiling cooler device comprising:
an evaporator containing a liquid cooling medium and having an exterior side wall in thermal contact with a cooled body, the evaporator comprising a first cooling medium conduit and second cooling medium conduits extending vertically therewithin, wherein the second cooling medium conduits are situated nearer to the cooled body than the first cooling medium conduits, and have an overall cross sectional area smaller than the cross sectional area of the first cooling medium conduit; and
a condensor coupled to the evaporator, such that the vapor generated in the evaporator is condensed into liquid cooliing medium within the condensnor.
23. A boiling cooler device as claimed in claim 22, wherein heat transfer promoting particles are attached to an interior side surface of the first cooling medium conduit situated to the side in thermal contact with the cooled body.
24. A boiling cooler device as claimed in claim 22, wherein the first cooling medium conduit is divided into a plurality of vertically extending conduits.
25. A boiling cooler device as claimed in claim 22, wherein the cooling medium comprises an aqueous solution of ethylene glycol.
26. A boiling cooler device comprising:
an evaporator containing a liquid cooling medium selected from the group consisting or water or an aqueous solution of ethylene glycol, a cooled body being in thermal contact with an exterior side of the evaporator to generate vapor of the cooling medium therein, wherein an interior heat transfer surface of the evaporator has attached thereon heat transfer promoting particles having a particle diameter ranging from about 300 µm to about 2000 µm; and

a condensor coupled to the evaporator to condense the vapor generated in the evaporator.

27. A boiling cooler device as claimed in claim 26, wherein said heat promoting particles have a particle diameter ranging from about 400 µm to about 1000 µm.

28. A boiling cooler device as claimed in claim 26, wherein the heat promoting particles attached to the heat transfer surface are double layered.

29. A boiling cooler device as claimed in claim 5, wherein an interior heat transfer surface of each one of the evaporators has attached thereon heat transfer promoting particles having a particle diameter ranging from about 300 µm to about 2000 µm.

30. A boiling cooler device as claimed in claim 29, wherein said heat promoting particles have a particle diameter ranging from about 400 µm to about 1000 µm.

31. A boiling cooler device as claimed in claim 29, wherein the heat promoting particles attached to the heat transfer surface are double layered.

32. A boiling cooler device comprising:

an evaporator containing a cooling medium selected from the group consisting of water and aqueous solution of ethylene glycol, the cooling medium being in thermal contact with a cooled body to generate vapor of the cooling medium;

a condensor coupled to the evaporator to condense the vapor of the cooling medium generated in the evaporator;

pressure monitoring means for detecting a pressure within an interior space of the condensor coupled to the evaporator, the monitoring means outputting a signal when the pressure of the interior space rises above a predtermined value; and

exhaust means, coupled to the monitoring means, for exhausting the interior space of the condensor in response to the signal of the monitoring means, thereby reducing the pressure within the interior space to a normal level.

33. A boiling cooler device as claimed in claim 6, wherein the cooling medium comprises a material selected from the group consisting of water and aqueous solution of ethylene glycol, and said boiling cooler device further comprises:

pressure monitoring means for detecting a pressure within an interior space of the first header of the condensor coupled directly to the common liquid reservoir, the monitoring means outputting a signal when the pressure of the interior space rises above a predtermined value; and

exhaust means, coupled to the monitoring means, for exhausting the interior space of the condensor in response to the signal of the monitoring means, thereby reducing the pressure within the interior space to a normal level.

34. A boiling cooler device as claimed in claim 32, wherein the monitoring means comprises:

bellows member coupled at an end thereof to the interior space of the condensor so as to expand and contract longitudinally in accordance with a rise and fall of the pressure within the interior space;

urging means for urging the bellows member in a direction of contraction thereof; and

detector means for detecting the displacement of the end of the bellows member opposite to the end coupled to the interior space, the detector means outputting a signal when the displacement exceeds a predtermined value corresponding to said predetermined value of the pressure within the interior space of the condensor.

35. A boiling cooler device as claimed in claim 32, wherein said exhaust means comprises:

an electromagnetic valve coupled to an output of the monitoring means to be opened in response to the signal from the monitoring means; and

a vacuum container coupled via the electromagnetic valve to interior space of the condensor to be communicated therewith.

36. A boiling cooler device comprising:

an evaporator containing a cooling medium selected from the group consisting of water and aqueous solutions, the cooling medium being in thermal contact with a cooled body to generate vapor of the cooling medium; and

a condensor coupled to the evaporator to condense the vapor of the cooling medium generated in the evaporator;

wherein the area A of a heat transfer surface of the evaporator is selected such that a dimensionless number F satisfies:

$F \geqq 2.7 \times 10^4$

where

$$F = Pr^{-0.35} \cdot [\{0.86(Q/A)/L \cdot \rho v \cdot al)\} \cdot \sqrt{\sigma/(\rho l - \rho v)}\ ]^{0.7} \cdot [Ps/\sqrt{\sigma(\rho l - \rho v)}\ ]^{0.7}$$

and

Q/A is a heat flux ($W/m^2$) through the heat transfer surface of the evaporator;
Q is a quantity of heat (W) flowing through the heat transfer surface of the evaporator;
A is the area ($m^2$) of the heat transfer surface of the evaporator;
L is the latent heat of evaporation (kcal/kg) of the cooling medium;
$\rho v$ is the specific weight ($kg/m^3$) of the vapor of the cooling medium;
$\rho l$ is the specific weight ($kg/m^3$) of the liquid cooling medium;
al is the thermal conductivity of the liquid cooling medium ($m^2/hr$);
$\sigma$ is the surface tension (kg/m) of the cooling medium;
Ps is the vapor pressure ($kg/m^2$) of the cooling medium; and
Pr is the Prandtl number of the liquid cooling medium.

37. A boiling cooler device comprising:
an evaporator containing a cooling medium consisting of an aqueous solution of ethylene glycol, the cooling medium being in thermal contact with a cooled body to generate vapor of the cooling medium; and
a condensor coupled to the evaporator to condense the vapor of the cooling medium generated in the evaporator;
wherein the area A of a heat transfer surface of the evaporator is selected such that a dimensionless number F satisfies:

$F \geqq 2.1 \times 10^4 \cdot m^{-0.027}$

where

$$F = Pr^{-0.35} \cdot [\{0.86(Q/A)/L \cdot \rho v \cdot al)\} \cdot \sqrt{\sigma/(\rho l - \rho v)}\ ]^{0.7} \cdot [Ps/\sqrt{\sigma(\rho l - \rho v)}\ ]^{0.7}$$

and

Q/A is a heat flux ($W/m^2$) through the heat transfer surface of the evaporator;
Q is a quantity of heat (W) flowing through the heat transfer surface of the evaporator;
A is the area ($m^2$) of the heat transfer surface of the evaporator;
L is the latent heat of evaporation (kcal/kg) of the cooling medium;
$\rho v$ is the specific weight ($kg/m^3$) of the vapor of the cooling medium;
$\rho l$ is the specific weight ($kg/m^3$) of the liquid cooling medium;
al is the thermal conductivity of the liquid cooling medium ($m^2$ /hr);
$\sigma$ is the surface tension (kg/m) of the cooling medium;
Ps is the vapor pressure ($kg/m^2$) of the cooling medium; and
Pr is the Prandtl number of the liquid cooling medium.

38. A boiling cooler device comprising:
an evaporator containing a cooling medium consisting of a liquid fluorocarbon, the cooling medium being in thermal contact with a cooled body to generate vapor of the cooling medium; and
a condensor coupled to the evaporator to condense the vapor of the cooling medium generated in the evaporator;
wherein the area A of a heat transfer surface of the evaporator is selected such that a dimensionless number F satisfies:

$F \geqq 1.1 \times 10^4$

where

$$F = Pr^{-0.35} \cdot [\{0.86(Q/A)/L \cdot \rho v \cdot al)\} \cdot \sqrt{\sigma/(\rho l - \rho v)}\ ]^{0.7} \cdot [Ps/\sqrt{\sigma(\rho l - \rho v)}\ ]^{0.7}$$

and

Q/A is a heat flux ($W/m^2$) through the heat transfer surface of the evaporator;
Q is a quantity of heat (W) flowing through the heat transfer surface of the evaporator;
A is the area ($m^2$) of the heat transfer surface of the evaporator;
L is the latent heat of evaporation (kcal/kg) of the cooling medium;
$\rho v$ is the specific weight ($kg/m^3$) of the vapor of the cooling medium;
$\rho l$ is the specific weight ($kg/m^3$) of the liquid cooling medium;
al is the thermal conductivity of the liquid cooling medium ($m^2/hr$);
$\sigma$ is the surface tension (kg/m) of the cooling medium;
Ps is the vapor pressure ($kg/m^2$) of the cooling medium; and
Pr is the Prandtl number of the liquid cooling medium.

FIG. 1

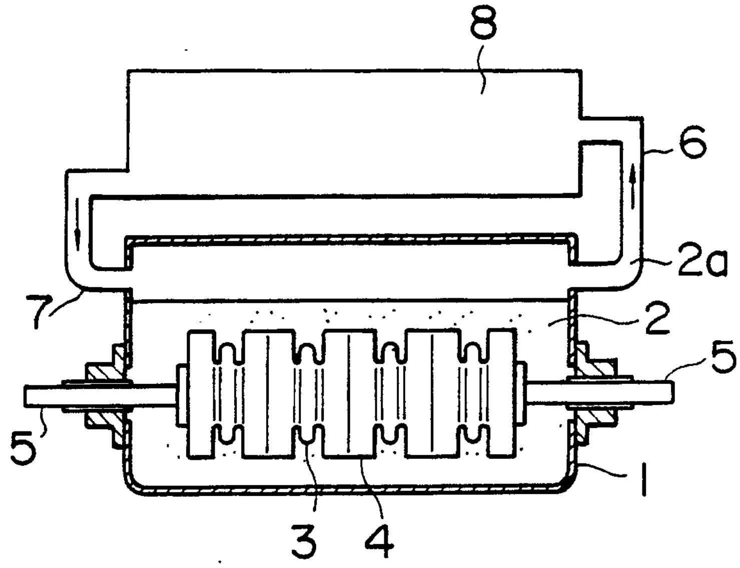


FIG. 2

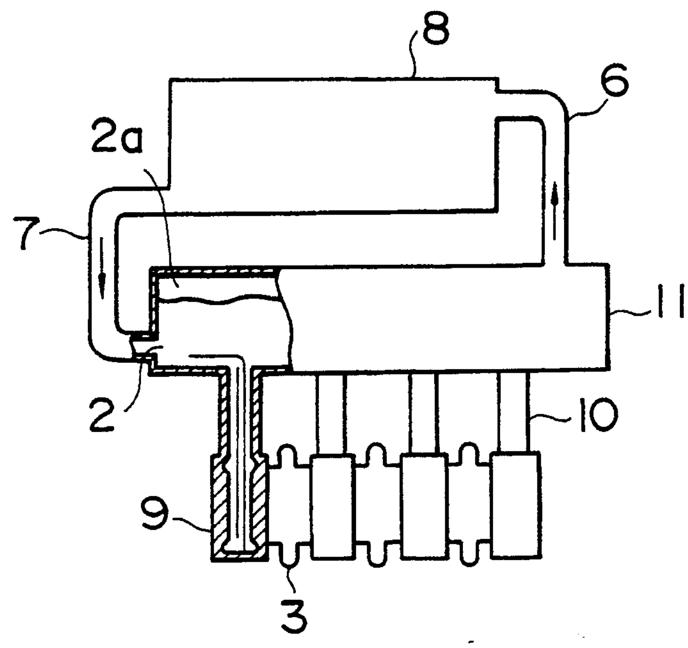

FIG. 3

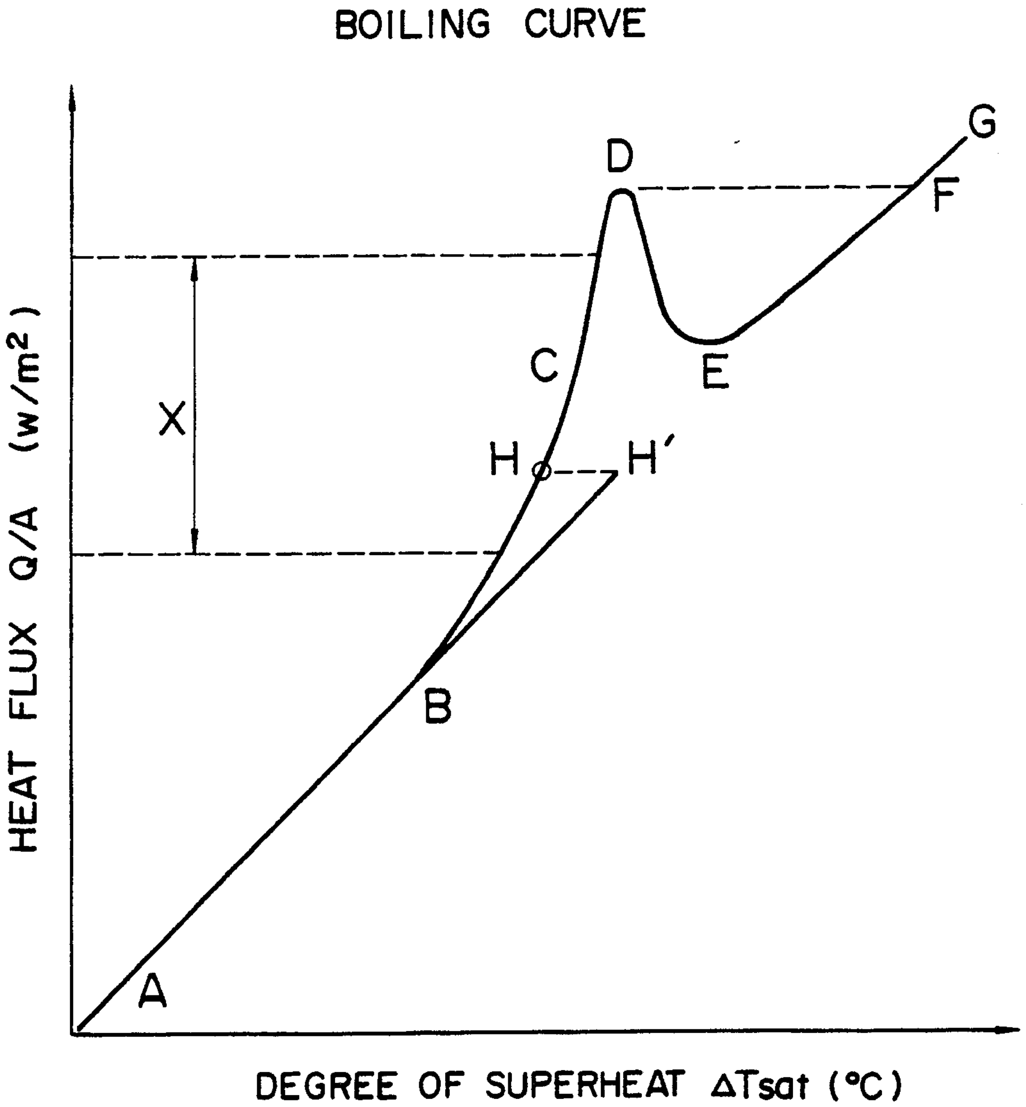
BOILING CURVE
HEAT FLUX Q/A (w/m²)
DEGREE OF SUPERHEAT ΔTsat (°C)
A
B
C
D
E
F
G
H
H'
X

FIG. 4

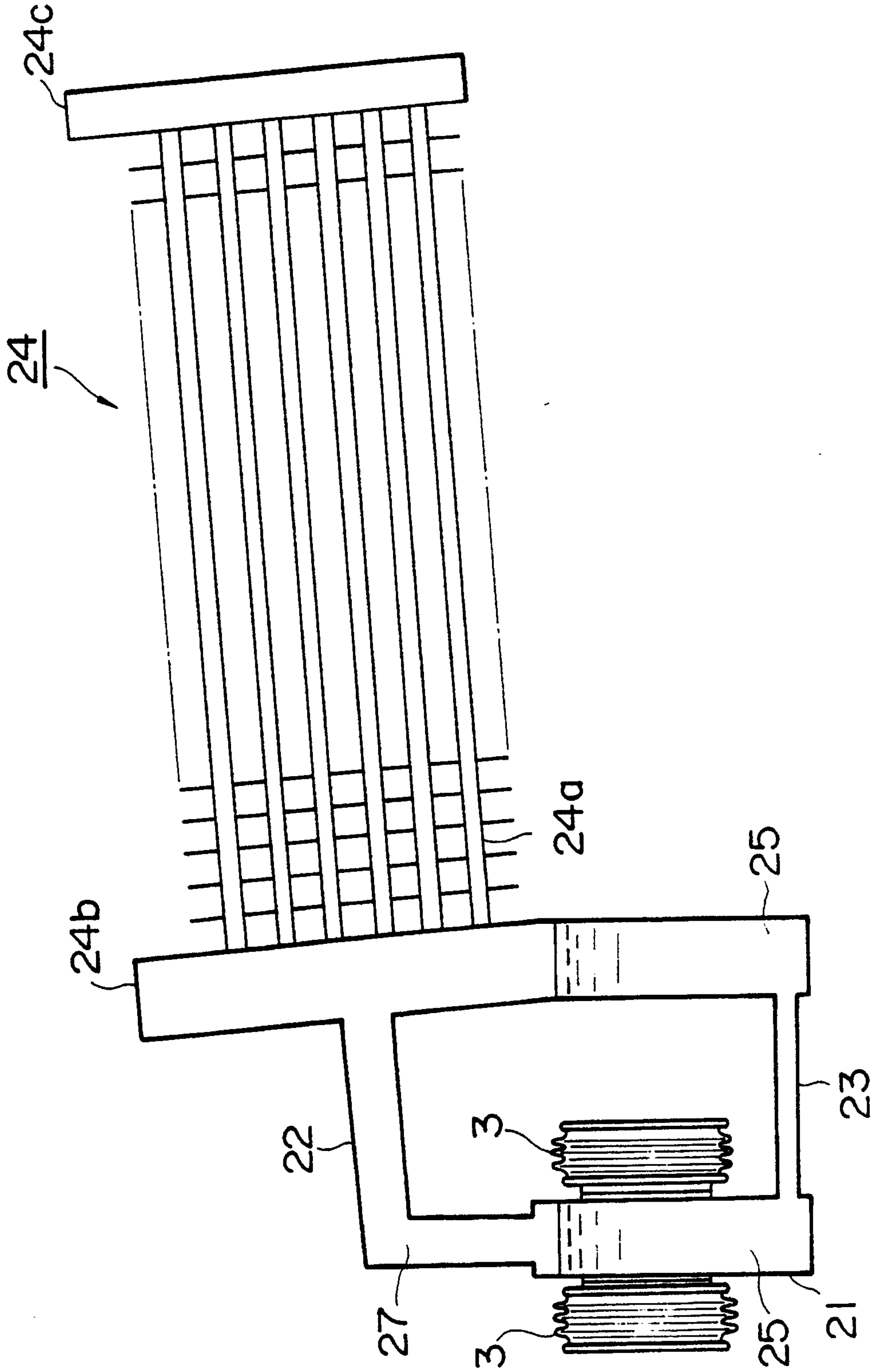

# F I G. 5

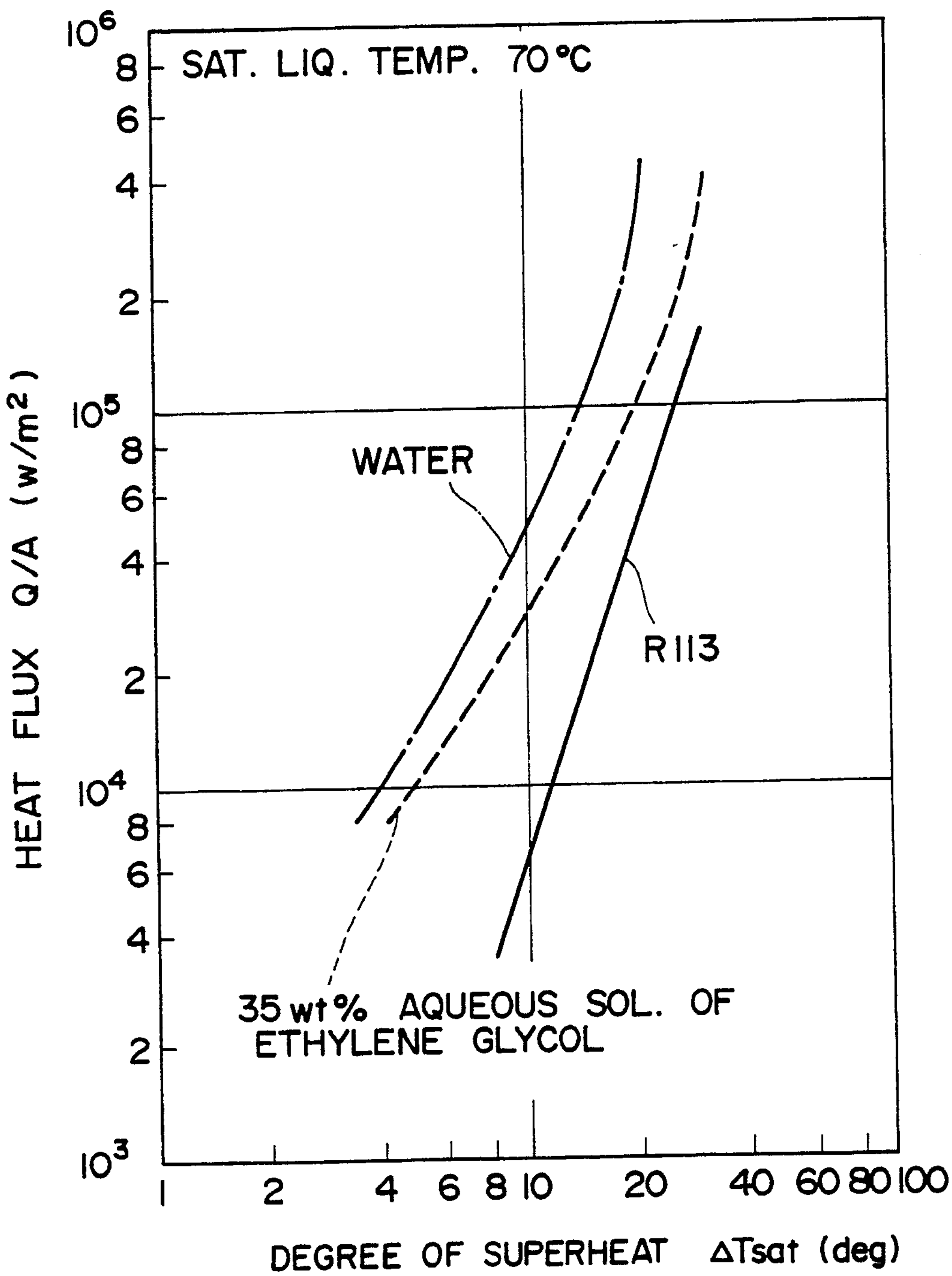
SAT. LIQ. TEMP. 70 °C
WATER
R113
35 wt % AQUEOUS SOL. OF ETHYLENE GLYCOL
HEAT FLUX Q/A (w/m²)
10⁶
8
6
4
2
10⁵
8
6
4
2
10⁴
8
6
4
2
10³
1
2
4
6
8
10
20
40
60
80
100
DEGREE OF SUPERHEAT ΔTsat (deg)

# FIG. 6

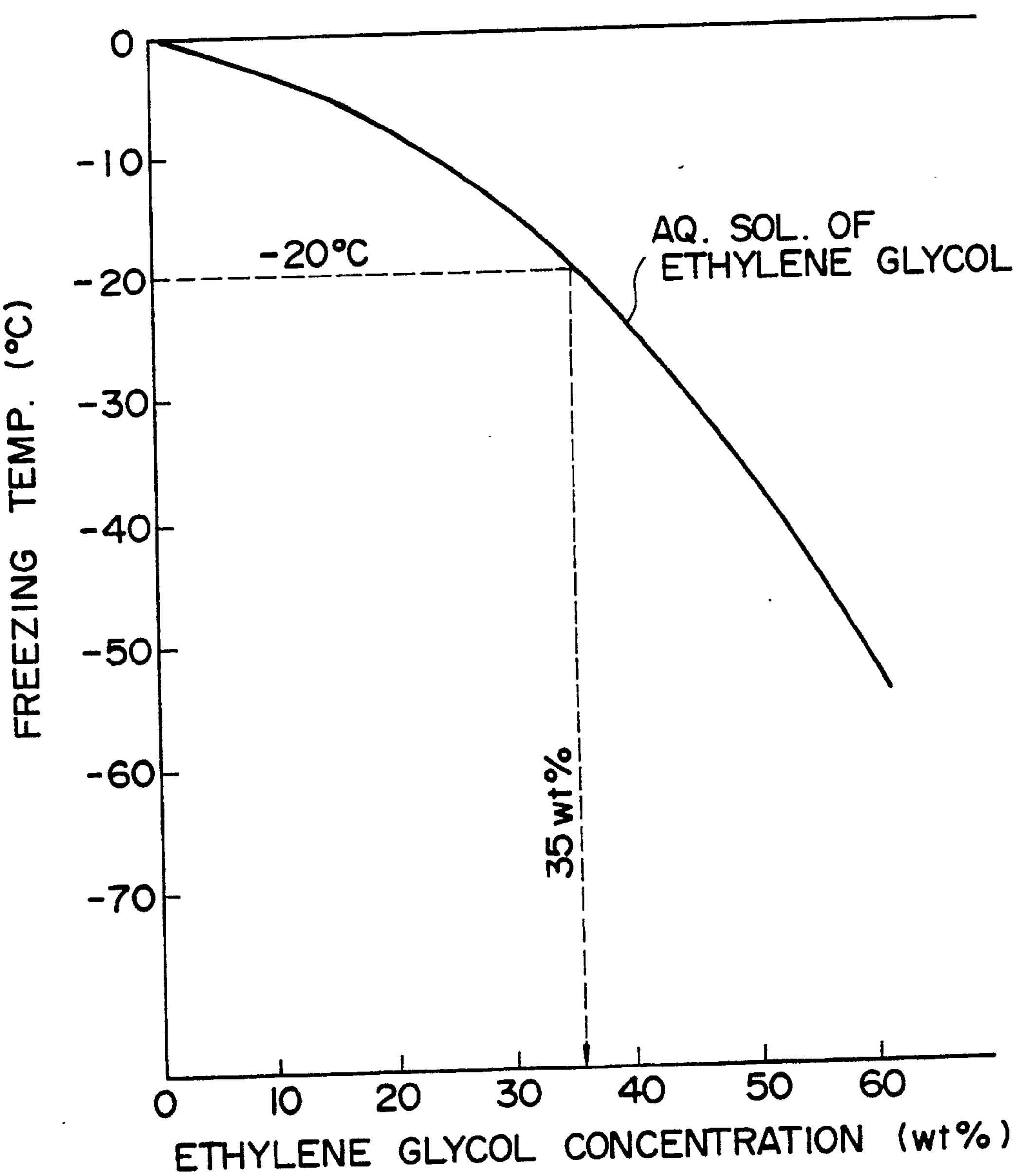
0
-10
-20
-30
-40
-50
-60
-70
FREEZING TEMP. (°C)
-20°C
AQ. SOL. OF ETHYLENE GLYCOL
35 wt%
0
10
20
30
40
50
60
ETHYLENE GLYCOL CONCENTRATION (wt%)

FIG. 7

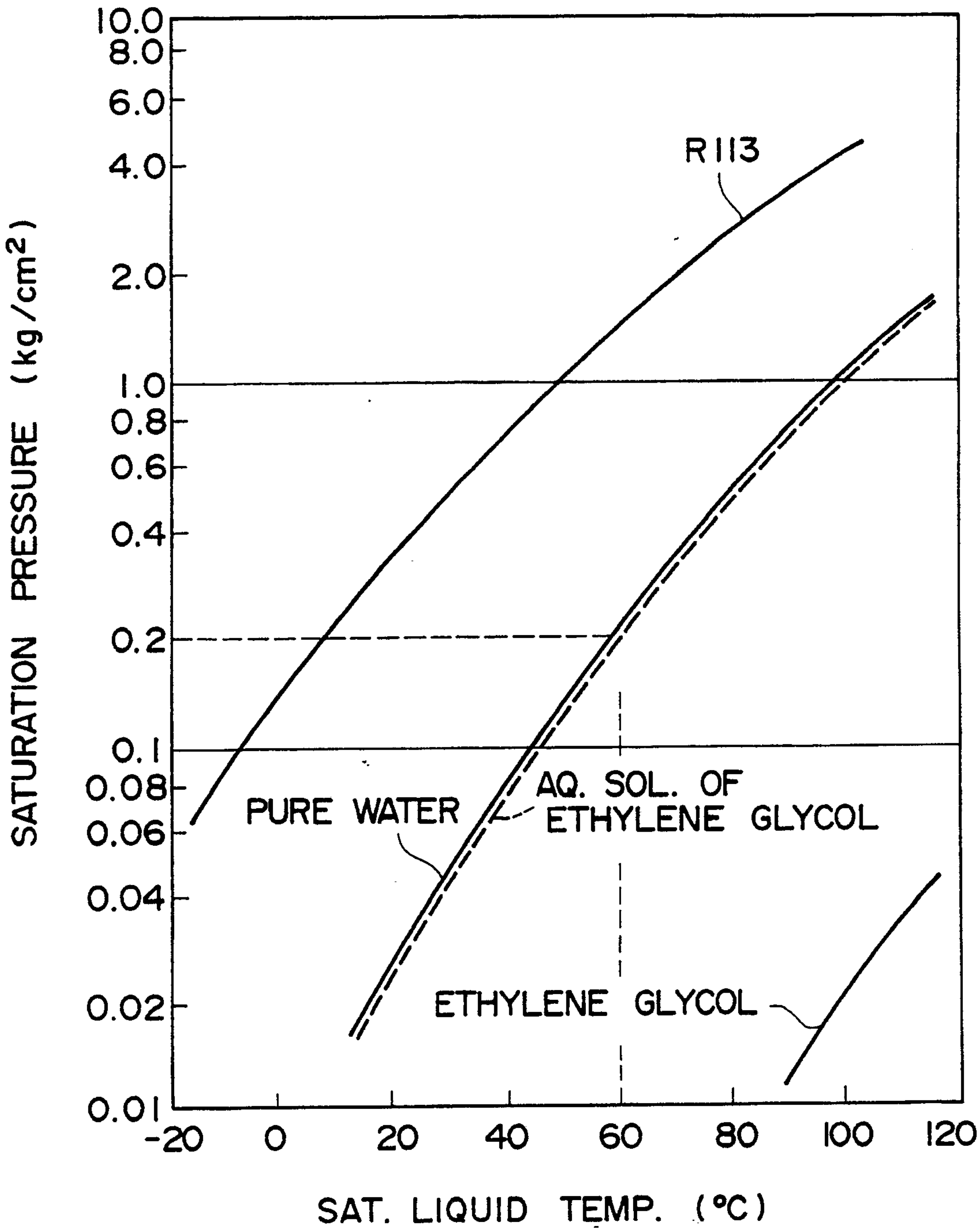
SATURATION PRESSURE (kg/cm²)
10.0
8.0
6.0
4.0
2.0
1.0
0.8
0.6
0.4
0.2
0.1
0.08
0.06
0.04
0.02
0.01
R113
PURE WATER
AQ. SOL. OF ETHYLENE GLYCOL
ETHYLENE GLYCOL
-20
0
20
40
60
80
100
120
SAT. LIQUID TEMP. (°C)

FIG. 8

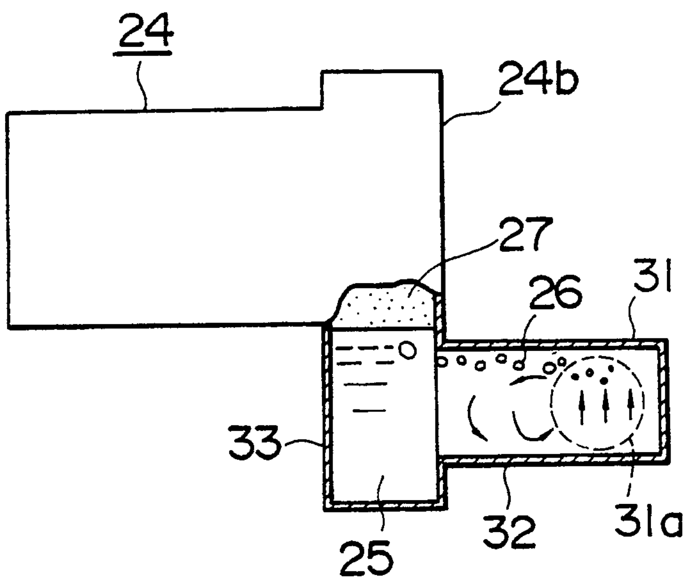


FIG. 9

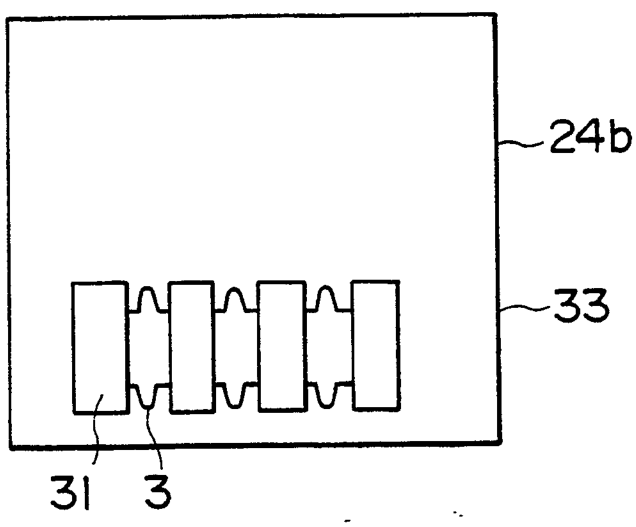

FIG. 10

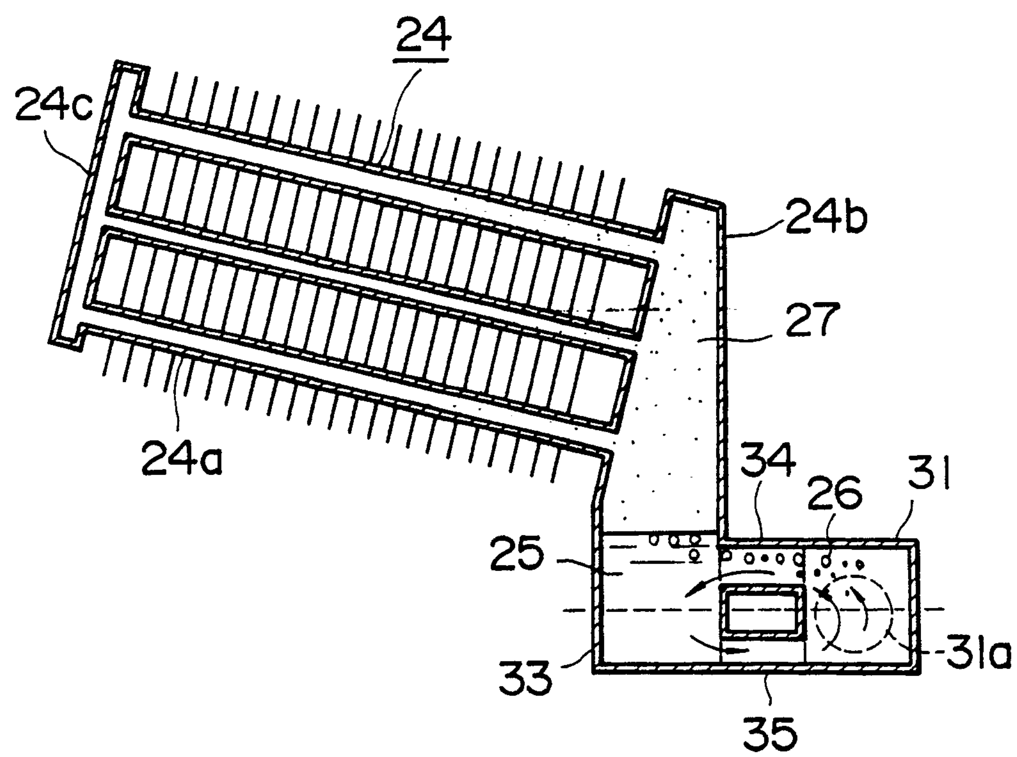

F I G. 11

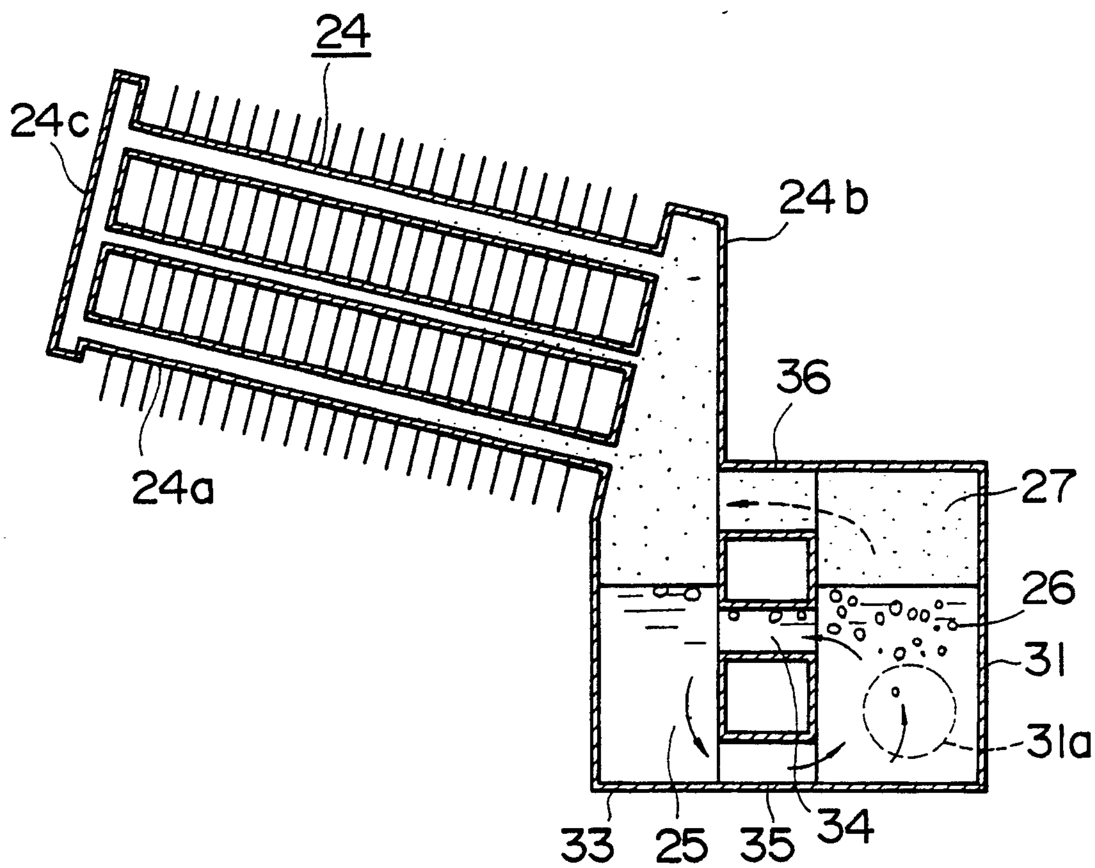

FIG. 12

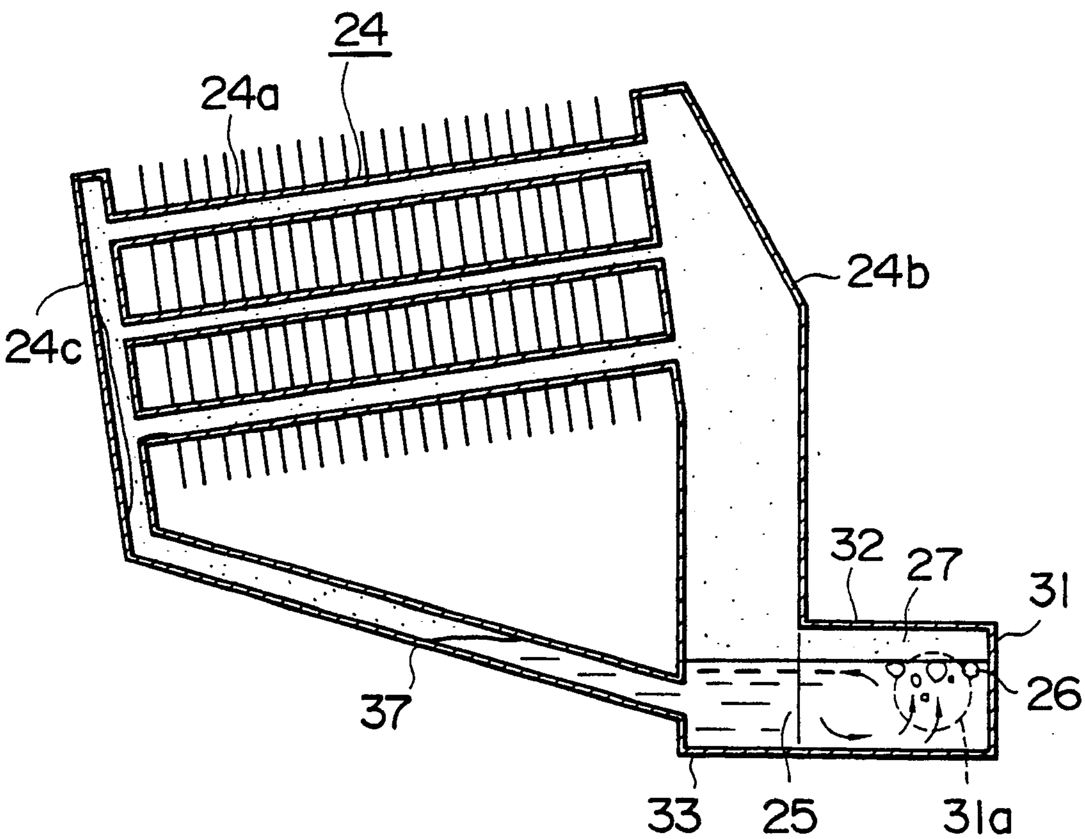

FIG. 13

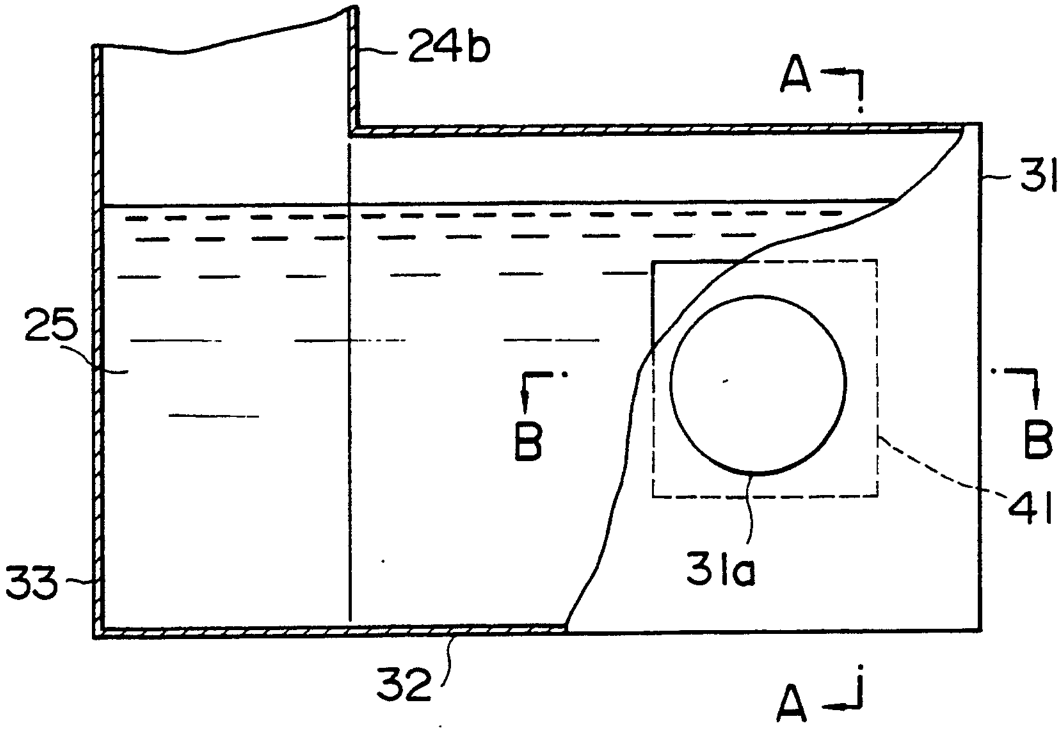


FIG. 14

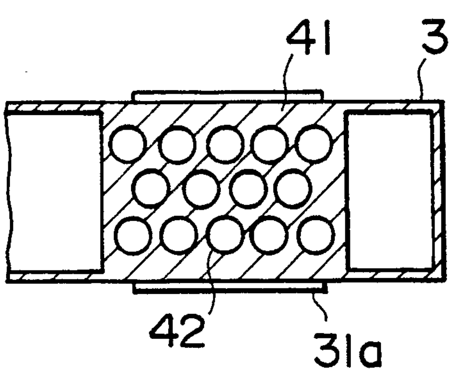


FIG. 15

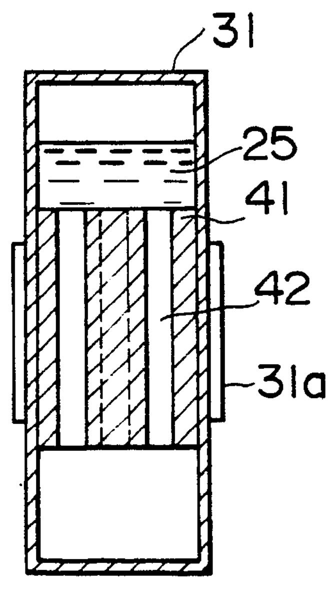

FIG. 16

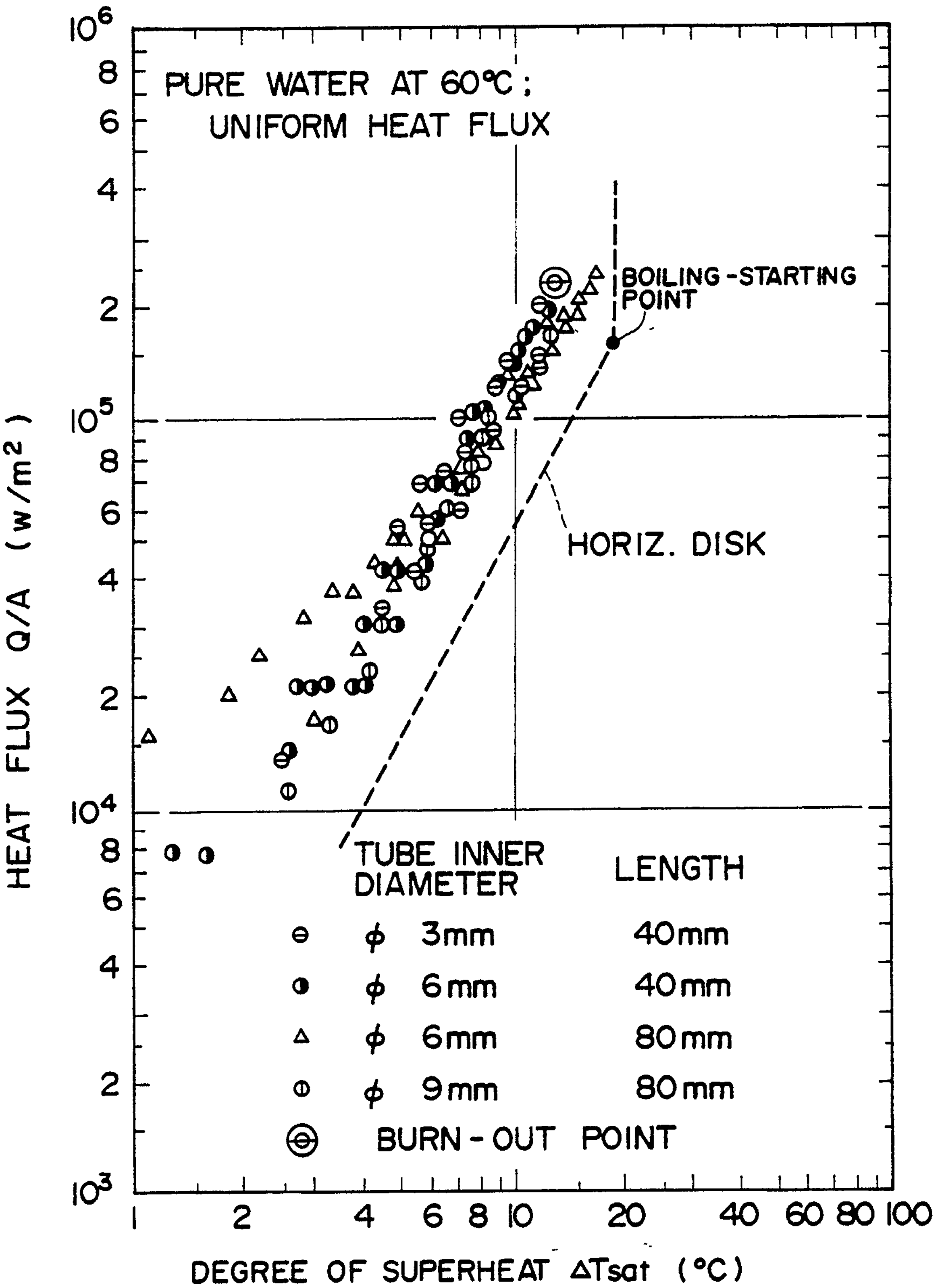
PURE WATER AT 60°C ;
UNIFORM HEAT FLUX
HEAT FLUX Q/A (w/m²)
10⁶
8
6
4
2
10⁵
10⁴
10³
BOILING-STARTING POINT
HORIZ. DISK
TUBE INNER DIAMETER
LENGTH
φ 3mm 40mm
φ 6mm 40mm
φ 6mm 80mm
φ 9mm 80mm
BURN-OUT POINT
1
2
4
6
8
10
20
40
60
80
100
DEGREE OF SUPERHEAT ΔTsat (°C)

F I G. 17

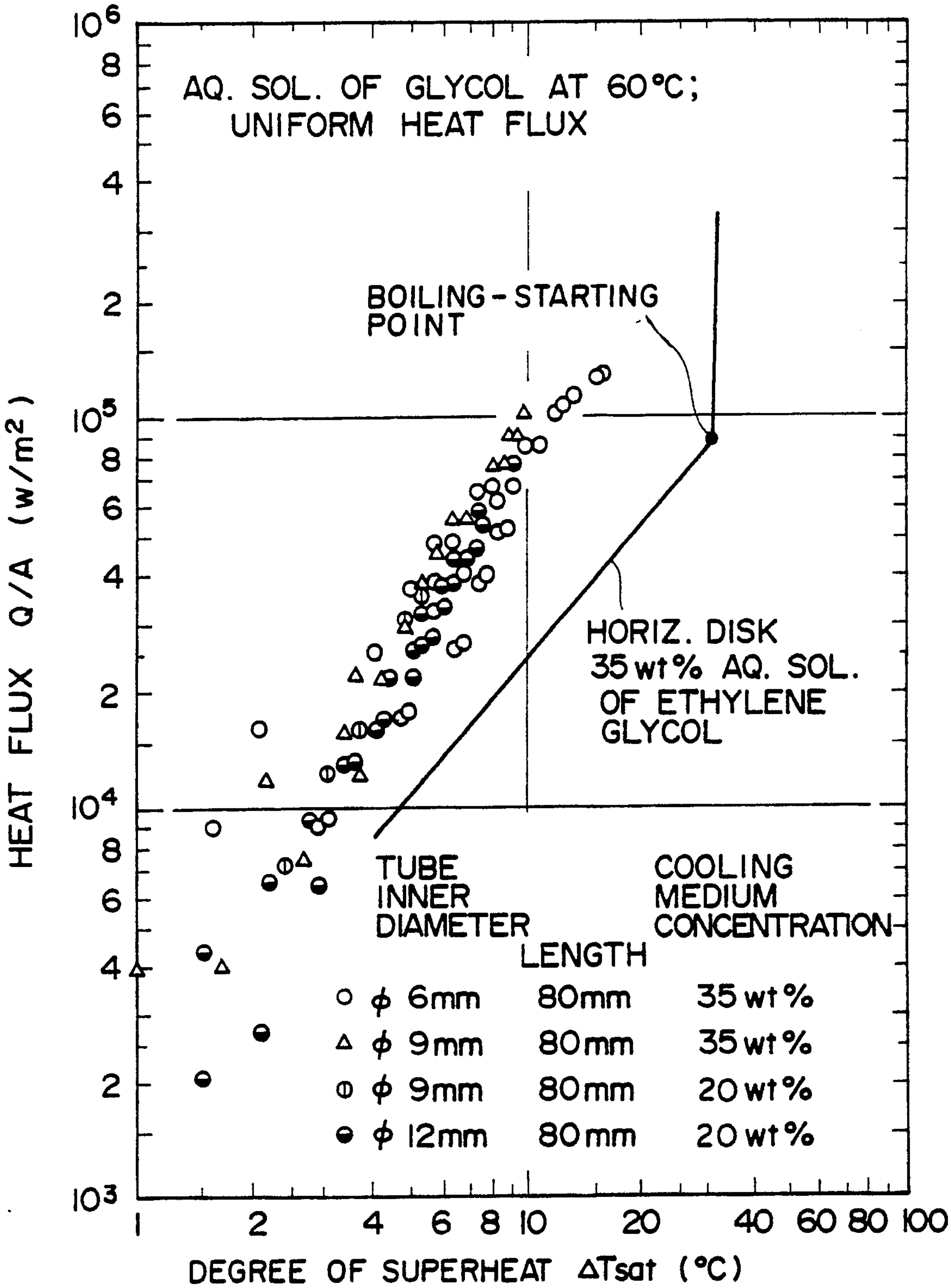
AQ. SOL. OF GLYCOL AT 60°C;
UNIFORM HEAT FLUX
BOILING-STARTING POINT
HORIZ. DISK
35 wt% AQ. SOL. OF ETHYLENE GLYCOL
TUBE INNER DIAMETER
LENGTH
COOLING MEDIUM CONCENTRATION
○ φ 6mm 80mm 35 wt%
△ φ 9mm 80mm 35 wt%
⦶ φ 9mm 80mm 20 wt%
◒ φ 12mm 80mm 20 wt%
HEAT FLUX Q/A (w/m²)
10⁶
8
6
4
2
10⁵
8
6
4
2
10⁴
8
6
4
2
10³
1
2
4
6
8
10
20
40
60
80
100
DEGREE OF SUPERHEAT ΔTsat (°C)

FIG. 18

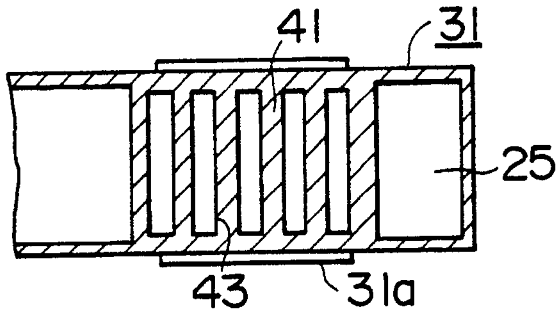


FIG. 19

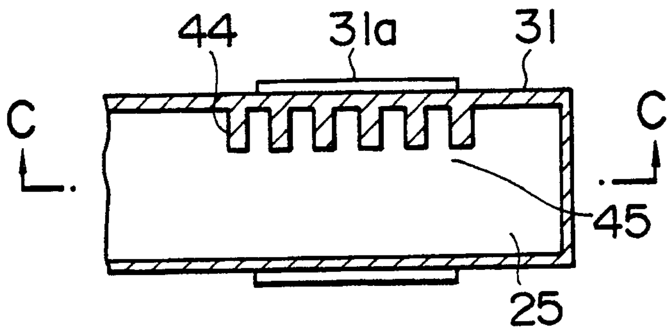


FIG. 20

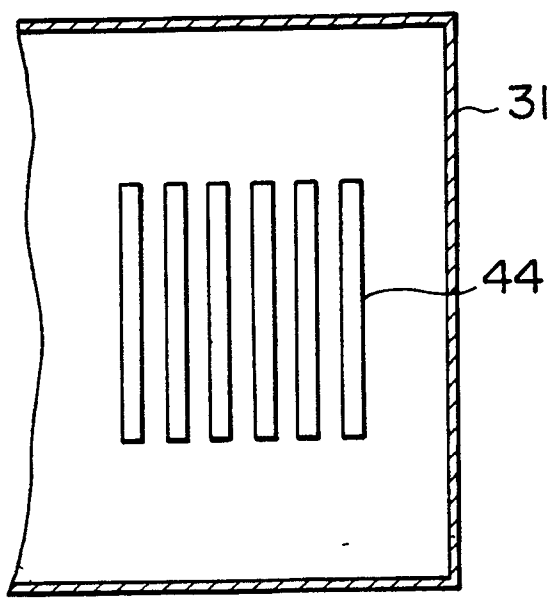

F I G. 21

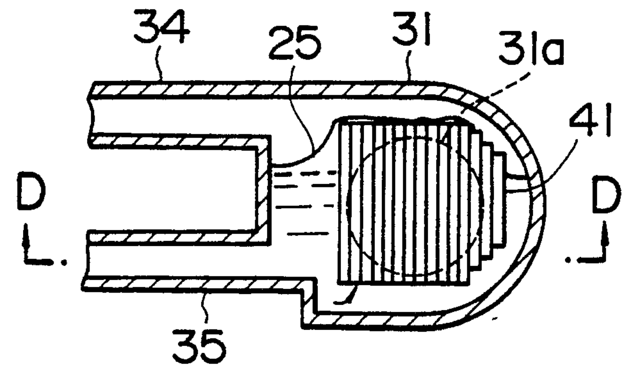


F I G. 22

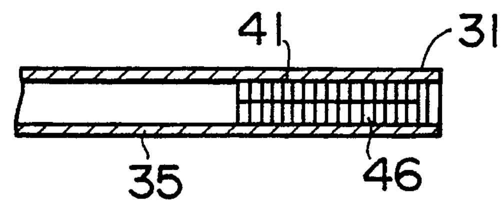


F I G. 23

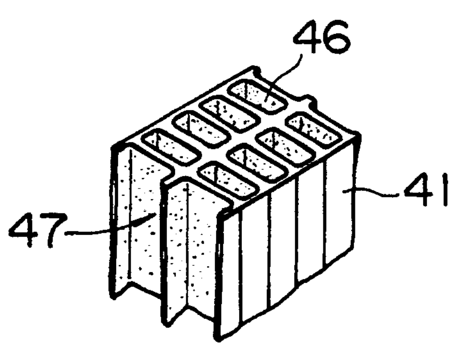

FIG. 24

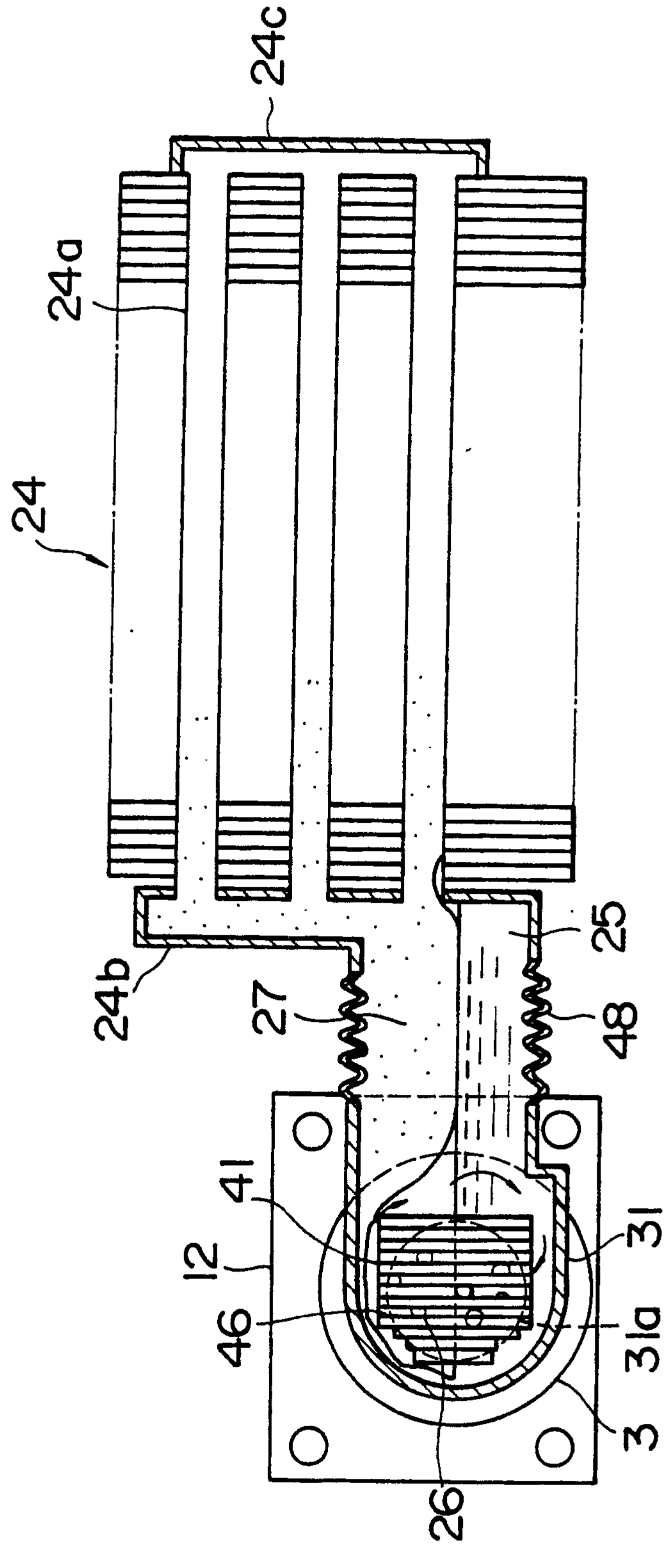

FIG. 25

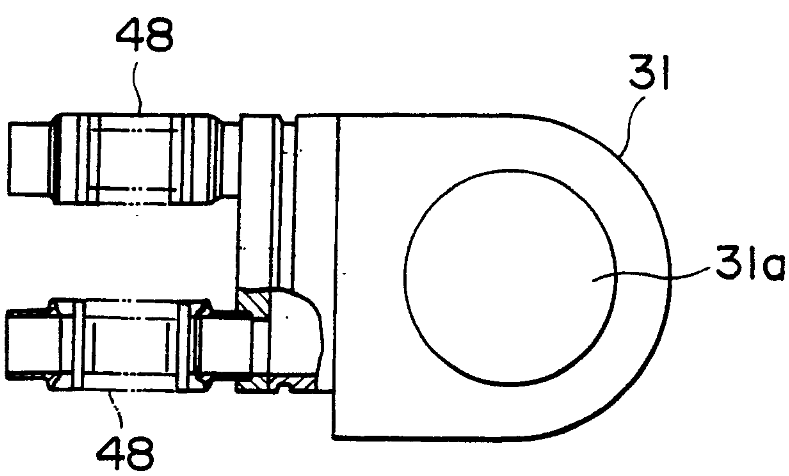

FIG. 26

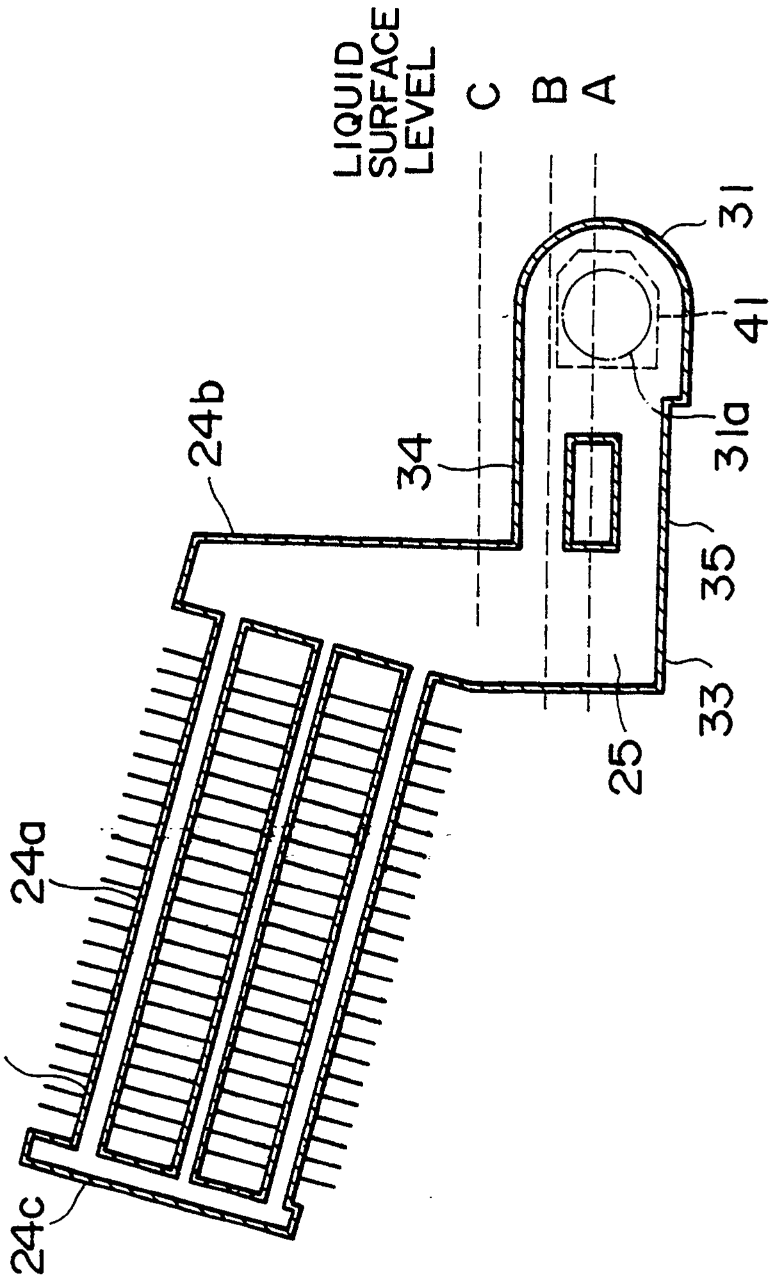

# F I G. 27

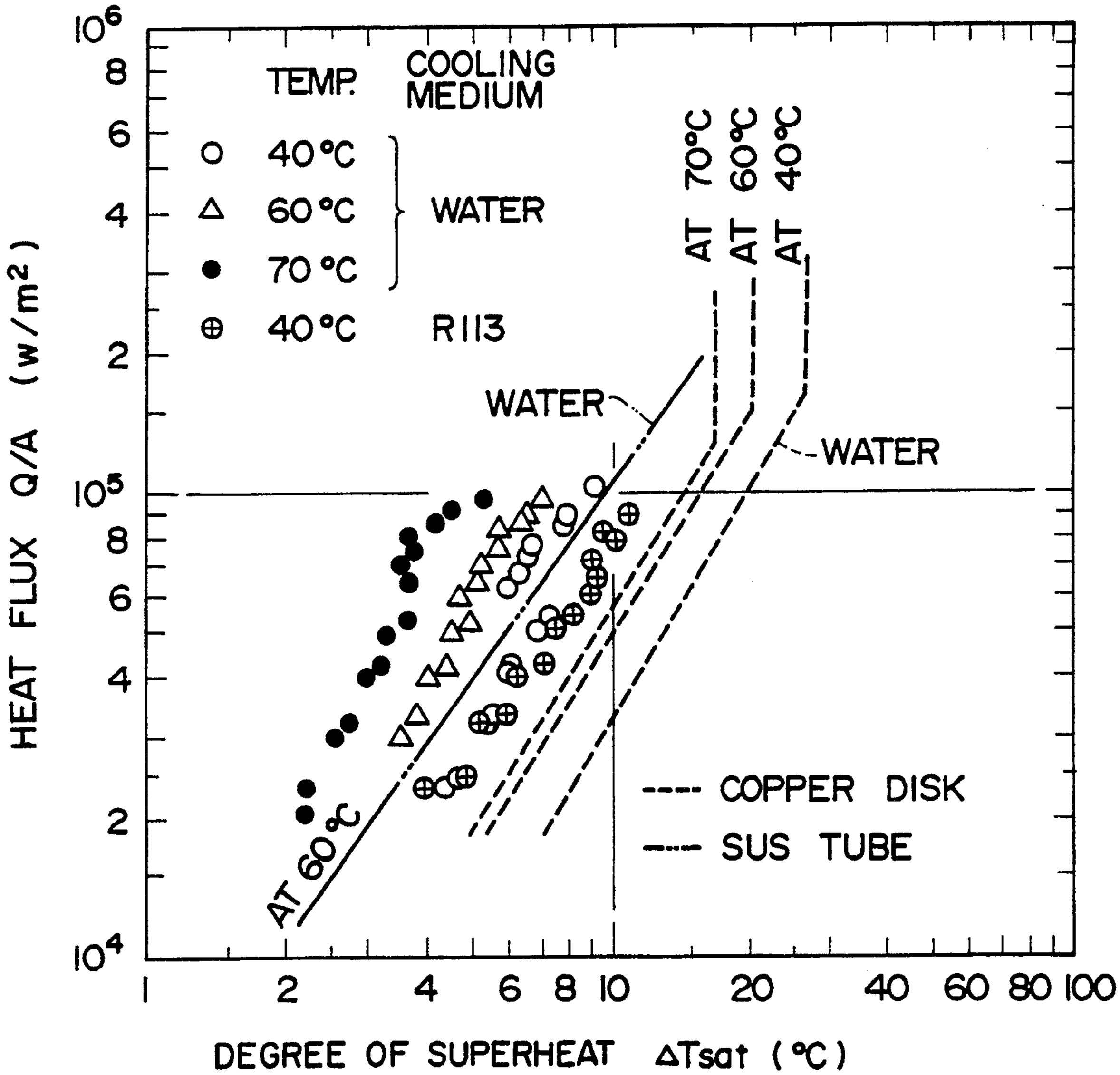
TEMP.
COOLING MEDIUM
40°C
60°C
70°C
WATER
40°C
R113
WATER
AT 70°C
AT 60°C
AT 40°C
WATER
AT 60°C
COPPER DISK
SUS TUBE
HEAT FLUX Q/A (w/m²)
DEGREE OF SUPERHEAT ΔTsat (°C)
10⁶
8
6
4
2
10⁵
8
6
4
2
10⁴
1
2
4
6
8
10
20
40
60
80
100

# FIG. 28

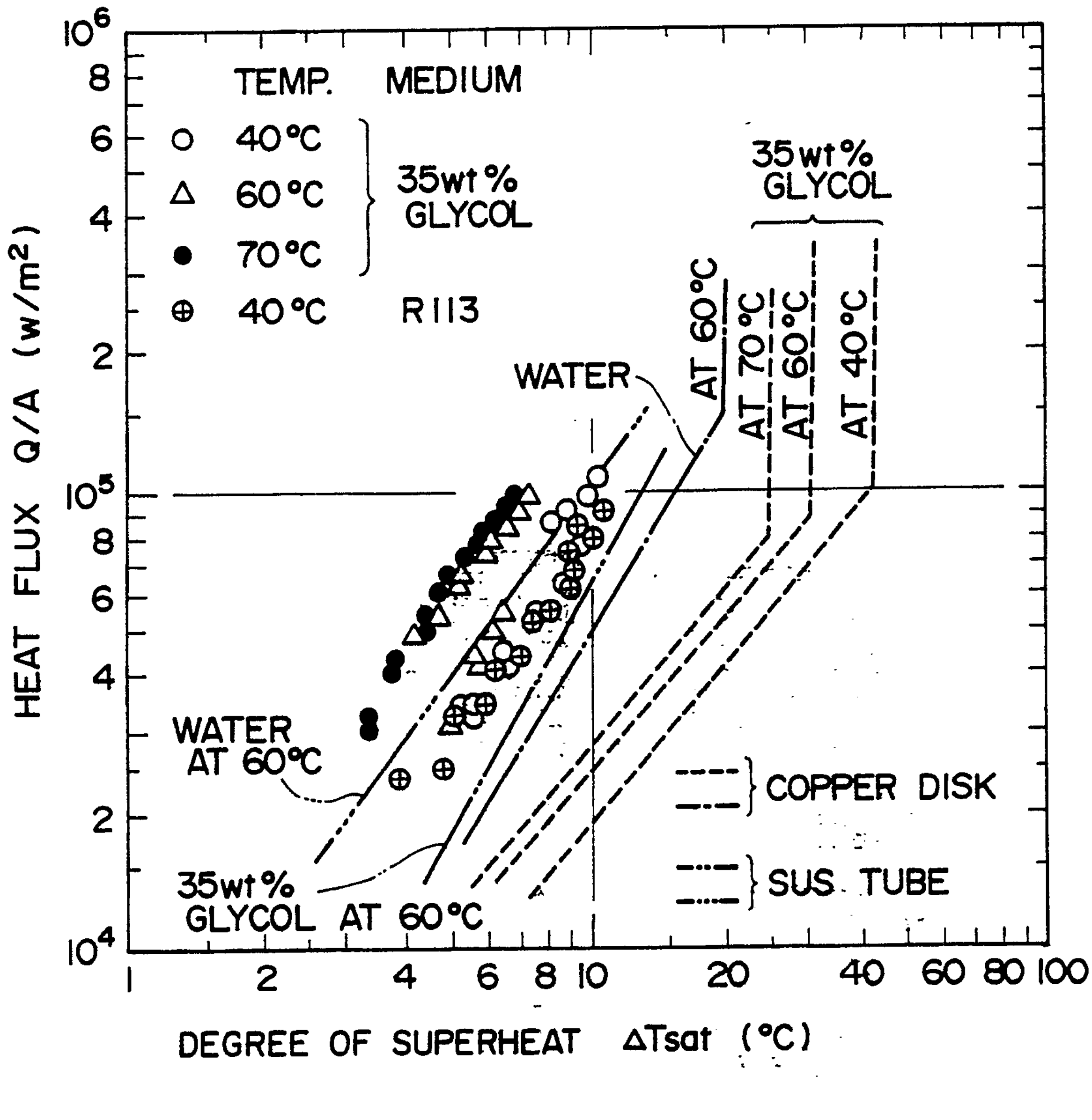
TEMP. MEDIUM
○ 40°C
△ 60°C
● 70°C
35wt% GLYCOL
⊕ 40°C R113
35wt% GLYCOL
AT 60°C
AT 70°C
AT 60°C
AT 40°C
WATER
WATER AT 60°C
35wt% GLYCOL AT 60°C
COPPER DISK
SUS TUBE
HEAT FLUX Q/A (w/m²)
DEGREE OF SUPERHEAT ΔTsat (°C)
10⁶
8
6
4
2
10⁵
8
6
4
2
10⁴
1
2
4
6
8
10
20
40
60
80
100

F I G. 29

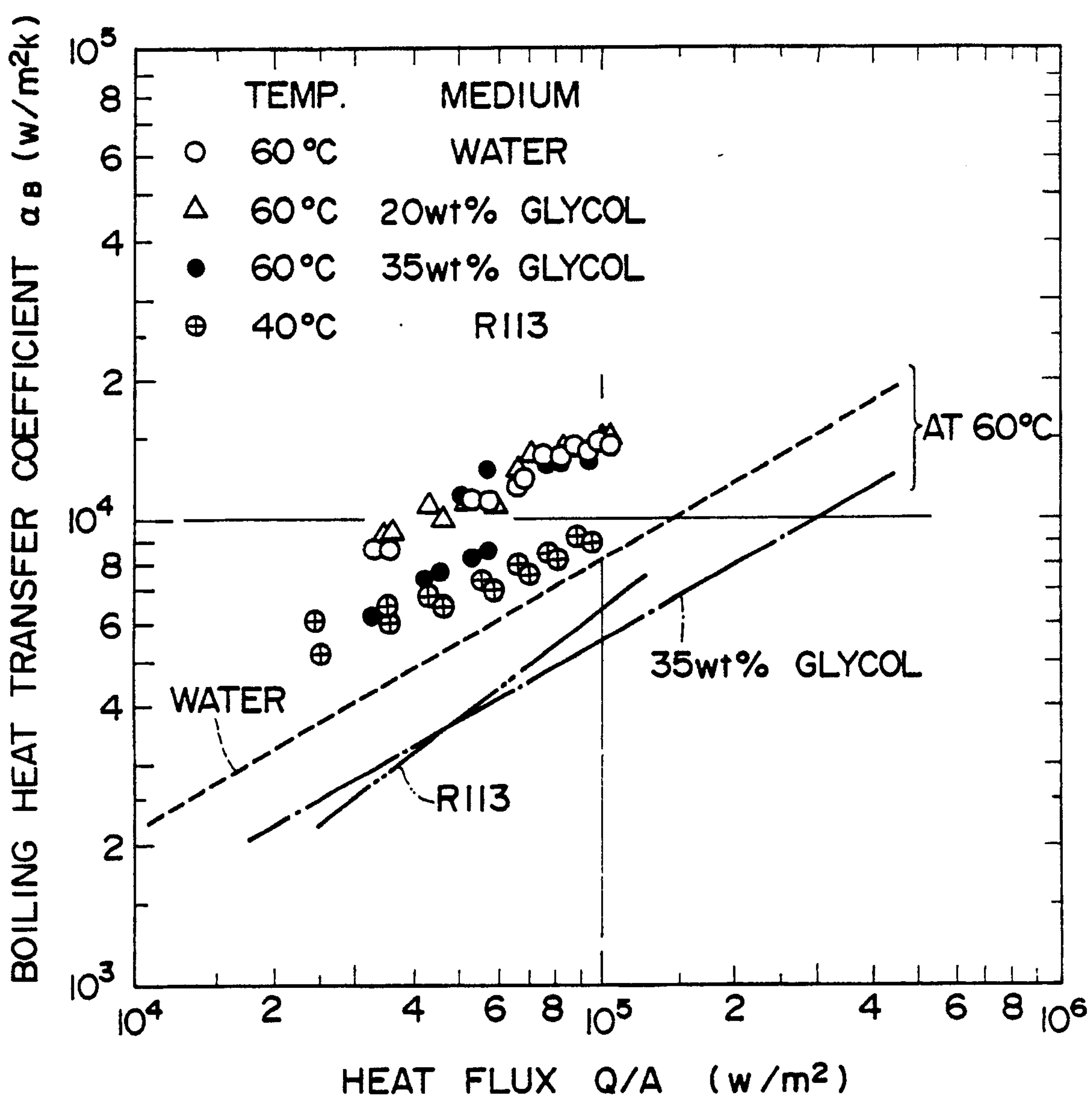
BOILING HEAT TRANSFER COEFFICIENT αB (w/m²k)
HEAT FLUX Q/A (w/m²)
TEMP. MEDIUM
60 °C WATER
60 °C 20wt% GLYCOL
60 °C 35wt% GLYCOL
40 °C R113
AT 60°C
WATER
35wt% GLYCOL
R113
10^5
8
6
4
2
10^4
8
6
4
2
10^3
10^4
2
4
6
8
10^5
2
4
6
8
10^6

FIG. 30

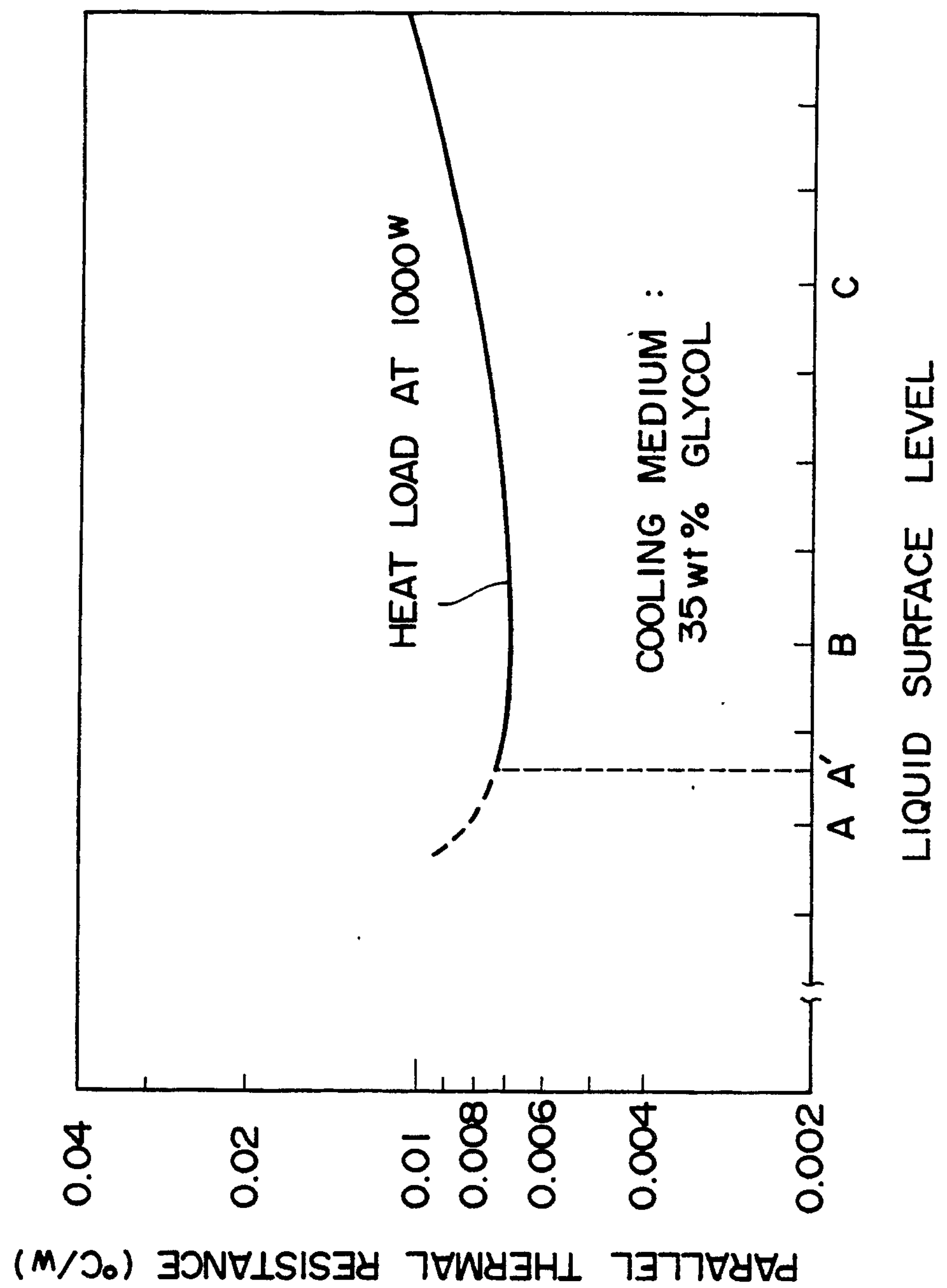
HEAT LOAD AT 1000W
COOLING MEDIUM :
35 wt % GLYCOL
PARALLEL THERMAL RESISTANCE (°C/W)
0.04
0.02
0.01
0.008
0.006
0.004
0.002
A
A'
B
C
LIQUID SURFACE LEVEL

FIG. 31

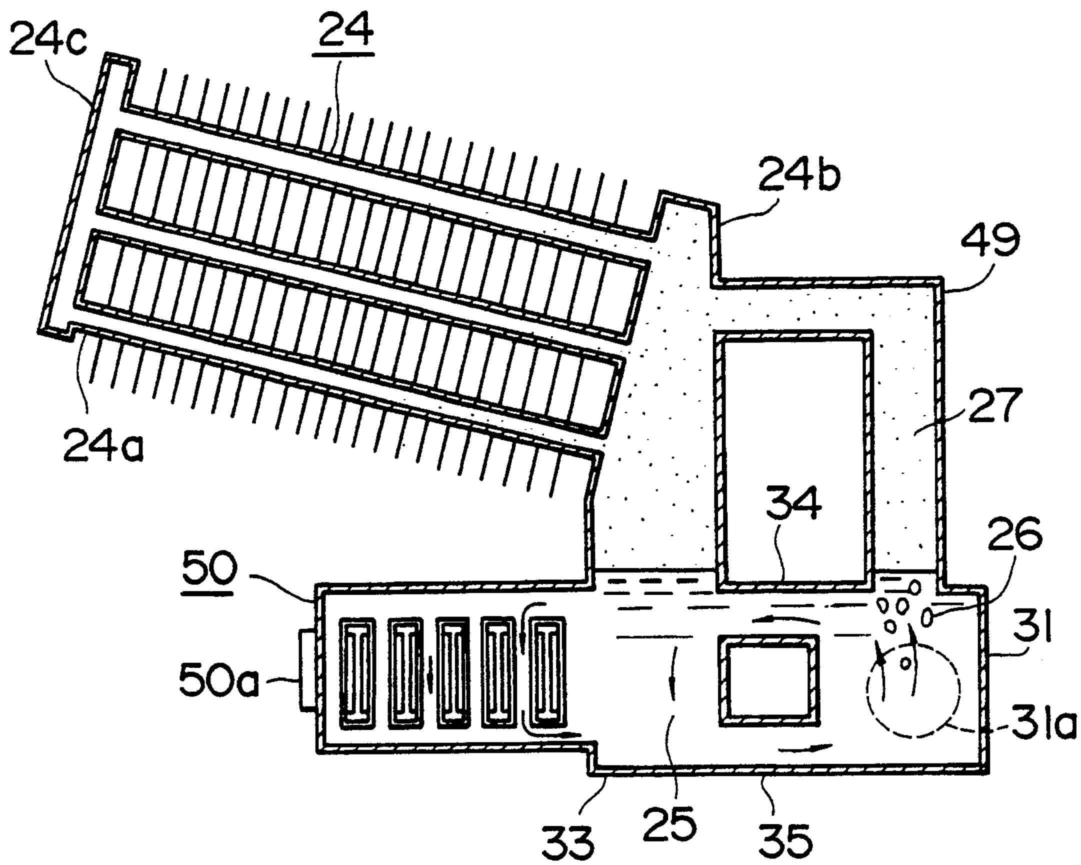

FIG. 32

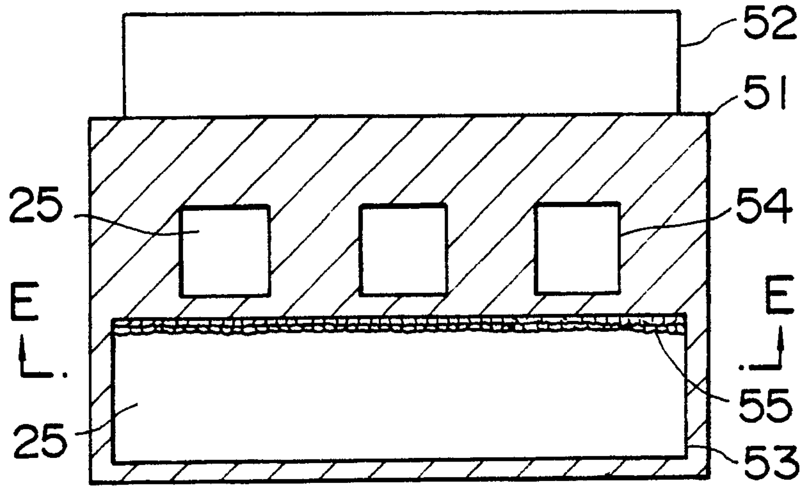


FIG. 33

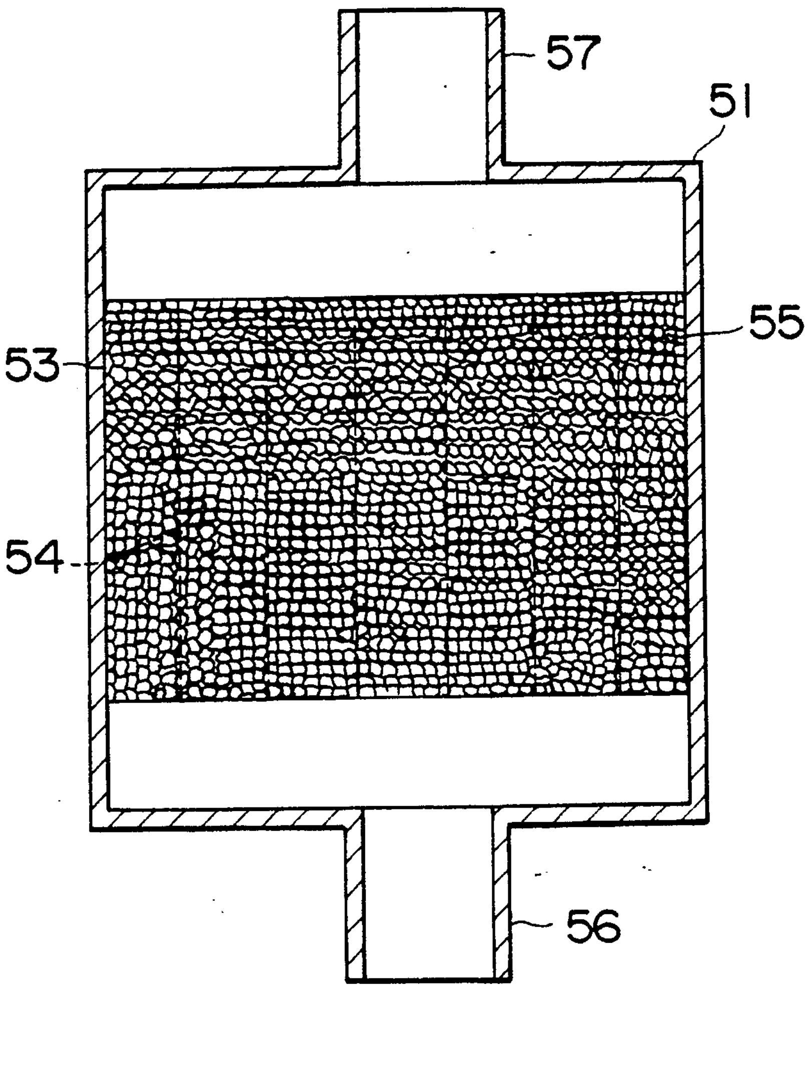

# FIG. 34

BOILING CURVES

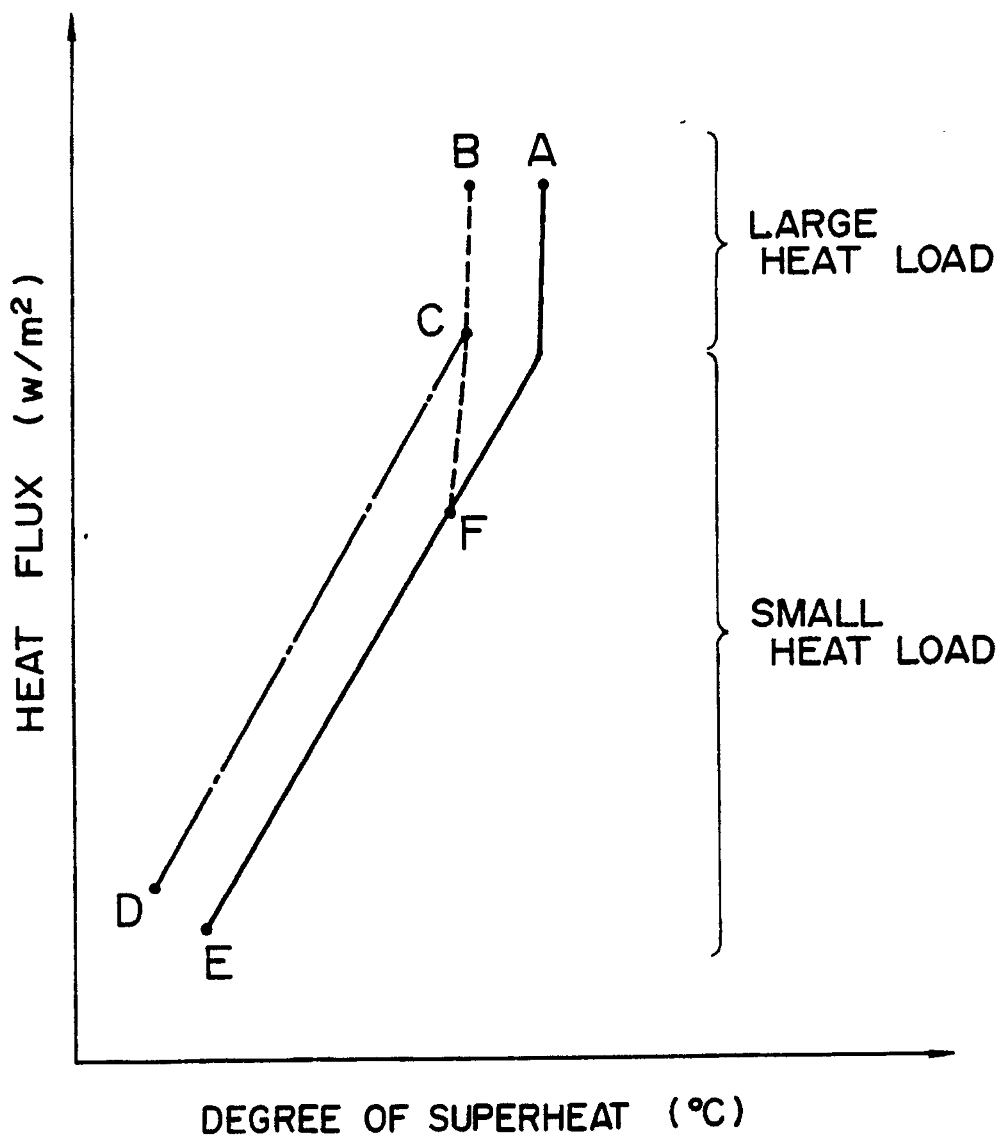

FIG. 35

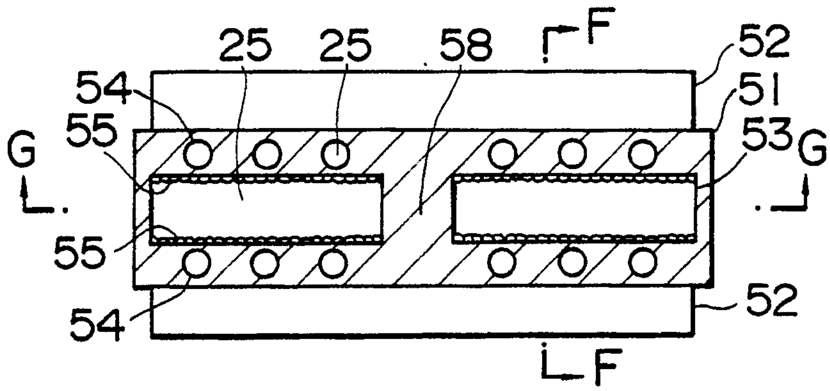


FIG. 36

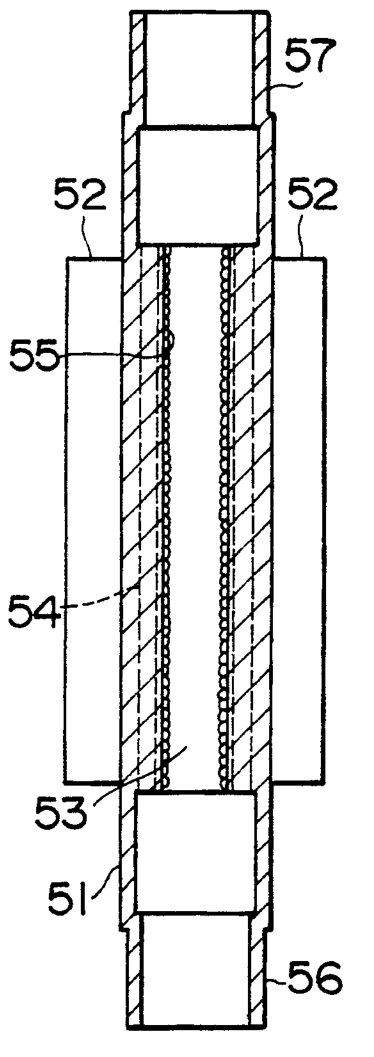


FIG. 37

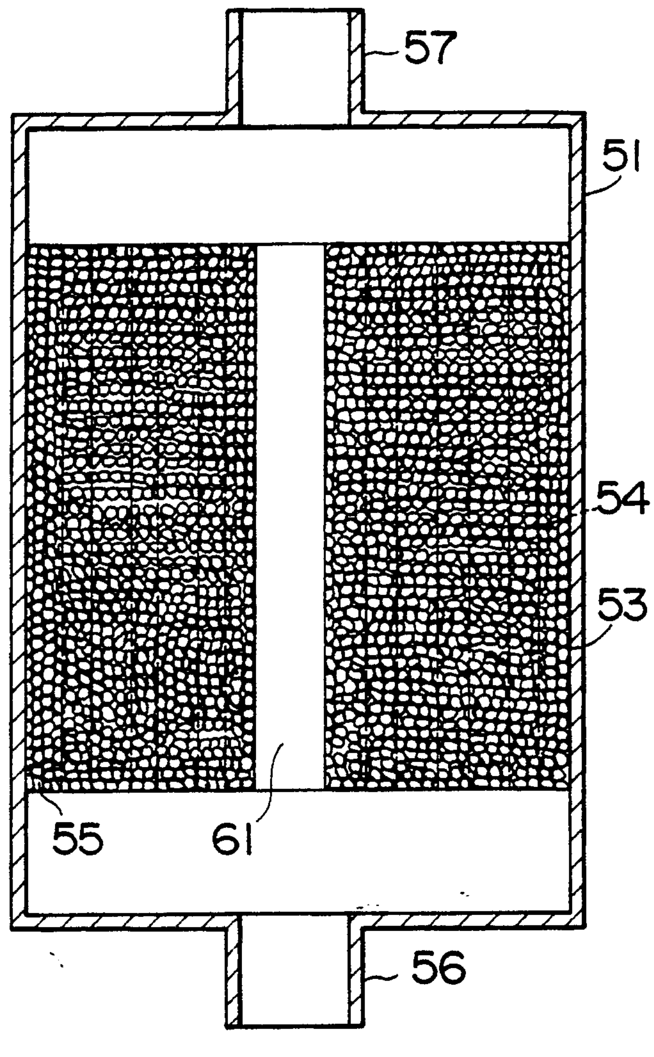

FIG. 38

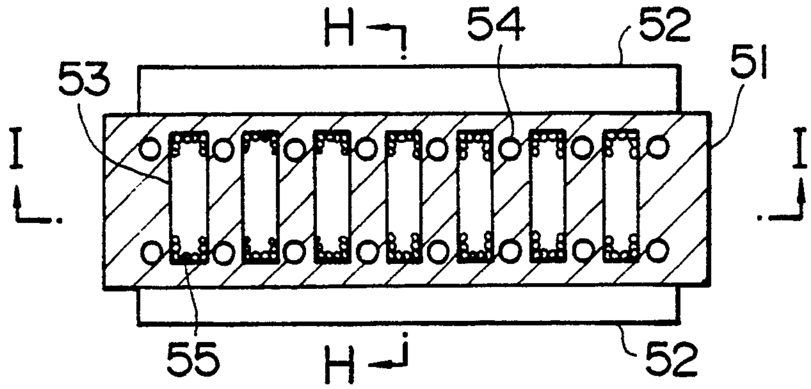


FIG. 39

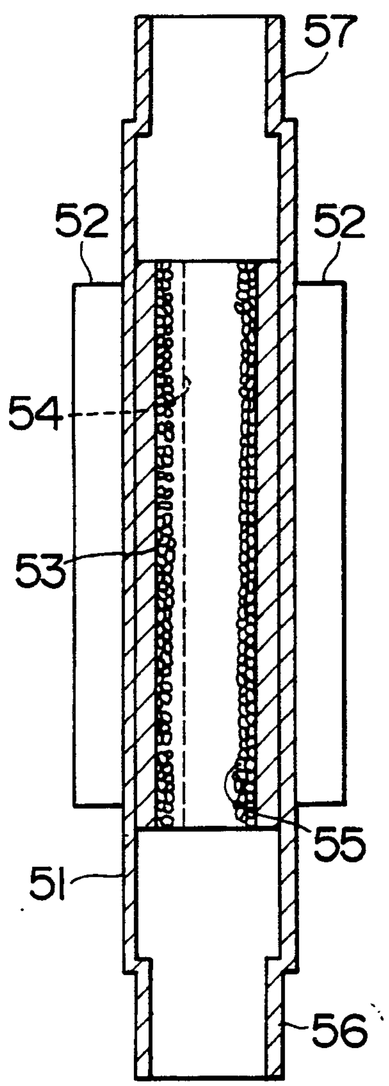


FIG. 40

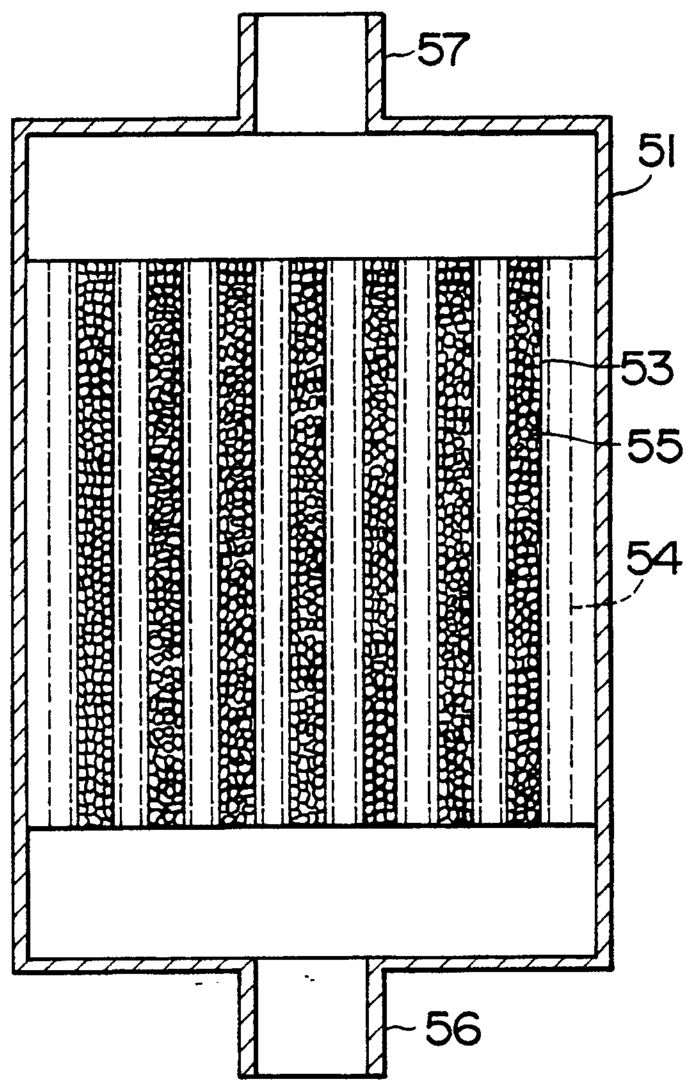

F I G. 41

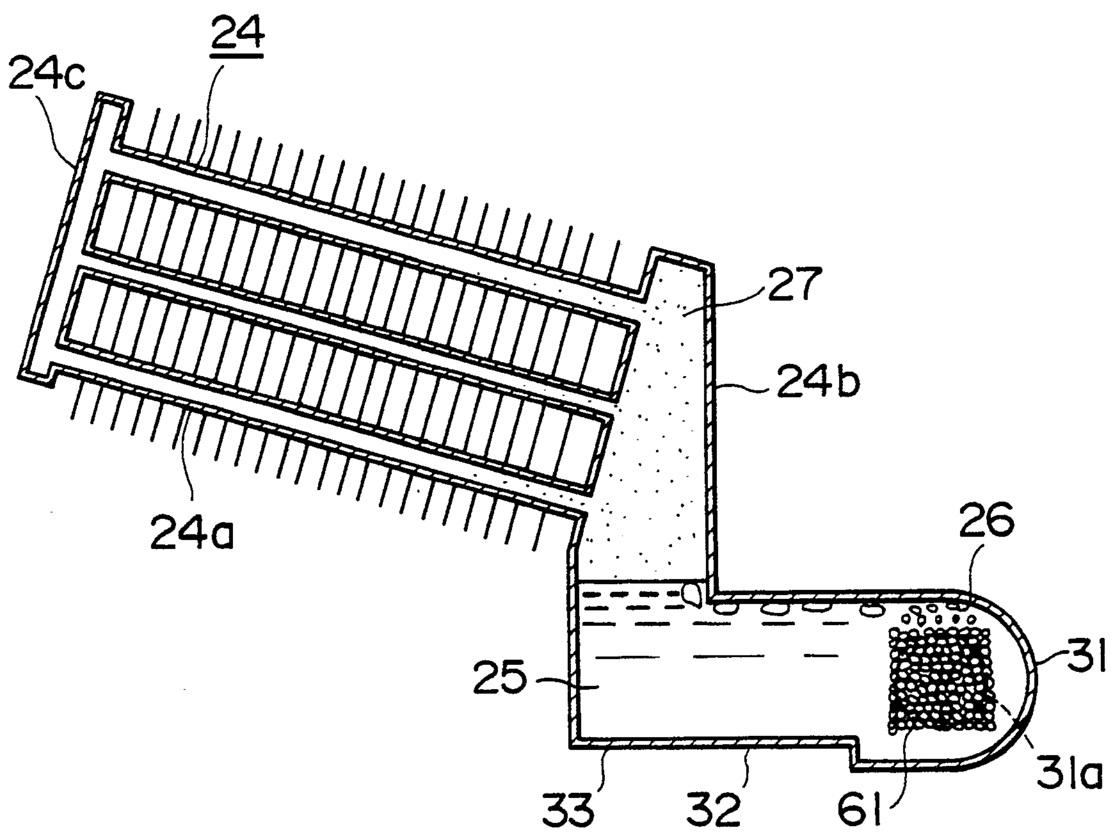

FIG. 42

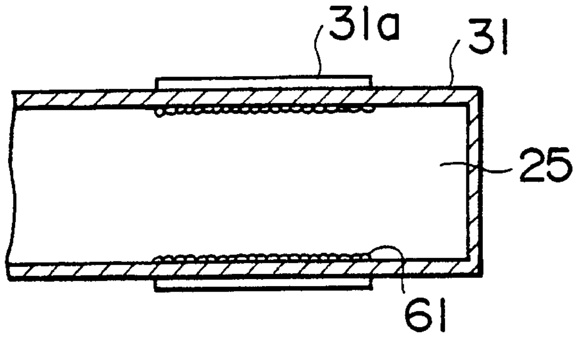


FIG. 43

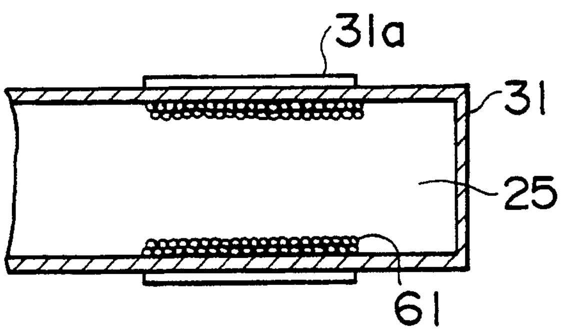


FIG. 44

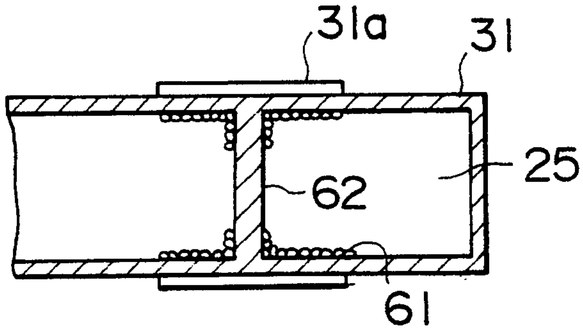

# FIG. 45

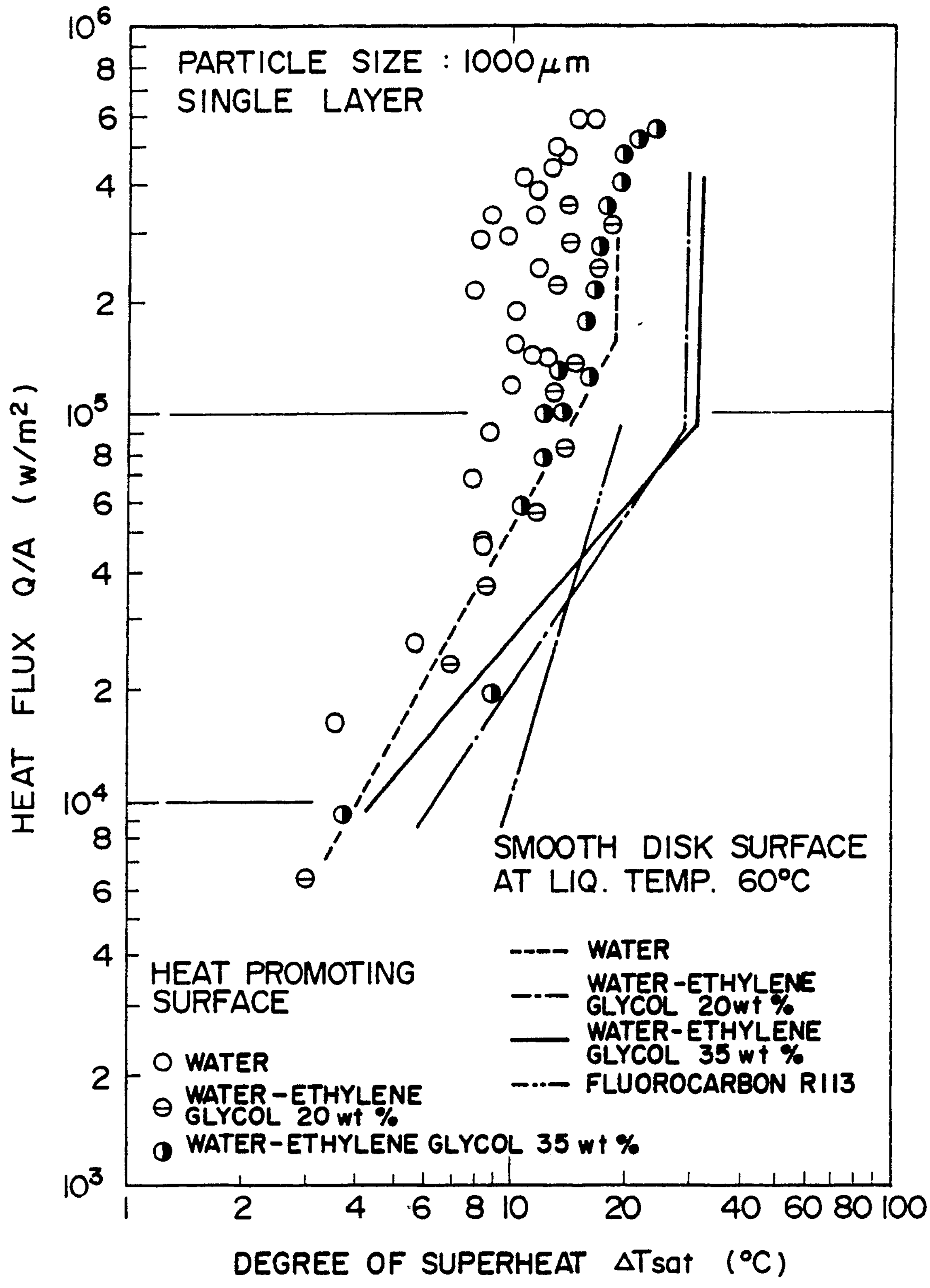
PARTICLE SIZE : 1000μm
SINGLE LAYER
HEAT FLUX Q/A (w/m²)
10⁶
8
6
4
2
10⁵
10⁴
10³
SMOOTH DISK SURFACE
AT LIQ. TEMP. 60°C
WATER
WATER-ETHYLENE GLYCOL 20wt %
WATER-ETHYLENE GLYCOL 35 wt %
FLUOROCARBON R113
HEAT PROMOTING SURFACE
WATER
WATER-ETHYLENE GLYCOL 20 wt %
WATER-ETHYLENE GLYCOL 35 wt %
1
2
4
6
8
10
20
40
60
80
100
DEGREE OF SUPERHEAT ΔTsat (°C)

# F I G. 46

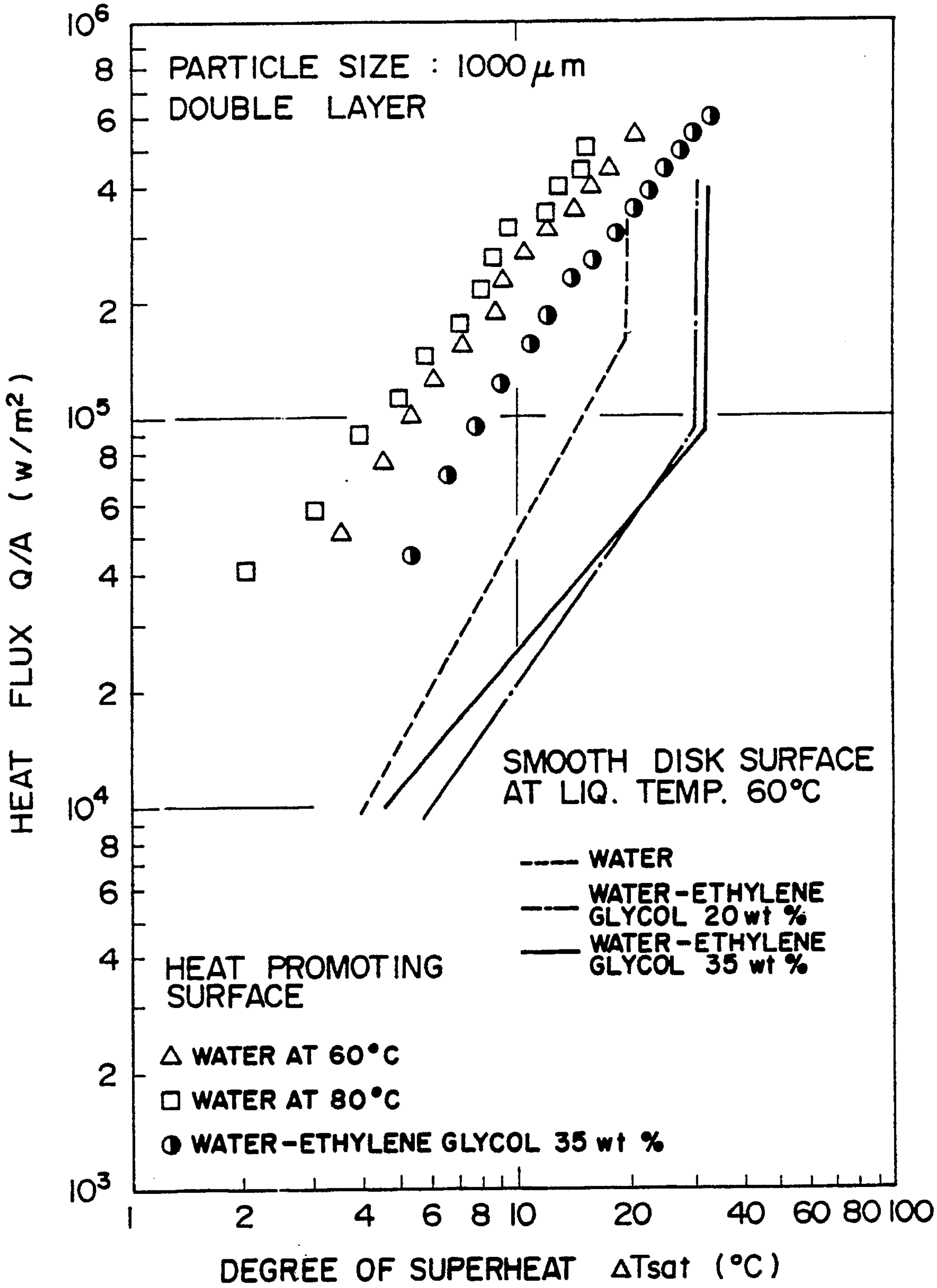
PARTICLE SIZE : 1000 μm
DOUBLE LAYER
SMOOTH DISK SURFACE
AT LIQ. TEMP. 60°C
WATER
WATER-ETHYLENE GLYCOL 20 wt %
WATER-ETHYLENE GLYCOL 35 wt %
HEAT PROMOTING SURFACE
△ WATER AT 60°C
□ WATER AT 80°C
◐ WATER-ETHYLENE GLYCOL 35 wt %
HEAT FLUX Q/A (w/m²)
DEGREE OF SUPERHEAT ΔTsat (°C)
10⁶
10⁵
10⁴
10³
1 2 4 6 8 10 20 40 60 80 100

# FIG. 47

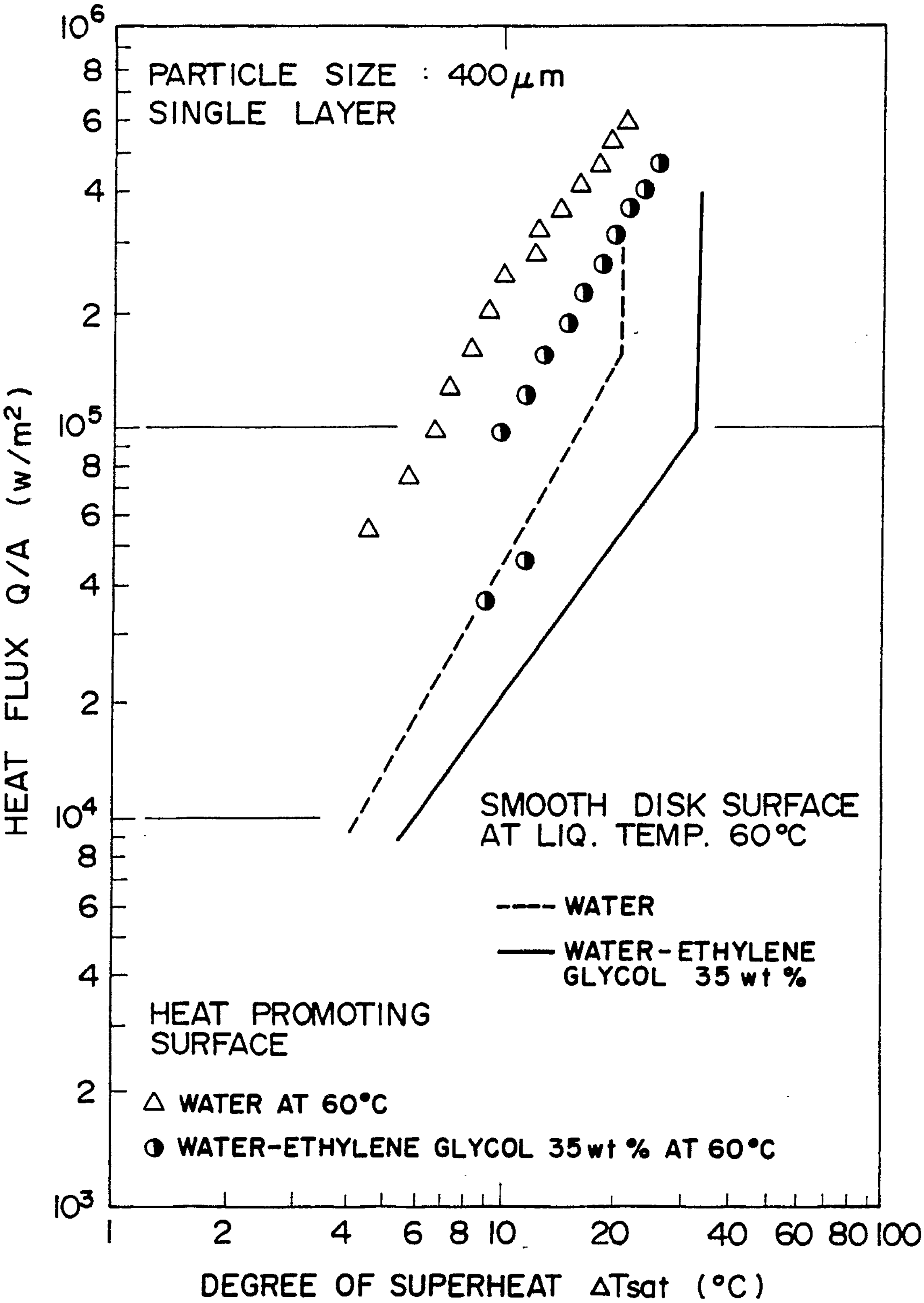
PARTICLE SIZE : 400μm
SINGLE LAYER
SMOOTH DISK SURFACE
AT LIQ. TEMP. 60°C
---- WATER
—— WATER-ETHYLENE GLYCOL 35 wt %
HEAT PROMOTING SURFACE
△ WATER AT 60°C
◑ WATER-ETHYLENE GLYCOL 35wt % AT 60°C
HEAT FLUX Q/A (w/m2)
DEGREE OF SUPERHEAT ΔTsat (°C)
10^6
8
6
4
2
10^5
8
6
4
2
10^4
8
6
4
2
10^3
1
2
4
6
8
10
20
40
60
80
100

# F I G. 48

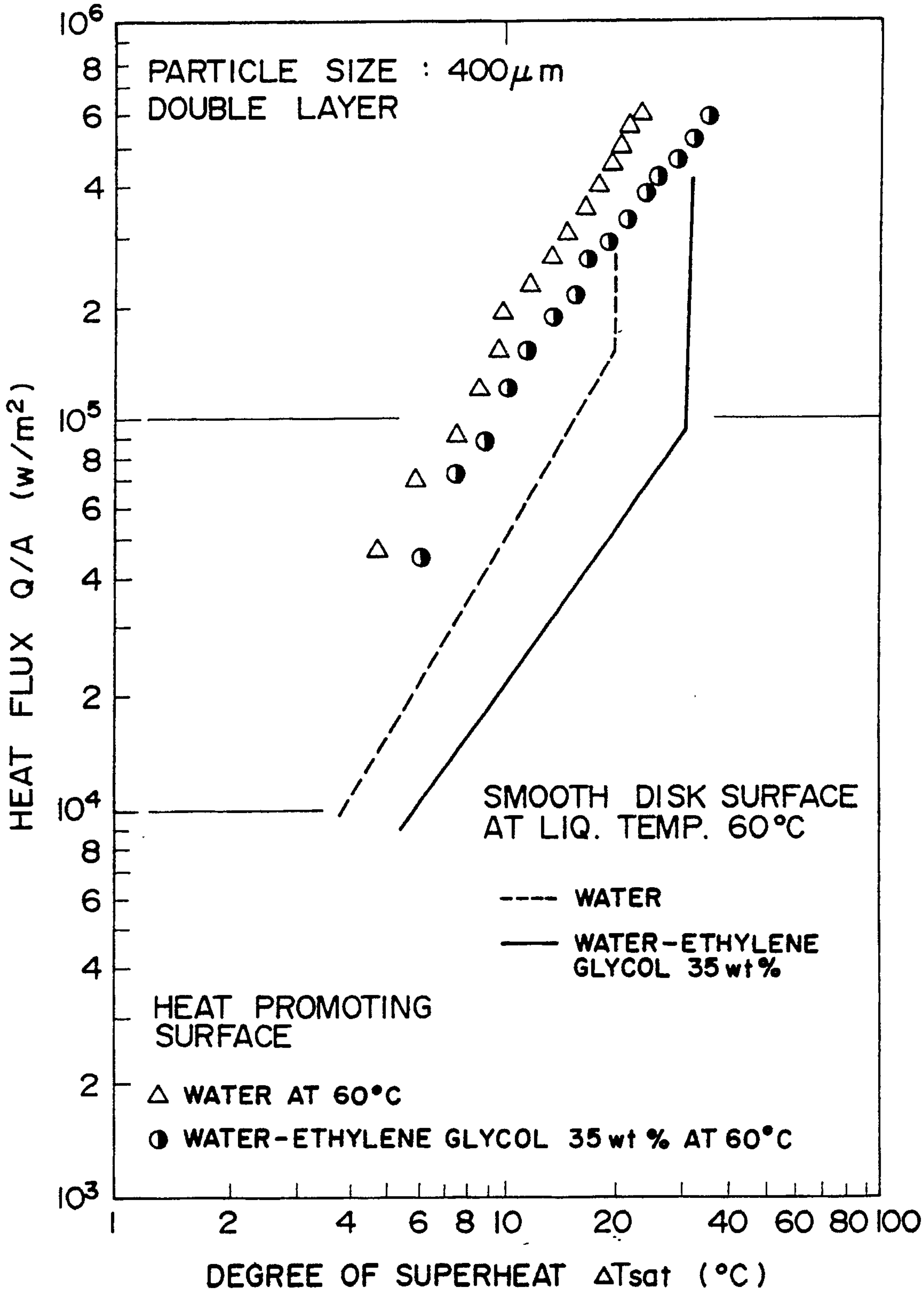
PARTICLE SIZE : 400μm
DOUBLE LAYER
SMOOTH DISK SURFACE
AT LIQ. TEMP. 60°C
WATER
WATER-ETHYLENE GLYCOL 35wt%
HEAT PROMOTING SURFACE
△ WATER AT 60°C
◑ WATER-ETHYLENE GLYCOL 35wt % AT 60°C
HEAT FLUX Q/A (w/m²)
DEGREE OF SUPERHEAT ΔTsat (°C)
10³
2
4
6
8
10⁴
2
4
6
8
10⁵
2
4
6
8
10⁶
1
2
4
6
8
10
20
40
60
80
100

FIG. 49

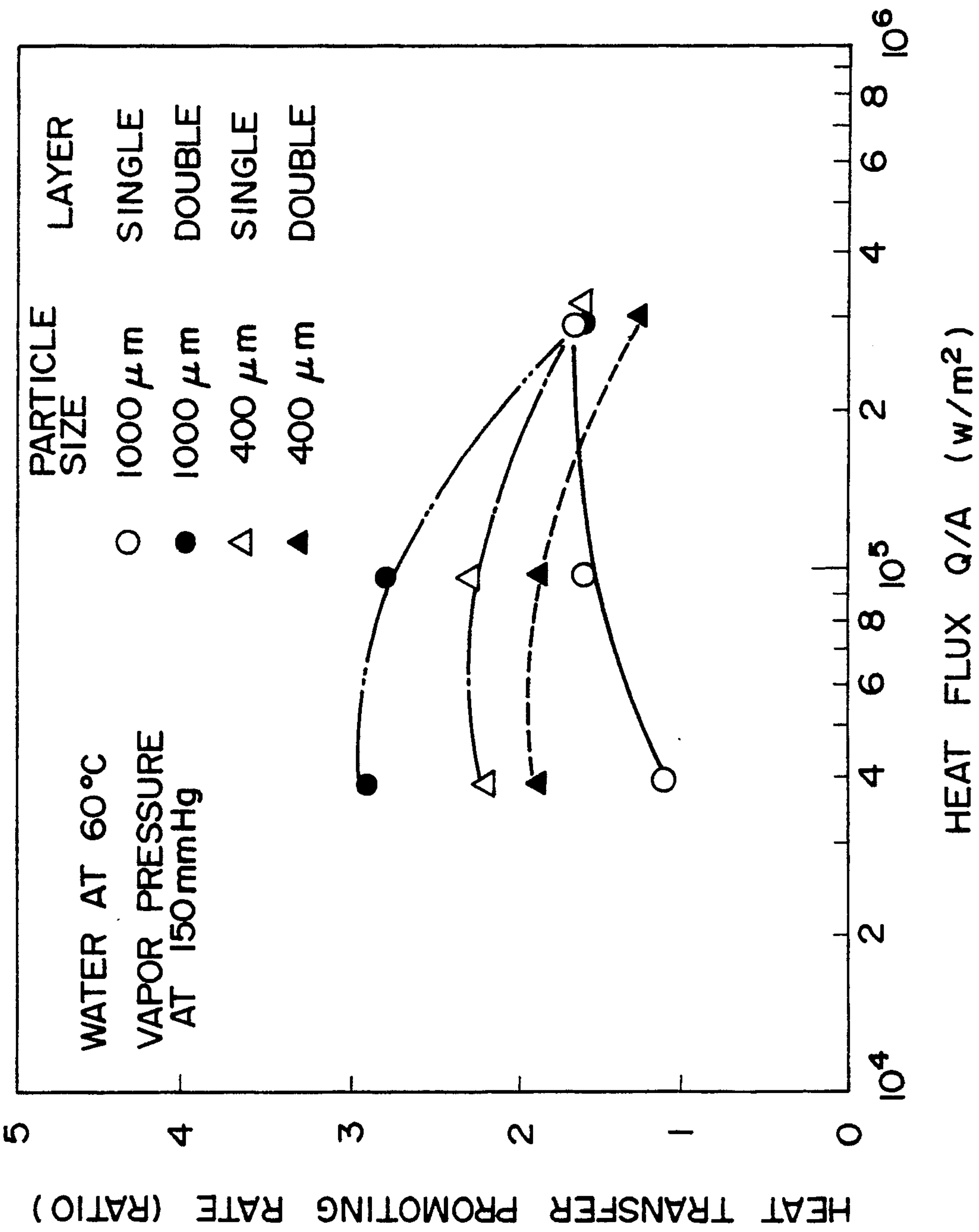
WATER AT 60°C
VAPOR PRESSURE AT 150mmHg
PARTICLE SIZE
LAYER
1000 μm SINGLE
1000 μm DOUBLE
400 μm SINGLE
400 μm DOUBLE
HEAT TRANSFER PROMOTING RATE (RATIO)
HEAT FLUX Q/A (w/m²)
0
1
2
3
4
5
10⁴
2
4
6
8
10⁵
2
4
6
8
10⁶

# FIG. 50

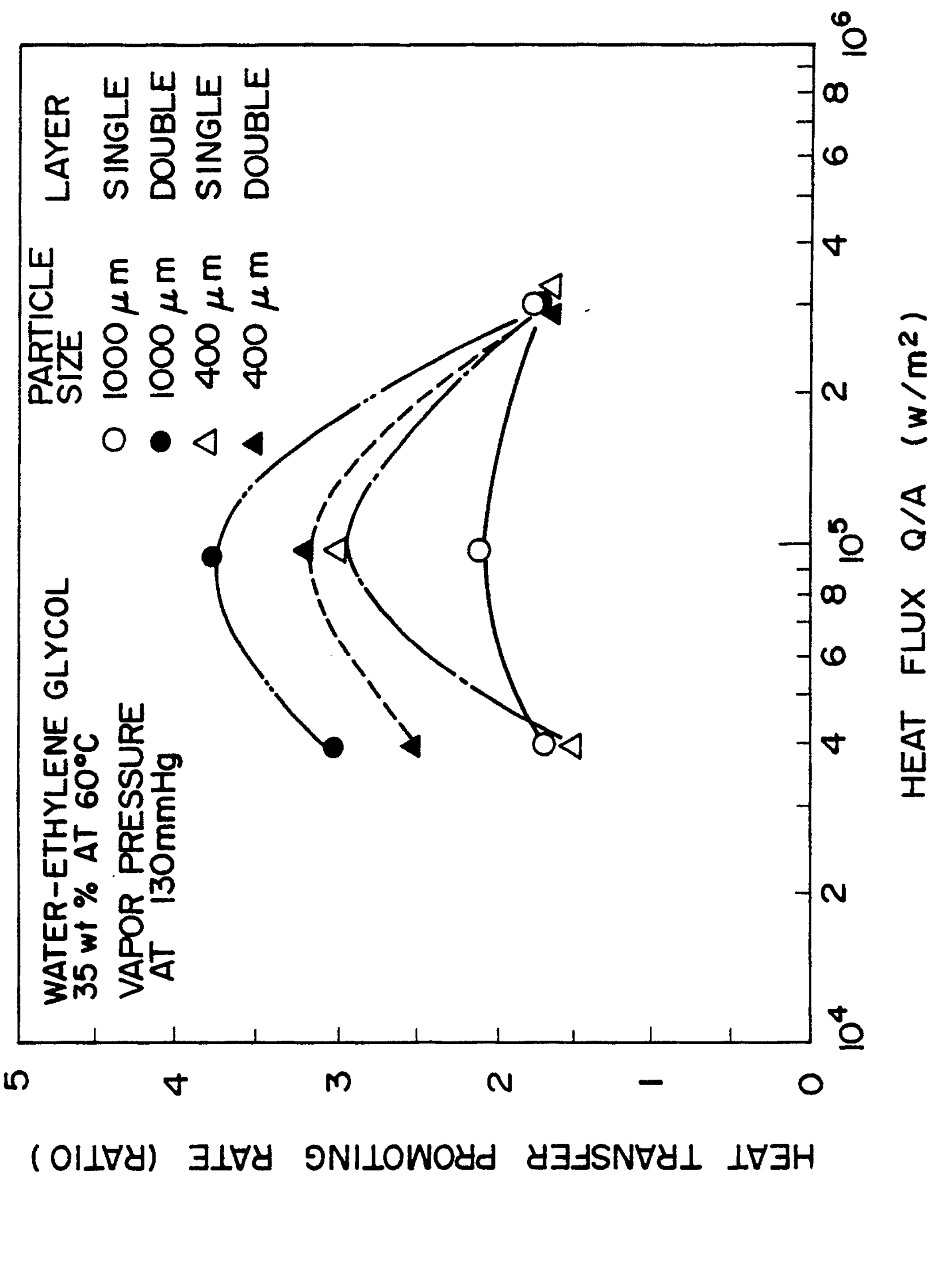
WATER-ETHYLENE GLYCOL
35 wt % AT 60°C
VAPOR PRESSURE
AT 130mmHg
PARTICLE SIZE
LAYER
1000 μm SINGLE
1000 μm DOUBLE
400 μm SINGLE
400 μm DOUBLE
HEAT TRANSFER PROMOTING RATE (RATIO)
0
1
2
3
4
5
HEAT FLUX Q/A (w/m²)
10⁴
2
4
6
8
10⁵
2
4
6
8
10⁶

FIG. 51

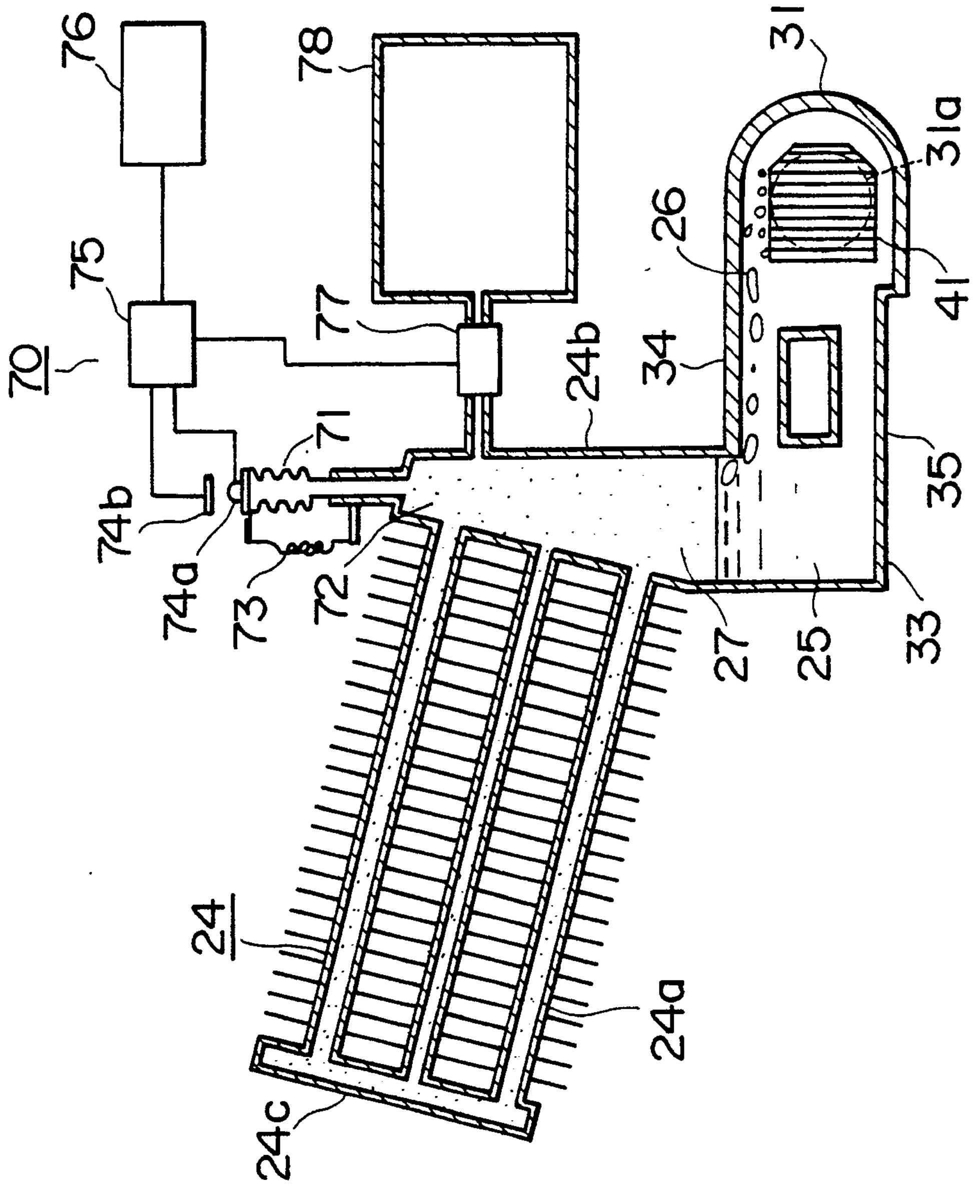
70
71
72
73
74a
74b
75
76
77
78
24
24a
24b
24c
25
26
27
31
31a
33
34
35
41

# F I G. 52

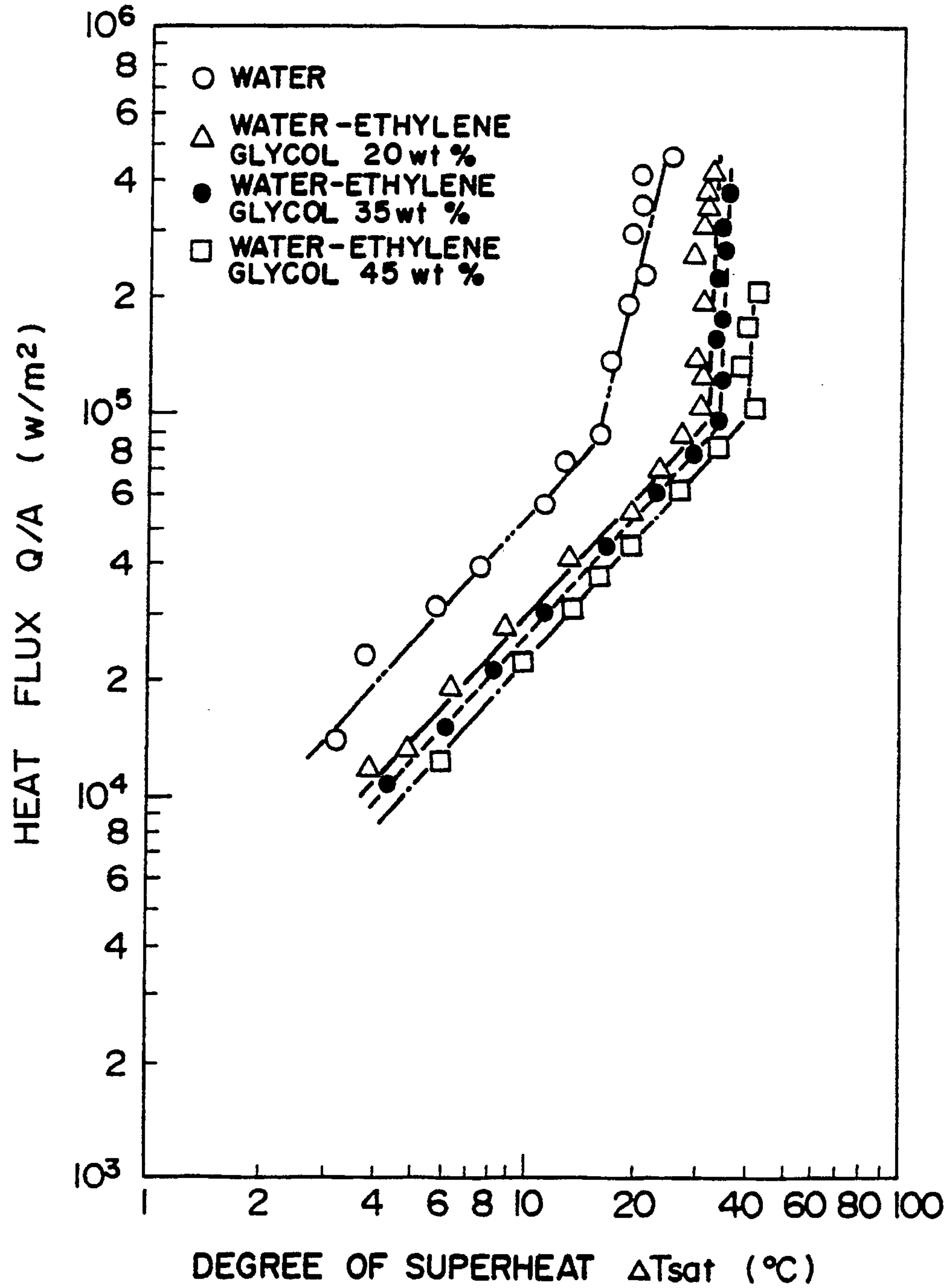

WATER
WATER-ETHYLENE GLYCOL 20 wt %
WATER-ETHYLENE GLYCOL 35 wt %
WATER-ETHYLENE GLYCOL 45 wt %
HEAT FLUX Q/A (w/m²)
10⁶
8
6
4
2
10⁵
8
6
4
2
10⁴
8
6
4
2
10³
1
2
4
6
8
10
20
40
60
80
100
DEGREE OF SUPERHEAT ΔTsat (°C)

# FIG. 53

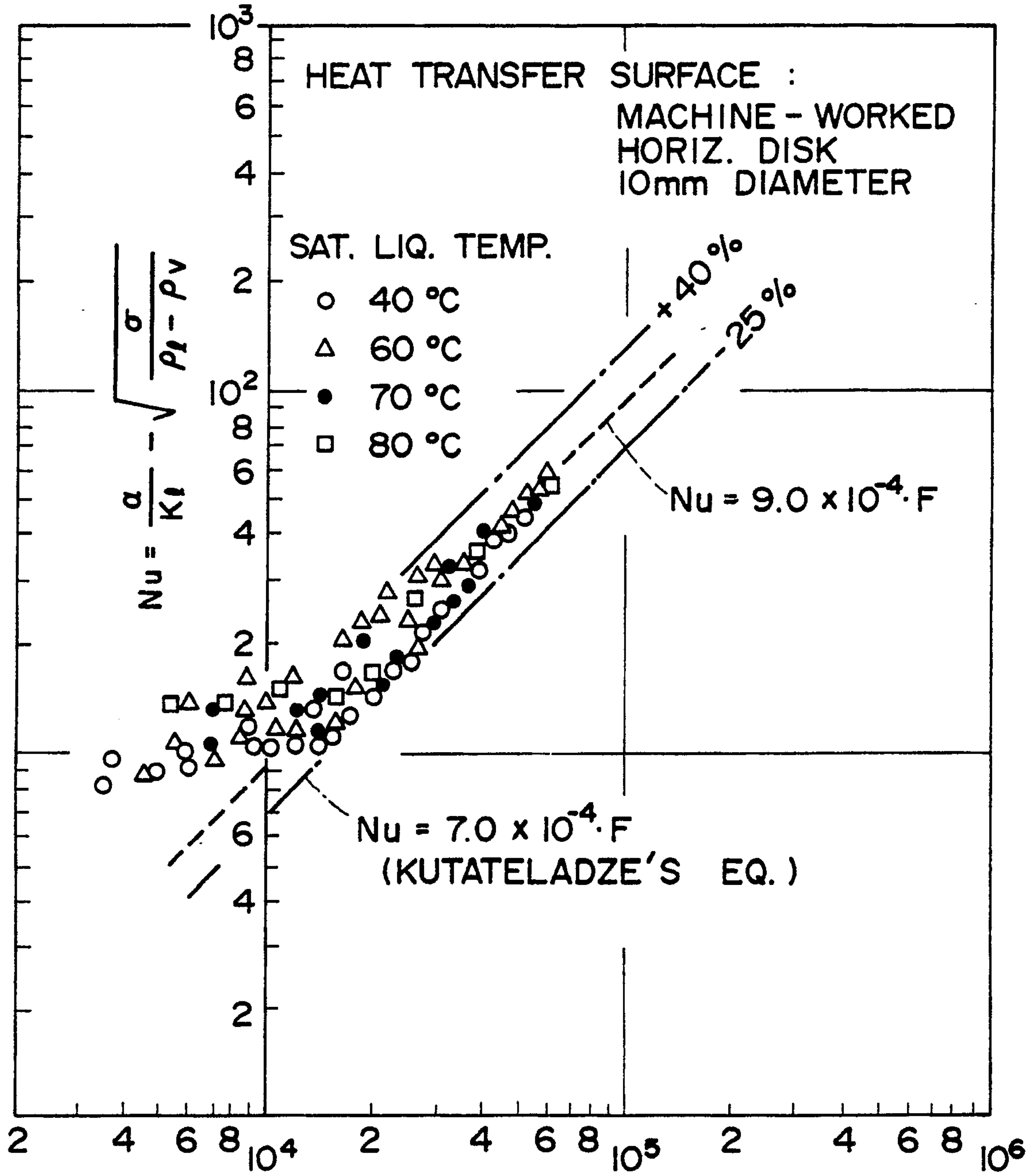


$$F = Pr_l^{-0.35}\left[\frac{0.86\,(Q/A)}{L\cdot\rho v\cdot a_2}\sqrt{\frac{\sigma}{\rho_l-\rho v}}\right]^{0.7}\left[\frac{P}{\sqrt{\sigma(\rho_l-\rho v)}}\right]^{0.7}$$

FIG. 54

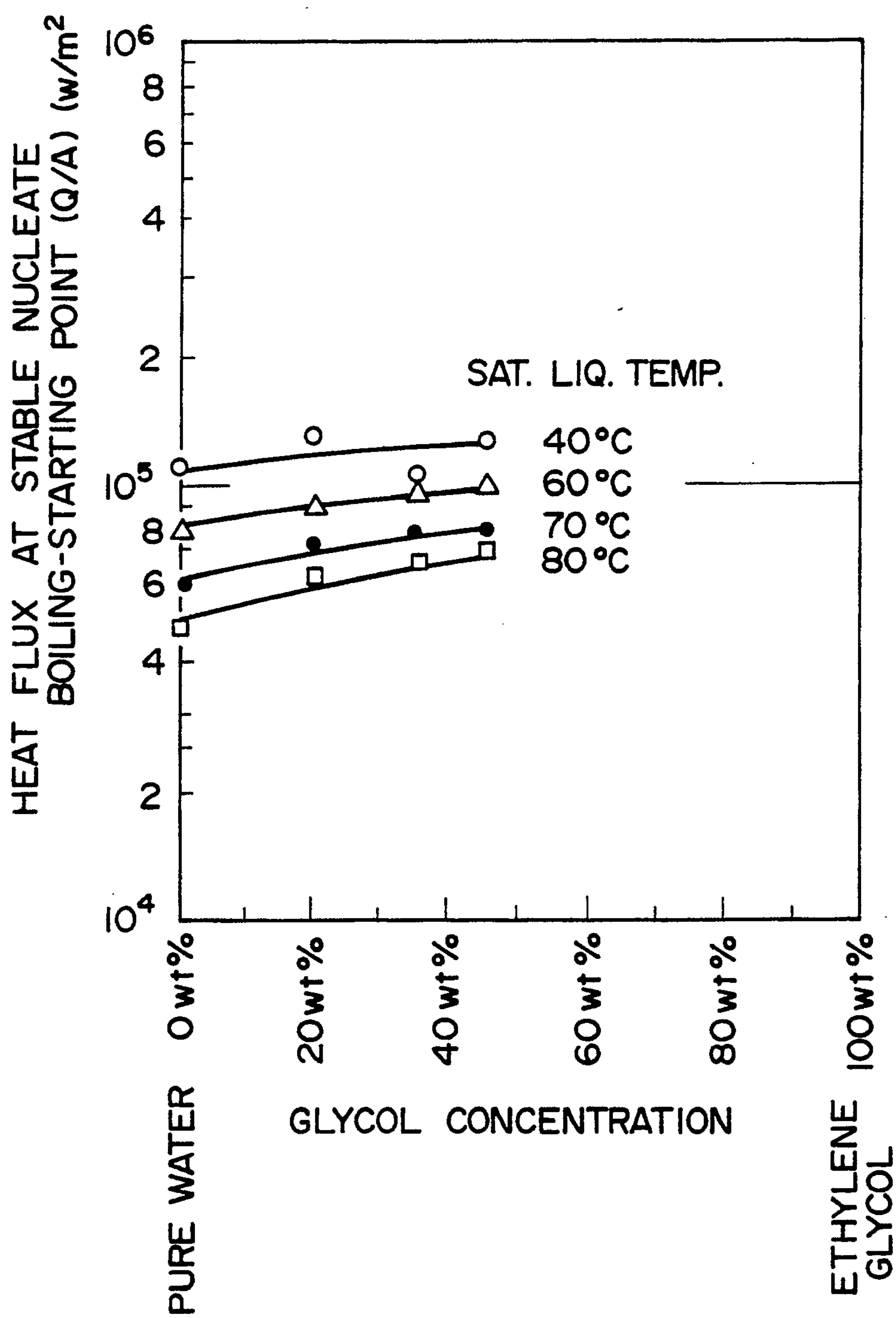
HEAT FLUX AT STABLE NUCLEATE BOILING-STARTING POINT (Q/A) (w/m²)
$10^6$
8
6
4
2
$10^5$
8
6
4
2
$10^4$
SAT. LIQ. TEMP.
40°C
60°C
70°C
80°C
0 wt%
20 wt%
40 wt%
60 wt%
80 wt%
100 wt%
PURE WATER
GLYCOL CONCENTRATION
ETHYLENE GLYCOL

# F I G. 55

$$F = Pr^{-0.35}\left[\frac{0.83(Q/A)}{L\cdot\rho v\cdot a_2}\sqrt{\frac{\sigma}{\rho l-\rho v}}\right]^{0.7}\left[\frac{P}{\sqrt{\sigma(\rho l-\rho v)}}\right]^{0.7}$$

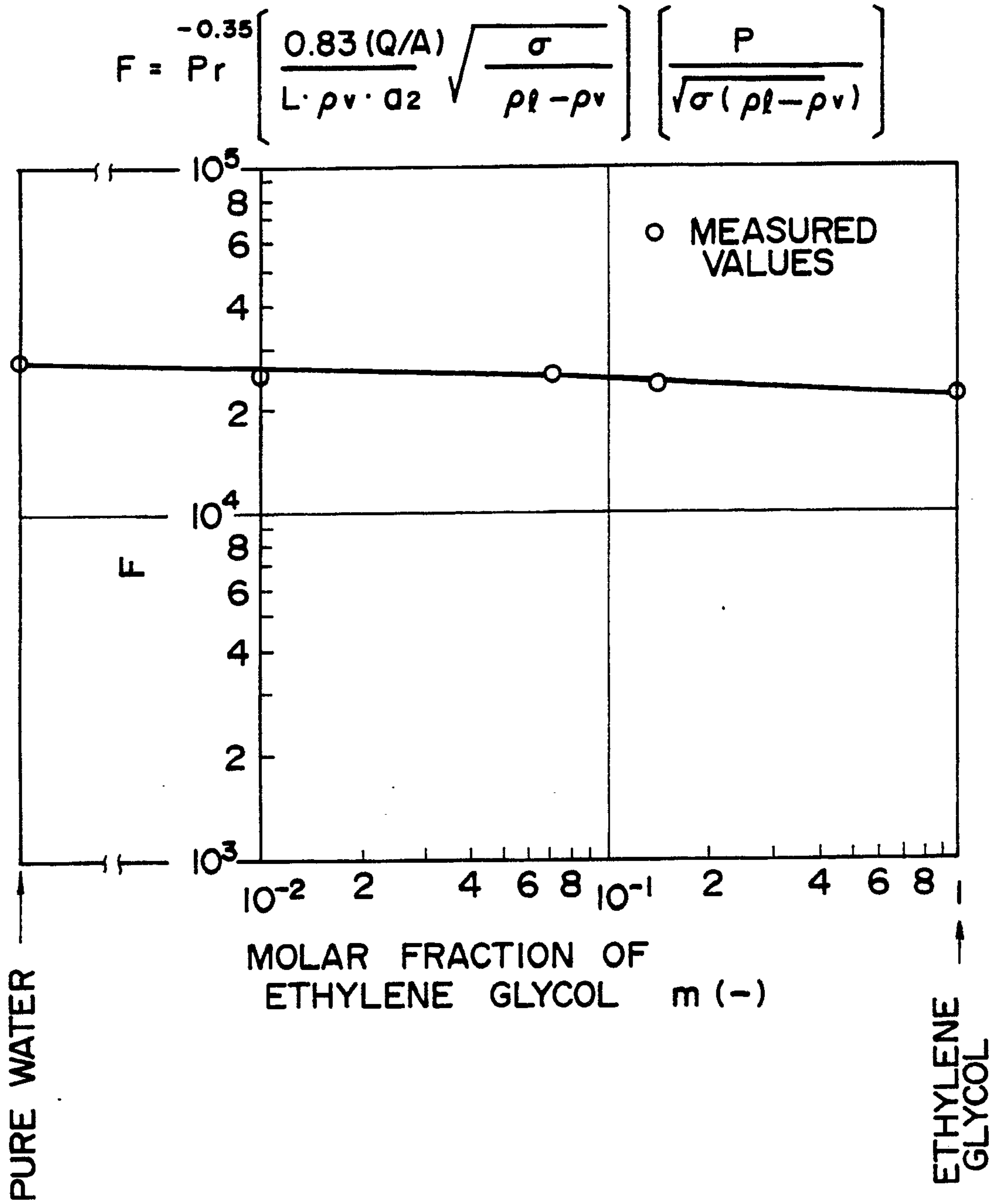

# FIG. 56

BOILING CURVE